# EUROPEAN PATENT APPLICATION

(11) **EP 4 741 989 A1**
(43) Date of publication of application: **13.05.2026**
(21) Application number: 24879884.5
(22) Date of filing: 27.06.2024
(51) Int. Cl.: G06F 1/16

(54) **HINGE STRUCTURE AND PORTABLE ELECTRONIC DEVICE COMPRISING SAME**

(30) Priority: 16.10.2023 KR 20230138085; 07.12.2023 KR 20230176843
(71) Applicant: Samsung Electronics Co., Ltd., Suwon-si, Gyeonggi-do 16677 (KR)
(72) Inventor: KIM, Jongkeun, Suwon-si, Gyeonggi-do 16677 (KR); BAIK, Jinwook, Suwon-si, Gyeonggi-do 16677 (KR); KANG, Jaeho, Suwon-si, Gyeonggi-do 16677 (KR); HAN, Yonghwa, Suwon-si, Gyeonggi-do 16677 (KR)
(74) Representative: Gulde & Partner
(86) International application number: PCT/KR2024/009036
(87) International publication number: WO 2025/084542

(57) **Abstract**

Disclosed are a portable electronic device including a housing, in which at least a portion of a display is disposed, and a hinge structure coupled to the housing, wherein at least one of arms included in the hinge structure includes a plurality of sub-arms, and is rotated at a specific angle and in different directions due to pressing of an elastic body included in the hinge structure, and a portable electronic device including the same.

## Description

### Field

The disclosure relates to hinge structures and an electronic device including the same.

### Description of Related Art

A portable electronic device may output at least one screen corresponding to various functions. When using these functions, the user may wish to use a wider screen. When the display is to be expanded for display of a screen in a typical portable electronic device, an overall size of the electronic device has to be increased, which may decrease portability. Accordingly, portable electronic devices with foldable displays are being provided so that the size of the screen may be increased while portability is maintained.

A foldable portable electronic device may provide a plurality of housings to support areas of the display in an unfolded state, and may include a hinge structure that connects the plurality of housings. The hinge structure connects the plurality of housings while the plurality of housings are in a folded or unfolded state, and may support the housings at a specific angle.

The above information may be provided as a related art for aiding understanding of the disclosure. None of the foregoing may be claimed as the prior art related to the disclosure, or used in determining the prior art.

### SUMMARY

An electronic device (or a portable electronic device) according to various example embodiments of the disclosure includes: a flexible display, a first housing and a second housing accommodating the flexible display, and a hinge structure comprising a hinge coupled to the first housing and the second housing, the hinge structure includes a first rotation member comprising a bracket coupled to the first housing and a second rotation member comprising a bracket coupled to the second housing, a first arm coupled to the first housing and a second arm coupled to the second housing, and a first elastic body configured to press the first arm and a second elastic body configured to press the second arm, and the first arm includes a first upper arm disposed between the first rotating member and the first elastic body, and having an inclined surface (or slope) formed thereon, and a first lower arm disposed between the first upper arm and the first rotation member to face the first upper arm, and having an inclined surface (or slope) formed thereon.

A hinge structure according to various example embodiments of the disclosure includes: a first rotation member comprising a bracket coupled to a first housing of a portable electronic device and a second rotation member comprising a bracket coupled to a second housing of the portable electronic device, a first arm coupled to the first housing and a second arm coupled to the second housing, a first elastic body configured to press the first arm and a second elastic body configured to press the second arm, the first arm includes a first upper arm disposed between the first rotating member and the first elastic body, and having a first inclined surface formed thereon, and a first lower arm disposed between the first upper arm and the first rotation member to face the first upper arm, and having a second inclined surface formed thereon, the first upper arm is configured to rotate clockwise in response to a pressure of the first elastic body and a state of contact between the first inclined surface and the second inclined surface, such that at least a portion of the first upper arm is disposed in contact with a rail formed on one side of a third link, and the first lower arm is configured to rotate counterclockwise in response to the pressure of the first elastic body and the state of contact between the first inclined surface and the second inclined surface such that at least a portion of the second upper arm is disposed in contact with a rail formed on one side of a fourth link.

Other various embodiments are disclosed.

### BRIEF DESCRIPTION OF THE DRAWINGS

The above and other aspects, features and advantages of certain embodiments of the present disclosure will be more apparent from the following detailed description, taken in conjunction with the accompanying drawings, in which:
FIG. 1 is a perspective view illustrating an example portable electronic device in unfolded and folded states according to various embodiments;
FIG. 2 is an exploded perspective view of some components of a portable electronic device in an unfolded state according to various embodiments;
FIG. 3 is an exploded perspective view of the hinge structure according to various embodiments;
FIG. 4A is a diagram illustrating an example of a first surface of a first upper arm according to various embodiments;
FIG. 4B is a perspective view, in which a first surface of the first upper arm is observed according to various embodiments;
FIG. 4C is a perspective view, in which a second surface of the first upper arm is observed according to various embodiments;
FIG. 5A is a diagram illustrating an example of a first surface of a first lower arm according to various embodiments;
FIG. 5B is a perspective view, in which a first surface of a first lower arm is observed according to various embodiments;
FIG. 5C is a perspective view, in which a second surface of a first lower arm is observed according to various embodiments;
FIG. 6A is a diagram including a perspective view illustrating an example of a pressing structure related to a first arm member in a hinge structure according to various embodiments;
FIG. 6B is a diagram including a perspective view illustrating an example of twisting of a first arm member due to a pressing structure according to various embodiments;
FIG. 7 is a diagram illustrating an example of a coupling form of a first upper arm, a second upper arm, and a first shaft in a hinge structure according to various embodiments;
FIG. 8 is a diagram illustrating an example of a disposition state of a first upper arm, a first lower arm, and a third link member according to various embodiments;
FIG. 9 is a diagram illustrating an example of a disposition state of arm members and link members in a hinge structure in an unfolded state according to various embodiments;
FIG. 10 is a diagram illustrating an example of a disposition state of arm members and link members in a hinge structure defined at a specific angle according to various embodiments;
FIG. 11 is a diagram illustrating an example of a disposition state of arm members and link members in a hinge structure in a folded state according to various embodiments;
FIG. 12 is a perspective view illustrating an example an arm member according to various embodiments;
FIG. 13A is a perspective view illustrating an example of an upper arm according to various embodiments;
FIG. 13B is a perspective view illustrating an example of a lower arm according to various embodiments;
FIG. 13C is a diagram illustrating an example of a coupling form of an upper arm and a lower arm according to various embodiments;
FIG. 14A is a diagram illustrating an example of a modified upper arm according to various embodiments;
FIG. 14B is a diagram illustrating an example of a modified lower arm according to various embodiments;
FIG. 14C is a diagram illustrating an example of a coupling form of a modified upper arm and a lower arm according to various embodiments;
FIG. 15A is a perspective view illustrating an example of an upper arm according to various embodiments;
FIG. 15B is a perspective view illustrating an example of a lower arm according to various embodiments;
FIG. 15C is a diagram illustrating an example of a coupling form of an upper arm and a lower arm according to various embodiments;
FIG. 16 is a diagram illustrating an example of a hinge structure according to various embodiments;
FIG. 17 is an exploded perspective view of a hinge structure according to various embodiments;
FIG. 18 includes an exploded perspective view illustrating an arm member of a hinge structure according to various embodiments; and
FIG. 19 is a block diagram illustrating an example electronic device in a network environment, according to various embodiments.

### DETAILED DESCRIPTION

Hereinafter, various example embodiments of the disclosure will be described in greater detail with reference to the accompanying drawings.

For example, a portable electronic device (or a portable communication device, or a foldable electronic device) according to various embodiments of the disclosure below may cause a gap between various structures included in the hinge structure to move the structures in a folded or unfolded state of the portable electronic device. This movement may cause inconvenience to the user, and may decrease a lifespan of the portable electronic device. Various embodiments of the disclosure improve the above-described movement and thus, support more stable hinge operations of a portable electronic device. As an example, at least some of the various embodiments in the disclosure present a device that may support a more robust hinge operation by reducing the gap that causes a movement or reducing the movement of rotating structures. These portable electronic devices may include portable electronic devices, such as smartphones, tablets, laptops, slate PCs, or laptops, and may support call functions and various content provision functions based on various types of applications.

Other intended purposes according to the various example embodiments of the disclosure will be mentioned as necessary while describing the various example embodiments.

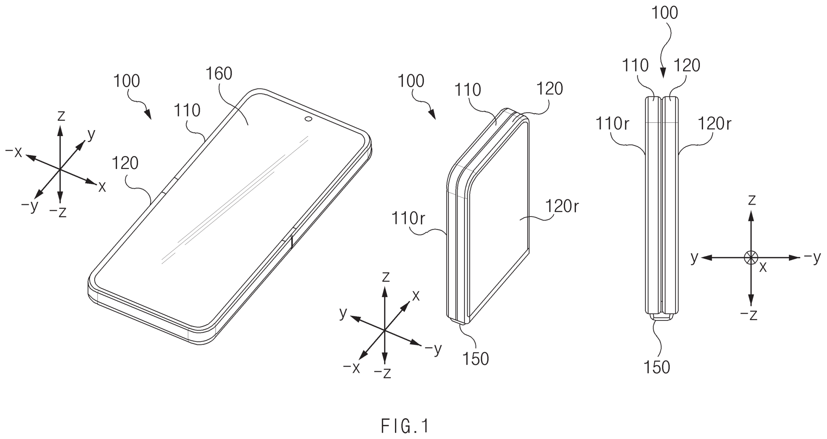

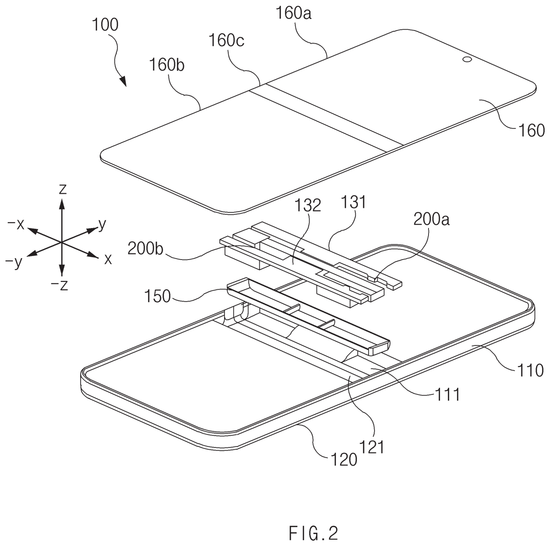

FIG. 1 is a perspective view of a portable electronic device in unfolded and folded states according to various embodiments, and FIG. 2 is an exploded perspective view of various components of the portable electronic device in the unfolded state according to various embodiments.

Referring to FIGS. 1 and 2, a portable electronic device 100 (or a foldable electronic device, an electronic device, or a portable communication device) according to an embodiment may include a housing (e.g., housings including a first housing 110 and a second housing 120), a display 160 (e.g., a flexible display), a hinge structure 200a and 200b (or a hinge structure, a hinge, a hinge assembly, and/or a gear assembly), and a hinge housing 150, in which at least a portion of the hinge structures 200a and 200b are disposed on an inside thereof. For example, at least one of a modem, a transceiver, an antenna for cellular communication, an antenna for short-distance communication, and a wireless charging coil may be accommodated in the first housing 110 and/or the second housing 120 of the portable electronic device 100.

FIG. 1 is a perspective view of the portable electronic device 100 in a flat state (or an unfolding state or an unfolded state) and a perspective view of a folded state, and FIG. 2 illustrates a disassembled state of various components of the portable electronic device 100 in the unfolded state. The portable electronic device 100 may further include a first cover 110r that covers a rear part of the first housing 110, and a second cover 120r that covers a rear part of the second housing 120. A separate auxiliary display may be further disposed on at least one of the rear part of the first housing 110 or the rear part of the second housing 120. When the separate auxiliary display is disposed, at least one of the first cover 110r and the second cover 120r may be disposed or formed to surround the auxiliary display. According to various embodiments, all of the first cover 110r and the second cover 120r or at least one of the first cover 110r and the second cover 120r may be replaced with an auxiliary display. For example, at least a portion of the first cover 110r may be replaced with a first auxiliary display. At least a portion of the second cover 120r may be replaced with a second auxiliary display.

According to an embodiment, the hinge housing 150 may be a part of the first housing 110 or the second housing 120. According to an embodiment, the first housing 110, the second housing 120, and the hinge housing 150 may be parts of one housing. According to an embodiment, the first cover 110r, the second cover 120r, and the hinge housing 150 may be parts of one housing. According to an embodiment, the first housing 110 may be disposed continuously with the second housing 120 (e.g., when a central portion 160c of the display 160 is unfolded flat or when the housings are unfolded), or disposed in parallel to the second housing 120, depending on the arrangement state. When the central portion 160c of the display 160 is folded, one surface of the first housing 110 may be disposed to face one surface of the second housing 120.

For example, the first housing 110 may be formed at least partially of a metallic material (or entirely of a metallic material), or at least partially of a nonmetallic material (or entirely of a nonmetallic material). For example, the first housing 110 may be formed of a material with a certain strength to support at least a portion of the display 160. An area (e.g., an upper portion 160a (or an area in the x-axis direction, or a first area) and a central portion (a portion of the central portion 160c)) of the display 160 may be disposed at at least a portion of the front part of the first housing 110. At least a portion of the first housing 110 may be coupled to the upper portion 160a of the display 160 (e.g., may be coupled or adhered to at least a portion of a rear surface (a surface in an opposite direction to a direction that faces the display 160) of the upper portion 160a). At least a portion of a periphery of a front surface (e.g., one surface that faces the z-axis direction) of the first housing 110 may be coupled to (or disposed at, or adhered to) at least a portion of the upper portion 160a of the display 160 while surrounding a periphery of the upper portion 160a of the display 160. One side of an upper portion of the front surface of the first housing 110 may be coupled to (or adhered to, or disposed adjacent to) one side of the upper portion 160a of the display 160. In this regard, an adhesive layer (or an adhesive member, an adhesive material, or an adhesive tape) may be disposed at at least portion between the first housing 110 and the upper portion 160a of the display 160. At least a portion of an inside of the first housing 110 may be provided in a hollow form or may be provided in a hollow form while being coupled to the first cover, and electronic elements (e.g., elements, such as a printed circuit board, and at least one processor, at least one memory, and a battery, which are disposed on the printed circuit board) that are necessary for driving the display 160 may be disposed therein.

According to an embodiment, an end (e.g., ends of peripheries of the remaining three sites, excluding the periphery that faces the second housing 120) of a periphery of the first housing 110 may protrude by a specific height from a bottom surface of a central portion of the housing to surround at least a periphery of one side of the display 160. Side walls, at least portions of which face a periphery of the display 160 may be disposed on at least one portion of an end of a periphery of the first housing 110. The side walls formed on at least a portion of the periphery of the first housing 110 may be formed to have a specific height at the peripheries of three sites, excluding the periphery that faces the second housing 120. At least a portion of a peripheral portion of the first housing 110, which faces the second housing 120 may include a recessed portion 111 of fig. 2 having a specific curvature so that at least a portion of the hinge housing 150 and at least a portion of the hinge structures 200a and 200b (or hinge structures) that are adjacent to (or seated on) the hinge housing 150 may be disposed thereat. For example, when the portable electronic device 100 is in the unfolded state, the first housing 110 may include at least one first stepped portion 111, at which at least a portion of the first hinge structure 200a and the second hinge structure 200b are disposed (or seated) to be adjacent thereto, at a peripheral portion that faces the second housing 120.

According to various embodiments, the second housing 120 may be disposed in parallel to the first housing 110, or at least one surface thereof may be disposed to face one surface (e.g., a surface, on which the display 160 is disposed) of the first housing 110, depending on a disposition of the second housing 120. The second housing 120 may be formed of the same material as that of the first housing 110. For example, at least a portion of the second housing 120 may be formed of a metallic material, and at least a portion of the remaining portions may be formed of a nonmetallic material (e.g., an injection-molded material). The entire second housing 120 may be formed of a metallic material or a nonmetallic material. Because the second housing 120 is disposed to be symmetrical to the first housing 110 to the left and right sides or the upper and lower sides, a front surface thereof may be disposed to support at least a portion (e.g., an opposite side of a lower portion 160b (or a second area in the - x-axis direction) and a central portion 160c of the display 160) of the remaining one area of the area of the display 160, which is disposed in the first housing 110. At least a portion of the second housing 120 may be adhered to a lower portion 160b of the display 160 (or adhered to at least a portion of a rear surface (a surface in the -z-axis direction) of the lower portion 160b). A periphery of a front surface of the second housing 120 may be adhered to a periphery of the lower portion 160b of the display 160. One side of a front surface of the second housing 120 (or at least a portion of a lower portion of the front surface of the second housing 120) may be adhered to one side of the lower portion 160b of the display 160 (or at least a portion of the lower portion 160b of the display 160). In this regard, an adhesive layer may be disposed at at least a portion between the second housing 120 and the lower portion 160b of the display 160. At least a portion of an inside of the second housing 120 may be provided in a hollow form or may be provided in a hollow form while being coupled to the second cover 120r, similar to the first housing 110, and electronic elements that are necessary for driving the display 160 may be disposed thereat.

According to an embodiment, an end (e.g., ends of peripheries of the remaining three sites, excluding the periphery that faces the first housing 110) of a periphery of the second housing 120 may protrude by a specific height from a bottom surface of a central portion of the second housing 120 to surround at least a periphery of an opposite side of the display 160. Similar to the side walls formed in the first housing 110, side walls, at least portions of which face a periphery of the display 160, may be disposed at at least one portion of an end of a periphery of the second housing 120. The side walls formed on at least a portion of the periphery of the second housing 120 may be formed to have a specific height at the peripheries of three sites, excluding the periphery that faces the first housing 110.

When the portable electronic device 100 is in the unfolded state, at least a portion of a part of the second housing 120, which faces the first housing 110 may include a recessed portion 121 of fig. 2 having a specific curvature so that the hinge housing 150 and the hinge structures 200a and 200b, at least portions of which are disposed adjacent to (or seated in) the hinge housing 150, may be located thereat. For example, the second housing 110 may include at least one second stepped portion 121, at which at least a portion of the first hinge structure 200a and the second hinge structure 200b are disposed (or seated) to be adjacent thereto, at a peripheral portion that faces the first housing 110.

According to an embodiment, the portable electronic device 100 may include at least one sensor that is disposed on one side of the first housing 110 or the second housing 120 and is related to an operation of a specific function of the portable electronic device 100. The sensor may, for example, include at least one of a proximity sensor, an illumination sensor, an iris sensor, an image sensor (or a camera), or a fingerprint sensor. According to an embodiment, different components may be disposed in the first housing 110 and the second housing 120. As an example, the camera may be disposed only in the first housing 110, and the antenna for short-distance communication may be disposed only in the second housing 120.

According to an embodiment, the hinge housing 150 may be either covered by one side of the first housing 110 and the second housing 120 (e.g., in the unfolded state of the housings) or may be exposed to an outside (e.g., in the folded state of the housings) depending on the folded or unfolded state of the portable electronic device 100. For example, as illustrated in FIG. 1, when the first housing 110 and the second housing 120 are disposed side by side (or when the housings 110 and 120 are in the unfolded state), the hinge housing 150 may be covered by the first housing 110 and the second housing 120. When one surface of the first housing 110 and one surface of the second housing 120 are disposed to face each other (or when the housings 110 and 120 are in the folded state), the hinge housing 150 may be disposed such that at least portions of peripheries (e.g., peripheries, at which the first housing 110 and the second housing 120 face each other in the unfolded state) of sides of the first housing 110 and the second housing 120 are exposed to the outside.

According to an embodiment, at least a portion of the display 160 may be flexible. According to an embodiment, the display 160 may include an upper portion 160a or a first area that is disposed on the first housing 110, a lower portion 160b or a second area that is disposed on the second housing 120, and a central portion 160c or central area, in which the first housing 110 and the second housing 120 are adjacent to each other. According to an embodiment, the entire display 160 may be flexible. At least a portion of the central portion 160c of the display 160 may be configured to be flexible. The central portion 160c of the display 160 may be disposed such that the first housing 110 and the second housing 120 are not adhered to each other. For example, the central portion 160c of the display 160 may be disposed to be spaced apart from the front surfaces of the first housing 110 and the second housing 120 at a specific distance. The upper portion 160a of the display 160 is coupled to (or adhered to, or disposed adjacent to, or disposed to contact) at least a portion of the first housing 110, and the lower portion 160b of the display 160 may be coupled to at least a portion of the second housing 120. In this regard, an adhesive layer (an adhesive layer that is disposed in a different position from that of the adhesive layer that contacts the first housing 110 and at least a portion of the upper portion 160a of the display 160) is disposed in at least a partial area between the display 160 and the first housing 110, an adhesive layer may be disposed in at least a partial area between the display 160 and the second housing 120. The adhesive layer disposed on the first housing 110 and the adhesive layer disposed on the second housing 120 may be disposed only at the peripheries of the first housing 110 and the second housing 120.

According to an embodiment, the hinge structures 200a and 200b may include a first hinge structure 200a and a second hinge structure 200b. It is illustrated in the drawing that two first hinge structures 200a and two second hinge structures 200b are disposed in the hinge housing 150, but the disclosure is not limited thereto, and if necessary, three or more hinge structures may be disposed on the hinge housing 150.

According to an embodiment, several hinge structures 200a and 200b may be disposed along the central portion 160c of the display 160. According to an embodiment, among the plurality of hinge structures 200a and 200b disposed along the central portion 160c of the display 160, at least some of the hinge structures 200a and 200b may include a shape/structure or parts that are different from those of other hinge structures 200a and 200b.

The first hinge structure 200a may be disposed on one side (e.g., a left side with respect to a longitudinal center line of the foldable electronic device in the drawing) of the hinge housing 150. The first hinge structure 200a is coupled to one side (e.g., opposite sides of the first housing 110 and the second housing 120 in the area, in which the first housing 110 and the second housing 120 are disposed adjacent to each other when the foldable electronic device is in the unfolded state) of the first housing 110 and the second housing 120, and may be rotated within a specific range with respect to a long axis of the hinge housing 150 (or at least a portion of the central portion 160c, at which the display 160 is folded). The first hinge structure 200a may be disposed to be symmetrical to the second hinge structure 200b with respect to the central portion of the hinge housing 150. The first hinge structure 200a may include at least one shaft according to an embodiment of the disclosure, and may include a fixing structure that fixes the shaft temporarily or based on an elastic force. A gear may be disposed in the at least one shaft, and accordingly, the first hinge structure 200a may include at least a shaft, a gear disposed that is disposed in the shaft, and a fixing structure that fixes the shaft.

The second hinge structure 200b may be disposed on an opposite side (e.g., a left side with respect to a longitudinal center line of the foldable electronic device in the illustrated drawing) of the hinge housing 150. The second hinge structure 200b may be coupled to an opposite side (e.g., a left side with respect to a longitudinal center line (e.g., an imaginary line that crosses a center of the display 160 of the foldable electronic device from the x-axis to the -x-axis) of the first housing 110 and an opposite side (e.g., a left side with respect to the longitudinal center line of the foldable electronic device) of the second housing 120, and may be rotated within a specific range with respect to the horizontal axis of the hinge housing 150. The second hinge structure 200b may be disposed to be symmetrical to the first hinge structure 200a with respect to the central portion of the hinge housing 150. This second hinge structure 200b has a structure and a configuration that are the same as or similar to those of the first hinge structure 200a, but a disposition position thereof may be different. The second hinge structure 200b may include at least one shaft according to an embodiment of the disclosure, and may include a fixing structure that fixes the shaft temporarily or based on an elastic force. A gear may be disposed in the at least one shaft, and accordingly, the second hinge structure 200b may include at least a shaft, a gear disposed that is disposed in the shaft, and a fixing structure that fixes the shaft. According to an embodiment, a shaft pressing structure according to the disclosure may be disposed in at least one of the first and second hinge structures 200a and 200b (or all the hinge structures). When the portable electronic device 100 includes a plurality of hinge structures, the shaft pressing structure may be applied to only some of the plurality of hinge structures.

According to an embodiment, in the portable electronic device 100, wing plates 131 and 132 are positioned on at least one hinge structure 200a and 200b or coupled to at least one hinge structure 200a and 200b, and are disposed to cover at least one surface of the at least one hinge structure 200a and 200b in the z-axis direction when the portable electronic device 100 is in the unfolded state. The wing plates 131 and 132 may be configured separately from the housings 110 and 120. Accordingly, gaps may be formed between the wing plates 131 and 132 and the housings 110 and 120. According to an embodiment, the housings 110 and 120 may be provided with recesses, in which the wing plates 131 and 132 can be disposed. The wing plates 131 and 132 may be disposed to correspond to at least a portion of a lower surface (e.g., a surface in the -z-axis direction) of a third area 160c (or a central portion) of the display 160. The wing plates 131 and 132 may be rotated clockwise or counterclockwise depending on a hinge operation of at least one hinge structure 200a and 200b. For example, while the first wing plate 131 is rotated counterclockwise, the second wing plate 132 may be rotated clockwise, and while the first wing plate 131 is rotated clockwise, the second wing plate 132 be rotated counterclockwise. The first wing plate 131 may support a flat first surface of the third area 160c of the display 160, which is folded into a dumbbell shape (or a water drop shape) or a "U" shape, and the second wing plate 132 may support a flat second surface (a surface that is symmetrical to the first surface with respect to the z-axis) of the third area 160c of the display 160 that is folded into a dumbbell shape. According to an embodiment, the structure including the first hinge structure 200a, the second hinge structure 200b, the first wing plate 131, and the second wing plate 132 may be referred to as a hinge structure, a hinge, a hinge assembly, or a gear assembly.

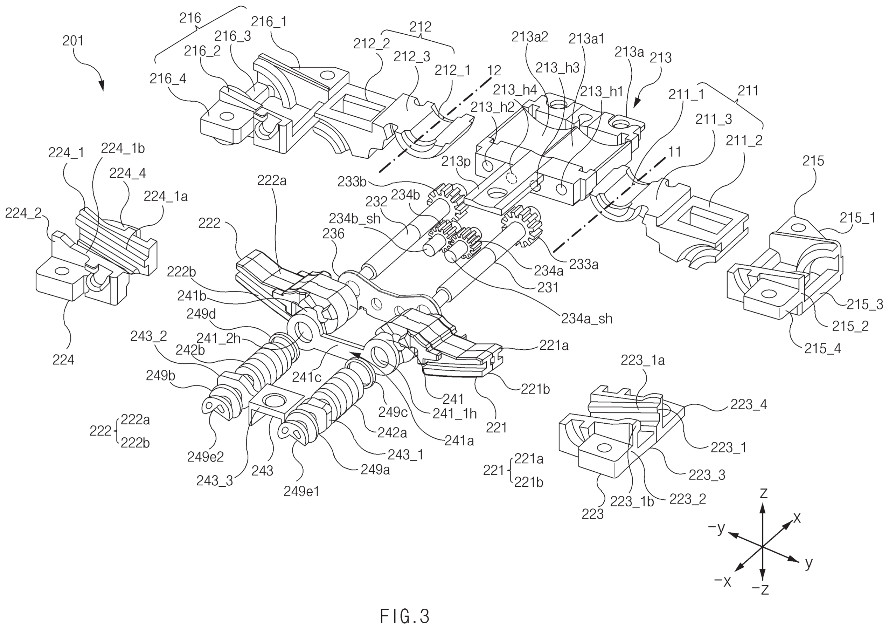

FIG. 3 is an exploded perspective view of the hinge structure according to various embodiments. The hinge structure 201 illustrated in FIG. 3 may correspond to either or both of the first hinge structure 200a or the second hinge structure 200b described above in FIG. 2.

Referring to FIGS. 1, 2 and 3 (which may be referred to as FIGS. 1 to 3), the hinge structure 201 (or the gear assembly) may include a fixing bracket 213, a first rotation member 211 (or a first rotation bracket), a second rotation member 212 (or a second rotation bracket), a first arm member 221, a second arm member 222, a first link member 215, a second link member 216, a third link member 223, and a fourth link member 224. It is illustrated in the drawing that the first to fourth link members 215, 216, 223, and 224 are separated from each other, but the various embodiments of the disclosure are not limited thereto. For example, the first link member 215 and the third link member 223 may be integrally formed to form one body, and the second link member 216 and the fourth link member 224 may be integrally formed to form one body. As another example, at least some of the first to fourth link members 215, 216, 223, and 224 may be integrally formed into the housings 110 and 120.

According to an embodiment, the hinge structure 201 may include a first main gear 233a (or a first gear, or a first shaft gear) that is formed (or disposed) in the first shaft 231, a second main gear 233b (or a second gear, or a second shaft gear) that is formed (or disposed) in the second shaft 232, and at least one interlocking gear 234a and 234b (or an idle gear, an auxiliary gear) that is disposed between the first main gear 233a and the second main gear 233b. The at least one interlocking gears 234a and 234b may include gear shafts 234a_sh and 234b_sh (or shafts), respectively. For example, the first interlocking gear 234a may be disposed (or formed) on the first gear shaft 234a_sh (or a first interlocking gear shaft, a first interlocking shaft, a first gear shaft, a first auxiliary shaft, or a third shaft). The second interlocking gear 234b may be disposed (or formed) in the second gear shaft 234b_sh (or a second interlocking gear shaft, a second gear shaft, a second auxiliary shaft, or a fourth shaft). In embodiments of the disclosure, the shaft may refer to a bar-shaped portion, on which a gear body including gear teeth is disposed. Furthermore, the shaft may refer to a shaped portion that protrudes from the gear body portion along a rotation axis of the gear.

According to various embodiments, a gear interlocking structure including spiral bevel gears, in replacement of the gear interlocking structure including the above-described main gears 233a and 233b and interlocking gears 234a and 234b may be included in the hinge structure 201. The gear interlocking structure including the spiral bevel gears, for example, may include bevel gears, in which gear patterns are formed such that the shafts 231 and 232 are rotated clockwise or counterclockwise while spiral gears having gear patterns on a cylindrical circumference or an upper surface thereof are disposed between the shafts 231 and 232 to be coupled to the shafts or that are formed in the shafts 231 and 232 to be gear-coupled to the spiral gears. As an example, the first bevel gear may be formed (or disposed) on the first shaft 231, and the second bevel gear may be formed (or disposed) in the second shaft 232.

The hinge structure 201 according to an embodiment may include a first main gear 233a and a second main gear 233b, a gear bracket 236 (or a stopper, an arm support structure, a shaft support structure, a gear frame, a gear support member, or a support member) that is used to fix at least one interlocking gear 234a and 234b and prevents or blocks the first arm member 221 and the second arm member 222 from being rotated by a specific angle or more, a shaft fixing part 243 that is used to fix the first shaft 231 and the second shaft 232, a cam member 241 that is cam-coupled to the cam structures formed in the first arm member 221 and the second arm member 222, a first elastic body 242a (or a first elastic body, or a first elastic member) and a second elastic body 242b (or a second elastic body, or a second elastic member) that provide an elastic force to the cam member 241, a plurality of coupling members 249e1 and 249e2, and washer rings 249a and 249b. According to an embodiment, the gear bracket 236 may include a fixing structure that fixes at least one of the first shaft 231, the second shaft 232, the first gear shaft 234a_sh, and the second gear shaft 234b_sh.

According to an embodiment, at least a portion of a shape of the lower surface (e.g., a surface in the -z-axis direction) of the fixing bracket 213 may include a curved surface. For example, at least a portion of the lower surface of the fixing bracket 213 may be formed to correspond to an inner shape of the hinge housing 150 (FIG. 2). At least a portion of an upper surface (e.g., a surface in the z-axis direction) of the fixing bracket 213 is provided in a flat shape, and rails 213a2 and 213a1 may be formed such that the rotation members 211 and 212 may be coupled to each other. For example, the fixing bracket 213 may include a first rail 213a1 (or a first rail structure inserted into a rail, or a first rail groove) and a second rail 213a2 (or a second rail structure inserted into a rail, or a second rail groove). According to an embodiment, at least a portion of a cross-section of the fixing bracket 213 from an upper surface (e.g., a surface in the z-axis direction) to a lower surface (e.g., a surface in the -z-axis direction) may include an arc shape (or a curved surface). The fixing bracket 213 may include a bracket extension part 213p that protrudes in the -x-axis direction from one side (e.g., a periphery of the upper surface of the fixing bracket body 213a in the -x-axis direction) of the fixing bracket body 213a. The fixing bracket body 213a may include a first rail 213a1, into which, among the first rotation members 211 having the first rail structure 211_1 and the second rail structure 211_2, the first rail structure 211_1 is inserted from one direction (e.g., the -x-axis direction) in an opposite direction (the x-axis direction), and a second rail 213a2, into which, among the second rotation members 212 having the third rail structure 212_1 and the fourth rail structure 212_2, the third rail structure 212_1 is inserted in an opposite direction (e.g., the x-axis direction) in one direction (e.g., the -x-axis direction). With respect to a first axis 11 or a second axis 12 (or with respect to the x axis that crosses a center between the first rotation member 211 and the second rotation member 212), the first rail 213a1 and the second rail 213a2 may be disposed (or formed) in the same position. The first rail structure 211_1 of the first rotation member 211 that is inserted into the first rail 213a1 may be rotated about the first axis 11, and the third rail structure 212_1 of the second rotation member 212 that is inserted into the second rail 213a2 may be rotated about the second axis 12. The first axis 11 and the second axis 12 may be formed on an upper side (air) of an upper surface (e.g., a surface in the z-axis direction) of the fixing bracket 213. The first axis 11 and the second axis 12 may be formed between an upper surface of the display 160 (FIG. 2) and a lower surface (e.g., a surface in the -z-axis direction) of the fixing bracket body 213a. As an example, the first axis 11 and the second axis 12 may be formed in the air above the upper surface (e.g., a surface in the -z-axis direction) of the fixing bracket body 213a.

According to an embodiment, one side (e.g., a side that faces the -x-axis direction) of the fixing bracket 213 may include a first recess 213_h1 (or a first hole, or a first opening), into which one side (e.g., a periphery of an end in the x-axis direction) of the first shaft 231, in which the first main gear 233a is formed (or disposed), may be inserted, and a second recess 213_h2 (or a second hole, or a second opening), into which one side (e.g., a periphery of an end in the x-axis direction) of the second shaft 232, in which the second main gear 233b is formed (or disposed), may be inserted. According to an embodiment, one side (e.g., a side surface that faces the -x-axis direction) of the fixing bracket 213 may include a third recess 213_h3 (or a third hole, or a third opening), into which one side of the first interlocking gear 234a (one side of the first gear shaft 234a_sh formed at a central portion of the first interlocking gear 234a) (e.g., a periphery of one end in the x-axis direction) may be inserted, and a fourth recess 213_h4 (or a fourth hole, or a fourth opening), into which one side of the second interlocking gear 234b (one side of the second gear shaft 234b_sh formed at a central portion of the second interlocking gear 234b) (e.g., a periphery of one end in the x-axis direction) may be inserted. The third recess 213_h3 and the fourth recess 213_h4 may be disposed between the first recess 213_h1 and the second recess 213_h2. Diameters (or sizes of a cross-section in the z-axis direction) of the third recess 213_h3 and the fourth recess 213_h4 may be smaller than diameters (or sizes of a cross-section in the z-axis direction) of the first recess 213_h1 and the second recess 213_h2.

According to an embodiment, the first axis 11 and the second axis 12 may be formed to be spaced apart from each other by a specific distance. According to an embodiment, a distance between the first axis 11 and the second axis 12 may be formed differently from a distance between the first shaft 231 and the second shaft 232. As an example, an interval between the first axis 11 and the second axis 12 may be smaller than an interval between the first shaft 231 and the second shaft 232. According to an embodiment, the first axis 11 and the second axis 12 may be formed on an upper side of the first shaft 231 and the second shaft 232 with respect to the z axis. The first axis 11 and the second axis 12 may be formed closer to the upper surface of the display 160 (FIG. 2) than the first shaft 231 and the second shaft 232 with respect to the z axis. According to an embodiment, the fixing bracket body 213a may include at least one fixing hole that is used to fix the fixing bracket 213 to the hinge housing 150 (FIG. 2). The portable electronic device 100 can fix the fixing bracket 213 to the hinge housing 150 (FIG. 2) using a coupling member (e.g., a screw, a rivet, or welding).

Insertion recesses 213_h1 and 213_h2 (or shaft insertion recesses or shaft holes), in which one end (e.g., an end in the y-axis direction) of the first shaft 231 and one end (e.g., an end in the y-axis direction) of the second shaft 232 are held, may be formed on a side wall of the fixing bracket body 213a in the -x-axis direction. According to an embodiment, insertion recesses 213_h3 and 213_h4 (or gear shaft insertion recesses or gear shaft holes), in which one side of at least one interlocking gear 234a and 234b (e.g., gear shafts 234a_sh and 234b_sh formed at the centers of the interlocking gears 234a and 234b) may be held, respectively, may be formed between the insertion holes 213_h1 and 213_h2 of the side wall of the fixing bracket 213a in the -x-axis direction. As an example, a third insertion recess 213_h3 and a fourth insertion recess 23 1_h4 may be disposed between the first insertion recess 213_h1 and the second insertion recess 213_h2. The bracket extension part 213p may protrude in the - x-axis direction from one side of the fixing bracket body 213a. The bracket extension part 213p may be disposed to supports or cover a gear (e.g., at least one gear, among the first main gear 233a, the second main gear, the first interlocking gear 234a, and the second interlocking gear 234b.

The first rotation member 211 may rotate about the first axis 11 (e.g., an imaginary axis in the x-axis direction that is different from that of the first shaft 231). The first rotation member 211 (or a first rotation structure, a first rotation part, or a first rotary body) may, for example, include a first rotation body 211_3, a first rail structure 211_1 (or a first rail, into which the rail structure is inserted), and a second rail structure 211_2 (or a second rail, into which the rail structure is inserted). According to an embodiment, the first rotation member 211 may include a first rotation body 211_3, a first rail structure 211_1 that extends to one end (e.g., an end in the x-axis direction) of the first rotation body 211_3 (or may be configured in a first rail shape, into which the first rail structure 211_1 is inserted), and a second rail structure 211_2 that extends to an opposite end (e.g., an end in the -x-axis direction) of the first rotation body 211_3 (or may be configured in a second rail shape, into which the second rail structure 211_2 is inserted). The first rotation body 211_3 may be disposed between the first rail structure 211_1 and the second rail structure 211_2. At least a portion of the first rotation body 211_3 may be fastened to one side of the fixing bracket body 213a. The first rail structure 211_1 and the second rail structure 211_2 may be formed to be stepped around the first rotation body 211_3. The first rail structure 211_1 of the first rotation member 211 may be fastened to one side (e.g., first rail 213a1) of the fixing bracket 213 to enable a hinge operation. The second rail structure 211_2 of the first rotation member 211 may be coupled to one side of the first link member 215 to perform a sliding operation (or a rotation, or an arc movement) in response to the hinge operation (or the rotation, or the sliding operation) of the first rail structure 211_1. According to an embodiment, at least one of the first rail structure 211_1 and the second rail structure 211_2 of the first rotation member 211 may be coupled to one side of the first link member 215 to perform a pivot operation (or a pivot movement) with respect to the axis defined in the first link member 215.

While the first link member 215 coupled to the first housing 110 (FIG. 2) is moved as the first housing 110 (FIG. 2) is moved, the first rail structure 211_1 of the first rotation member 211 fastened to the fixing bracket 213 may be rotated in place with respect to the first axis 11. As an example, the second rail structure 211_2 of the first rotation member 211 may be rotate (or slid) in relation to the first link member 215 while being moved in one direction (e.g., counterclockwise while the portable electronic device 100 is folded from the unfolded state, or clockwise while the portable electronic device 100 is unfolded from the folded state). At least a portion of, among the wing plates 131 and 132 (FIG. 2), the first wing plate 131 (FIG. 2) may be fixed to the first rotation member 211. As an example, when the hinge structure 201 is the first hinge structure 200a (FIG. 2), the first rotation member 211 may be coupled to the first wing plate 131 (FIG. 2), and when the hinge structure 201 is the second hinge structure 200b (FIG. 2), the first rotation member 211 may be coupled to the second wing plate 132 (FIG. 2). In this regard, the first rotation body 211_3 may include at least one hole or recess that is used to be coupled to the first wing plate 131 (FIG. 2).

The second rotation member 212 may be rotated about a second axis 12 (or a second imaginary axis that is different from that of the second shaft 232 and is formed parallel to the first axis 11). The second rotation member 212 (or a second rotation structure, a second rotation part, or a second rotary body) may, for example, include a second rotation body 212_3, a third rail structure 212_1 (or a third rail that is inserted into the rail), or a fourth rail structure 212_2 (or a fourth rail that is inserted into the rail). According to an embodiment, the second rotation member 212 may include a part (e.g., the third rail structure 212_1) that is fastened to an opposite side (e.g., the second rail 213a2) of the fixing bracket 213) and then fastened to enable a hinge operation, and a part (e.g., fourth rail structure 212_2) that is coupled to the second link member 216, and a second rotation body 212_3 that is disposed between the third rail structure 212_1 and the fourth rail structure 212_2. When the shape of the rail of the fixing bracket 213 is replaced with a rail structure, the third rail structure 212_1 and the fourth rail structure 212_2 may be replaced with a rail shape, in which the rail structure is received. The third rail structure 212_1 and the fourth rail structure 212_2 may be formed to be stepped with respect to the second rotation body 212_3. While the second link member 216 coupled to the second housing 120 (FIG. 2) is moved as the second housing 120 (FIG. 2) is moved, the third rail structure 212_1 of the second rotation member 212 fastened to the fixing bracket 213 may be rotated in place with respect to the second axis 12. The fourth rail structure 212_2 coupled to the second link member 216 may be rotated (or slid) in the second link member 216 while being moved in one direction (e.g., counterclockwise while the portable electronic device 100 is folded from the unfolded state, or clockwise while the portable electronic device 100 is unfolded from the folded state). The third rail structure 212_1 may include a rail structure that is similar to or the same as that of the first rail structure 211_1. The fourth rail structure 212_2 coupled to the second link member 216 may be rotated (or slid) in the second link member 216 while being moved in one direction (e.g., counterclockwise while the portable electronic device 100 is folded from the unfolded state, or clockwise while the portable electronic device 100 is unfolded from the folded state). In this regard, similar to the first link member 215, the second link member 216 may have an empty space formed in the central portion thereof and may include rail wings including curved surfaces disposed on opposite sides thereof. According to an embodiment, at least one of the third rail structure 212_1 and the fourth rail structure 212_2 of the second rotation member 212 may be coupled to one side of the second link member 216 to perform a pivot operation (or a pivot movement) with respect to the axis defined in the second link member 216.

According to an embodiment, the second rotation member 212 may generate friction with the fixing bracket 213 and the second link member 216 while the hinge operation is repeated, similar to the first rotation member 211, and may be formed of a material (e.g., a metallic material) with a certain strength or higher that may withstand it. For example, the second rotation member 212 may be formed of the same material as that of the first rotation member 211. A portion of, among the wing plates 131 and 132 (FIG. 2), the second wing plate 132 (FIG. 2) may be fixed to the second rotation member 212. As an example, when the hinge structure 201 is the first hinge structure 200a (FIG. 2), the second rotation member 212 may also be coupled to the second wing plate 132 (FIG. 2), and when the hinge structure 201 is the second hinge structure 200b (FIG. 2), the second rotation member 212 may be coupled to the first wing plate 132 (FIG. 2). In this regard, the second rotation body 212_3 may include at least one hole or recess that is used to be coupled to the second wing plate 132 (FIG. 2). The second rotation member 212 may be moved in an opposite direction to that of the first rotation member 211. For example, while the first rail structure 211_1 of the first rotation member 211 is rotated counterclockwise in place, the third rail structure 212_1 of the second rotation member 212 may be rotated clockwise in place.

According to an embodiment, while the portable electronic device 100 is folded, the first rail structure 211_1 of the first rotation member 211 may be rotated counterclockwise, and the first link member 215 inserted into the second rail structure 211_2 may be slid clockwise along the second rail structure 211_2 (the sliding operation is relative, and thus, the first link member 215 is slid clockwise relative to the second rail structure 211_2). While the portable electronic device 100 is folded, the third rail structure 212_1 of the second rotation member 212 may be rotated clockwise along the second rail 213a2 of the fixing bracket 213, and the second link member 216 inserted into the fourth rail structure 212_2 may be slid counterclockwise (the sliding motion is relative, and thus, the second link member 216 is slid clockwise relative to the fourth rail structure 212_2).

According to an embodiment, the first link member 215 may include a structure coupled and fixed to one side of the first housing 110 (FIG. 2). The first link member 215 may include an eleventh link side wall 215_1 (or the first side wall of the first link member 215) and a twelfth link side wall 215_2 (or the second side wall of the first link member 215) that extend in the z-axis direction from opposite sides (e.g., x-axis and -x-axis peripheries) of the first link body 215_3, and a first link connecting part 215_4 that connects the first link body 215_3 to the third link member 223. This first link member 215 may include a structure (e.g., the eleventh link side wall 215_1 and the twelfth link side wall 215_2), in which a portion (e.g., the second rail structure 211_2) of the first rotation member 211 is disposed (or coupled, fastened, or seated). A rail wing that protrudes toward the twelfth link side wall 215_2 may be formed in the eleventh link side wall 215_1, and a rail wing that protrudes toward the eleventh link side wall 215_1 may be formed in the twelfth link side wall 215_2. The rail wings may be fastened to the second rail structure 211_2. At least one structure (e.g., a hole, or a recess) that is used to fix the first link member 215 to the first housing 110 (FIG. 2) may be formed in at least one of the eleventh link side wall 215_1 and the twelfth link side wall 215_2. The first link member 215 may be disposed parallel to or integrally formed with the third link member 223 in the -x-axis (or x-axis) direction. The first link connecting part 215_4 may protrude from the twelfth link side wall 215_2 toward the third link member 223.

According to an embodiment, the second link member 216 may include a structure coupled and fixed to one side of the second housing 120 (FIG. 2). The second link member 216 may include a twenty first link side wall 216_1 and a twenty second link side wall 216_2 that extend in the z-axis direction from opposite sides (e.g., the y-axis and -y-axis peripheries) of the second link body 216_3, and a second link connecting part 216_4 used to connect the second link member 216 to the fourth link member 224. The second link member 216 may include a structure (e.g., the twenty first link side wall 216_1 and the twenty second link side wall 216_2), in which a portion (e.g., the fourth rail structure 212_2) of the second rotation member 212 is seated (or coupled, fastened, or disposed). A rail wing that protrudes toward the twenty second link side wall 216_2 may be formed in the twenty first link side wall 215_1, and a rail wing that protrudes toward the twenty first link side wall 216_1 may be formed in the twenty second link side wall 216_2. The rail wings may be fastened to the fourth rail structure 212_2. At least one structure (e.g., a hole or a recess) that is used to fix the second link member 216 to the second housing 120 (FIG. 2) may be formed in the twenty first link side wall 216_1 and the twenty second link side wall 216_2. The above-described second link member 216 may be disposed to be symmetrical to the first link member 215 with respect to the y-axis direction. The second link member 216 may be disposed parallel to or integrally formed with the fourth link member 224 in the -x-axis (or x-axis) direction. The second link connecting part 216_4 may protrude from the twenty second link side wall 216_2 toward of the fourth link member 224.

According to an embodiment, the third link member 223 may include a structure, in which a portion of the first arm member 221 is disposed (or fastened, coupled, or seated). The third link member 223 may include a third link body 223_3, and a thirty first link side wall 223_1 and a thirty second link side wall 223_2 that extends from opposite sides (e.g., y-axis and -y-axis peripheries) of the third link body 223_3 in the z-axis direction. A first link rail 223_1a (or a first rail wing, a link rail on one side of the third link member 223) that protrudes toward the thirty second link side wall 223_2 may be formed in the thirty first link side wall 223_1, and a second link rail 223_1b (or a second rail wing, a link rail on an opposite side of the third link member 223) that protrudes toward the thirty first link side wall 223_1 may be formed on the thirty second link side wall 223_2. The first link rail 223_1a and the second link rail 223_1b may be disposed to face each other with a gap of a specific size. The order of the first link rail 223_1a and the second link rail 223_1b is arbitrary, and may be replaced with each other, changed to another number, or removed. The first link member 215 and the third link member 223 may be integrally formed. The link rails 223_1a and 223_1b are fastened to the first upper arm 221a (or a first sub arm) and the first lower arm 221b (a second sub arm) of the first arm member 221, respectively. A structure (e.g., at least one hole or recess) that is used to fix the third link member 223 to the first housing 110 (FIG. 2) may be formed in the thirty first link side wall 223_1 and the thirty second link side wall 223_2. An empty space may be formed between the thirty first link side wall 223_1 and the thirty second link side wall 223_2, and at least a portion of the first upper arm 221a and the first lower arm 221b of the first arm member 221 may be disposed in the empty space to guide the sliding operation of the first arm member 221. The third link member 223 may include a third link connecting part 223_4 that protrudes in the x-axis direction from one side (e.g., the thirty first link side wall 223_1) of the third link body 223_3. In a process of fixing the first link member 215 and the third link member 223 to the first housing 110 (FIG. 2), the third link connecting part 223_4 may be formed to overlap or be integrally formed with the first link connecting part 215_4 of the first link member 215.

According to an embodiment, the fourth link member 224 may include a structure, in which a portion of the second arm member 222 is disposed (or fastened, coupled, or seated). In this regard, the fourth link member 224 may include a fourth link body (e.g., a link body that is disposed in the same shape as that of the third link body 223_3 and in a position that is symmetrical with respect to the y-axis), a forty first link side wall 224_1 and a forty second link side wall 224_2 that extends in the z-axis direction from opposite sides (e.g., y-axis and -y-axis peripheries) of the fourth link body, and a fourth link connecting part. A third link rail 224_1a (or a third rail wing) that protrudes toward the forty second link side wall 224_2 may be formed in the forty first link side wall 224_1, and a fourth link rail 224_1b (or a fourth rail wing) that protrudes toward the forty first link side wall 224_1a may be formed on the forty second link side wall 224_2. The third and fourth link rails 224_1a and 224_1b are fastened to at least a portion of the second upper arm 222a (or a third sub arm) and the second lower arm 222b (or a fourth sub arm) of the second arm member 222. A structure (e.g., at least one hole or recess) that is used to fix the fourth link member 224 to the second housing 120 (FIG. 2) may be formed in the forty first link side wall 224_1 and the forty second link side wall 224_2. An empty space may be formed between the forty first link side wall 224_1 and the forty second link side wall 224_2, and the empty space may be used to guide the second upper arm 222a and the second lower arm 222b while one side (e.g., the second upper arm 222a and the second lower arm 222b) of the second arm member 222 are slid. The fourth link member 224 may include a fourth link connecting part 224_4 that protrudes in the x-axis direction from one side (e.g., the forty first link side wall 224_1) of the forty link body. In a process of fixing the second link member 216 and the fourth link member 224 to the second housing 120 (FIG. 2), the fourth link connecting part 224_4 may be formed to overlap or be integrally formed with the second link connecting part 216_4 of the second link member 216.

At least one of the first to fourth link members 215, 216, 223, and 224 may be formed of the same material. It may be at least partially formed of another structure (e.g., an injection-molded product). It is illustrated in the above description that the link members 215, 216, 223, and 224 are separated, but the disclosure is not limited thereto. For example, the first link member 215 and the third link member 223 may be connected to or integrally formed with each other, and the second link member 216 and the fourth link member 224 may be connected to or integrally formed with each other. At least some of the components (e.g., at least some of the first to fourth link members 215, 216, 223, and 224) of the hinge structure 201 described above may be omitted. For example, while the first rotation member 211 and the second rotation member 212 are directly coupled to the housings (110 and 120 in FIG. 2), and the arm members 221 and 222 are coupled to the rotation members 211 and 212, they may be rotated in response to the rotation of the rotation members 211 and 212.

According to an embodiment, the first arm member 221 may be disposed to be symmetrical to the second arm member 222 with respect to the x axis or - x axis (or the x axis). Accordingly, parts of the structure of the first arm member 221 described below, which are difficult to observe in the drawing, will be described with reference to the structure of the second arm member 222. The first arm member 221 may be rotated from the y axis in the z-axis direction with respect to the center of the first shaft 231 while the portable electronic device 100 is changed from the unfolded state to the folded state, and may be rotated from the z axis to the y-axis direction while the portable electronic device 100 is changed from the folded state to the unfolded state. The first arm member 221 may be rotated counterclockwise (e.g., a direction, in which the portable electronic device 100 is operated from unfolded state to the folded state) or clockwise (e.g., the portable electronic device 100 is operated from the folded state to the unfolded state) with respect to the x-axis direction. The first arm member 221 may include a first upper arm 221a and a first lower arm 221b that face each other in the x-axis direction (or the -x-axis direction). At least a portion of the first upper arm 221a and the first lower arm 221b may remain in contact. Contact surfaces of the first upper arm 221a and the first lower arm 221b may be in a twisted state. In response to this, as the first elastic body 242a presses the cam member 241 (e.g., the first fixing cam part 241a) in the x-axis direction, the first upper arm 221a may rotated counterclockwise by a twisting contact surface (or a twisting surface) of the first lower arm 221b, and the first lower arm 221b may be rotated clockwise by a twisting surface of the first upper arm 221a. When the first upper arm 221a is rotated counterclockwise, one side of the first upper arm 221a may be in contact with one side (e.g., the first link rail 223_1a) of the third link member 223. When the first lower arm 221b is rotated clockwise, one side of the first lower arm 221b may be in contact with an opposite side (e.g., the second link rail 223_1b) of the third link member 223. The movement of the first arm member 221 can be improved by maintaining the above-described contact state.

According to an embodiment, the second arm member 222 may be disposed to be symmetrical to the first arm member 221 with respect to the y axis or -y axis. The second arm member 222 may be rotated from the -y axis in the z-axis direction with respect to the x axis while the portable electronic device 100 is changed from the unfolded state to the folded state, and may be rotated from the z axis to the -y-axis direction while the portable electronic device 100 is changed from the folded state to the unfolded state. The second arm member 222 may be rotated clockwise while the portable electronic device 100 is folded with respect to the center of the second shaft 232, and may be rotated counterclockwise while the portable electronic device 100 is unfolded. This second arm member 222 may be rotated in an opposite direction to a movement direction of the first arm member 221.

The second arm member 222 may include a second upper arm 222a and a second lower arm 222b that face each other in the x-axis direction (or the -x-axis direction). At least a portion of the second upper arm 222a and the second lower arm 222b may remain in contact. Contact surfaces of the second upper arm 222a and the second lower arm 222b may be in a twisted state. In response to this, as the second elastic body 242b presses the cam member 241 (e.g., the second fixing cam part 241b) in the x-axis direction, the second upper arm 222a may rotated clockwise by a twisting surface of the second lower arm 222b, and the second lower arm 222b may be rotated clockwise by a twisting surface of the second upper arm 222a. When the second upper arm 222a is rotated clockwise, one side of the second upper arm 222a may be in contact with one side (e.g., the third link rail 224_1a) of the fourth link member 224. When the second lower arm 222b is rotated counterclockwise, one side of the second lower arm 222b may be in contact with an opposite side (e.g., the fourth link rail 234_1b) of the third link member 223. The movement of the second arm member 222 can be improved by maintaining the above-described contact state.

According to various embodiments, the first rotation member 211, the second rotation member 212, the first arm member 221 and the second arm member 222, the first to fourth link members 215, 216, 223, and 224, the rail structure (or the arc-shaped rail structure) formed in the fixing bracket 213 may be formed by any one of a rail groove or a rail protrusion, and other coupling components may have a form of rail protrusions or rail grooves. As an example, the second rail structure 211_2 of the first rotation member 211 has the shape of a rail groove, but may be changed to the shape of a rail protrusion, and in response to this, the first link member 215 has a rail protrusion structure that may be inserted into the rail groove of the second rail structure 211_2, and may be changed to the shape of a rail groove correspondingly when the first rotation member 211 is changed to a rail protrusion. Similarly, when one of the sets of the rail structure between the second rotation member 212 and the second link member 216, the first arm member 221 and the third link member 223, and the second arm member 222 and the fourth link member 224 has a recess or protrusion structure to be engaged with each other, the other thereof may be designed to have a protrusion or recess structure.

According to an embodiment, the first shaft 231 may have a rod shape, of which a length in the x-axis or -x-axis direction is greater than a length in the y-axis or z-axis direction. The first shaft 231 may be formed of a metallic material to support the inserted components. A first main gear 233a may be coupled to or formed at (e.g., integrally formed with the first main gear 233a) one end of the first shaft 231. At least a portion of a z-axis cross section of the first shaft 231 may include a flat area and a curved surface. As an example, upper and lower surfaces of the z-axis cross section of the first shaft 231 may be flat, and opposite side surfaces thereof may include curved surfaces. The z-axis cross-section of the first shaft 231 may have a polygonal shape (e.g., a triangular shape, a rectangular shape, a pentagonal shape, a hexagonal shape, and the like). Accordingly, the structure having a cylindrical through-hole may be maintained in the current state without being rotated while the first shaft 231 is rotated, and may be rotated together while the first shaft 231 is rotated when the structure has an angled through-hole that is similar to that of the first shaft 231. For example, the first upper arm 221a and the first lower arm 221b of the first arm member 221, the first fixing cam part 241a of the cam member 241, and at least one washer ring (e.g., a first washer ring 249a, or a third washer ring 249c, a first elastic body 242a, a first fixing portion 243_1 of the shaft fixing part 243, a first coupling member 249e1 (e.g., a first E-ring) may be mounted on the first shaft 231. According to an embodiment, one side of the gear bracket 236 may be inserted into the first shaft 231.

According to an embodiment, the second shaft 232 may have a shape that is the same as or similar to that of the first shaft 231. For example, the second shaft 232 may have a rod shape, of which the length in the x-axis or -x-axis direction is longer than the length in the y-axis or z-axis direction. The second shaft 232 may be formed of a metallic material having a strength of a specific magnitude or more to support inserted components. A second main gear 233b may be coupled to or formed at (e.g., integrally formed with the second main gear 233b) one end of the second shaft 232. As an example, upper and lower surfaces of the z-axis cross section of the second shaft 232 may be flat, and opposite side surfaces thereof may include curved surfaces. The z-axis cross-section of the second shaft 232 may have a polygonal shape. Accordingly, the structure having a cylindrical through-hole may be maintained in the current state without being rotated while the second shaft 232 is rotated, and may be rotated together while the second shaft 232 is rotated when the structure has an angled through-hole that is similar to that of the second shaft 232. For example, the second upper arm 222a and the second lower arm 222b of the second arm member 222, the second fixing cam part 241b of the cam member 241, and at least one washer ring (e.g., a second washer ring 249b, or a fourth washer ring 249d), a second elastic body 242b, a second fixing portion 243_2 of the shaft fixing part 243, a second coupling member 249e2 (e.g., a second E-ring) may be mounted on the second shaft 232. According to an embodiment, an opposite side of the gear bracket 236 may be inserted into one side of the second shaft 232.

The cam member 241 may include a cam body 241c, a first fixing cam part 241a, and a second fixing cam part 241b. The cam member 241 may include a first cam hole 241_1h that passes through the y-axis or -y-axis direction, in which at least a portion of the first shaft 231 is held after the first shaft 231 is inserted, and is formed at a central portion of the first fixing cam part 241a, and a second cam hole 241_2h that passes through the y-axis or -y-axis direction, in which at least a portion of the second shaft 232 is held after the second shaft 232 is inserted, and is formed at a central portion of the second fixing cam part 241b. The cam body 241c may have a specific length, and the first fixing cam part 241a and the second fixing cam part 241b may be disposed at opposite peripheries thereof. A surface (e.g., a surface in the x-axis direction) of the cam body 241c in one direction may be disposed to face a surface (e.g., a surface in the -x-axis direction) of the gear bracket 236 in one direction.

The first fixing cam part 241a may be disposed at a y-axis periphery from a center of the cam body 241c. The first fixing cam part 241a may have a cylindrical shape that entirely surrounds the first cam hole 241_1h that is formed to pass through the x-axis or -x-axis direction, at a center thereof. The first fixing cam part 241a may include a pattern, in which ridges and valleys are repeatedly disposed to be engaged with the cam structure formed in the first lower arm 221b. A central portion of the first cam hole 241_1h may have a specific shape so that the first shaft 231 may pass therethrough. For example, a central portion of the first cam hole 241_1h may have a circular shape. The second fixing cam part 241b may be disposed at a -y-axis periphery from the center of the cam body 241c (or at a position that is opposite or symmetrical to the position, in which the first fixing cam part 241a is formed around the cam body 241c). The second fixing cam part 241b may have a cylindrical shape that entirely surrounds the second cam hole 241_2h that is formed to pass through the x-axis or -x-axis direction, at a center thereof. The second cam hole 241_2h may be formed parallel to the first cam hole 241_1h. The second fixing cam part 241b may include a repeated pattern of ridges and valleys that are disposed to be engaged with the cam structure formed in the second lower arm 222b of the second arm member 222. A central portion of the second cam hole 241_2h may have a specific shape so that the second shaft 232 may pass therethrough. For example, a central portion of the second cam hole 241_2h may have a circular shape similar to the first cam hole 241_1h.

According to an embodiment, the cam member 241 may be retreated in one direction (e.g., the -x-axis direction) in response to the cam movement of the cam structure of the first lower arm 221b and the cam structure of the second lower arm 222b while the first arm member 221 and the second arm member 222 are rotated within a specific angle range, and may be moved in the opposite direction (e.g., the x-axis direction) to the one direction due to the elasticity of the first elastic body 242a (or the third elastic member) and the second elastic body 242b (or the fourth elastic member) to return to an original position when the ridges and valleys of cams (e.g., the cam structures and the cam parts) are engaged with each other.

According to an embodiment, the hinge structure 201 may include a plurality of ring structures (e.g., a first washer ring 249a, a second washer ring 249b, a third washer ring 249c, and a fourth washer ring 249d). The first washer ring 249a may be inserted into one end (e.g., an end in the -x-axis direction) of the first shaft 231, and may be disposed between the shaft fixing part 243 and the first coupling member 249e1. The second washer ring 249b may be inserted into one end (e.g., an end in the -x-axis direction) of the second shaft 232, and may be disposed between the shaft fixing part 243 and the second coupling member 249e2. The first washer ring 249a and the second washer ring 249b may support the first coupling member 249e1 and the second coupling member 249e2, respectively, and prevent or improve the first shaft 231 and the second shaft 232 from being separated from the fixing portions of the shaft fixing part 243 thereof. The third washer ring 249c may have a hole that is formed at the central portion such that the first shaft 231 pass therethrough, and may be disposed between the first elastic body 242a and the first fixing cam part 241a. The third washer ring 249c may receive a pressure applied by the first elastic body 242a to the first fixing cam part 241a and transmit it to the cam member 241, and thus, may eliminates a direct contact between the cam member 241 and the first elastic body 242a to prevent or improve wear of the cam member 241 caused by the first elastic body 242a. The fourth washer ring 249d may perform the same function as that of the third washer ring 249c. For example, the fourth washer ring 249d may have a hole that is formed at the central portion such that the second shaft 232 pass therethrough, and may be disposed between the second elastic body 242b and the second fixing cam part 241b. The fourth washer ring 249d may uniformly receive a pressure applied by the second elastic body 242b to the second fixing cam part 241b first, and may serve to transmit it to the second fixing cam part 241b. The plurality of ring structures (the first washer ring 249a, the second washer ring 249b, the third washer ring 249c, and the fourth washer ring 249d) may have a circular central portion, and thus, may be maintained in the current state even though the first shaft 231 and the second shaft 232 are rotated. At least some of the plurality of ring structures (e.g., the first washer ring 249a, the second washer ring 249b, the third washer ring 249c, and the fourth washer ring 249d) may be removed. Additionally, at least some of the other components of the hinge structure 201 may be removed or modified.

According to an embodiment, the first elastic body 242a (or the first elastic member) may have a spring shape with an empty central portion. At least a portion of the body of the first shaft 231, which passes through the first fixing cam part 241a, may be disposed at the central portion of the first elastic body 242a. The first elastic body 242a may be disposed between the cam member 241 and the shaft fixing part 243, and may be fixed to the shaft fixing part 243 to provide an elastic force such that the cam member 241 is pushed in one direction (e.g., x-axis direction).

According to an embodiment, the second elastic body 242b (or the second elastic member) may be disposed to be spaced apart from the first elastic body 242a by a specific interval, and may be disposed to contact one surface of the second fixing cam part 241b. The second elastic body 242b may exert an elastic force to the second fixing cam part 241b of the cam member 241 through the fourth washer ring 249d. The elastic force generated by the second elastic body 242b may be similar to the elastic force generated by the first elastic body 242a within a specific range.

The shaft fixing part 243 may include a shaft body 243_3, a first fixing portion 243_1, in which the first shaft hole is formed, and a second fixing portion 243_2, in which the second shaft hole is formed. The shaft body 243_3 may include a through-hole that passes in an upward/downward direction (e.g., the -z-axis direction from one point on the z-axis) and is used to fix the shaft fixing part 243 to the hinge housing 150 (FIG. 2). The first shaft hole formed at the first fixing portion 243_1 may be formed to pass in the x-axis or -x-axis direction, and the first shaft 231 may pass therethrough or be disposed therein. A shape of the first shaft hole may be cylindrical, different from the z-axis cross section of the first shaft 231. The first fixing portion 243_1 may support one side of the first elastic body 242a. The second shaft hole formed in the second fixing portion 243_2 may be disposed parallel to the first shaft hole with respect to the x axis, and may be formed to pass in the x-axis or -x-axis direction, and the second shaft 232 pass therethrough and be disposed therein. A shape of the second shaft hole may be cylindrical, different from the z-axis cross section of the second shaft 232. The second fixing portion 243_2 may support one side of the second elastic body 242b.

The hinge structure 201 described above may have sub-arms that are disposed such that the first arm member 221 and the second arm member 222 face each other while being separated from each other, and because the sub-arms are rotated in different directions (e.g., clockwise or counterclockwise) about the x axis with respect to the externally applied elastic force and the twisting surfaces (or a twisting contact surface) that contact each other, it may be in a closer contact (or in a contact state) with the third link member 223 and the fourth link member 224. As the hinge structure 201 of this structure is maintained in the above-mentioned contact state even when it is from the folded state to the unfolded state or from the unfolded state to the folded state, and thus, may support a more robust hinge operation by improving the movement due to the arm members 221 and 222.

At least some of the components of the hinge structure 201 described in FIG. 3 may be omitted. For example, the first and second link members 215 and 216 may be omitted, and the first and second rotation members 211 and 212 may be directly connected to the housings 110 and 120. The gear interlocking structure (e.g., the first and second main gears 233a and 233b and the first and second interlocking gears 234a and 234b) may be omitted from the hinge structure 201. The gear bracket 236 and at least one ring structure may be omitted.

According to various embodiments, the positions of the elastic bodies 242a and 242b in the above-described hinge structure may be changed. For example, the elastic bodies 242a and 242b may be disposed between the arm members 221 and 222 and the fixing bracket 213 (or the rotation members 211 and 212). The positions of the gear interlocking structures may also be disposed in positions other than those illustrated in FIG. 3.

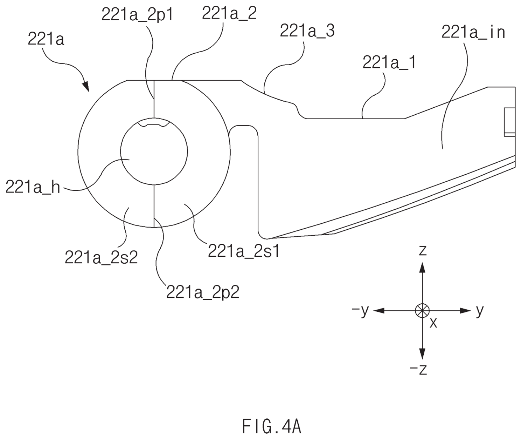

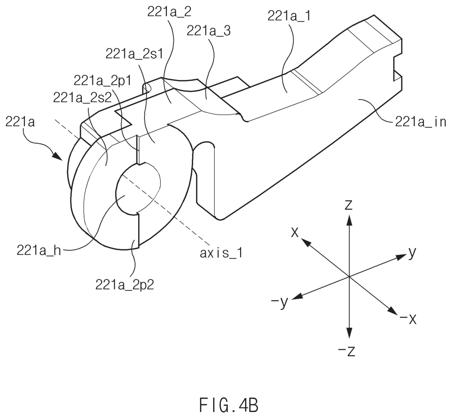

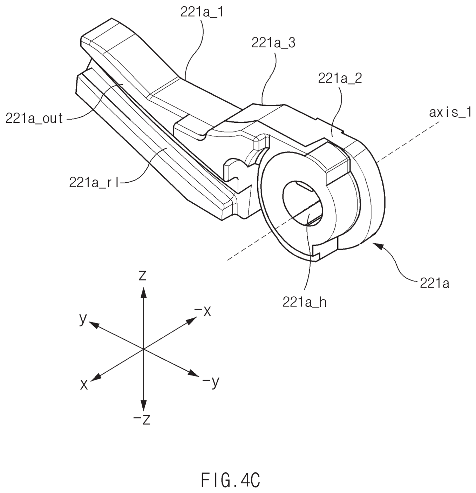

FIG. 4A is a diagram illustrating an example of a first surface of a first upper arm according to various embodiments. FIG. 4B is a perspective view, in which a first surface of the first upper arm is observed according to various embodiments. FIG. 4C is a perspective view, in which a second surface of the first upper arm is observed according to various embodiments. As an example, the first surface of the first upper arm 221a may include a surface that faces the first lower arm 221b or a surface (e.g., an inner surface) that contacts at least a portion of the first lower arm 221b. The second surface of the first upper arm 221a may include a rear surface of the first upper arm 221a from an opposite surface of the first surface. The first upper arm 221a that will be described below may have a structure that is the same as or similar to that of the second upper arm 222a. As an example, the first upper arm 221a may be disposed at the same position as that of the second upper arm 222a with respect to the x axis. The second upper arm 222a may have at least one of the same size, the position, and the shape as those of the first upper arm 221a, except that an operation direction thereof is opposite to that of the first upper arm 221a. Accordingly, a detailed description of the second upper arm 222a may be replaced with the first upper arm 221a. At least a portion of the first upper arm 221a and the second upper arm 222a may be formed of a metallic material.

Referring to FIGS. 3, 4A, 4B and 4C (which may be referred to as FIGS. 3 to 4C), the first upper arm 221a may be disposed between the first lower arm 221b and the first main gear 233a (or the gear bracket 236, or the fixing bracket 213). The first upper arm 221a may include a first upper arm body 221a_1, a first upper arm header 221a_2, and a first upper arm connecting part 221a_3. The first upper arm connecting part 221a_3 may connect one point of the first upper arm body 221a_1 and one point of the first upper arm header 221a_2.

At least a portion of the first upper arm body 221a_1 may be inserted into the third link member 223. In this regard, at least a partial shape of the first upper arm body 221a_1 may have a shape corresponding to at least a portion of the empty space between the first and second link rails 223_1a and 223_1b of the third link member 223. As an example, a thickness of the first upper arm body 221a_1 in the z-axis direction may gradually decrease from the -y-axis in the y-axis direction (or a direction from the second shaft 232 to the first shaft 231). The shape of the first upper arm body 221a_1 in the -z-axis direction may define an inclined surface having a constant inclination from the -y-axis in the y-axis direction. At least a portion of the inner surface 221a_in of the first upper arm body 221a_1 may be formed to be flat when viewed from the -x axis. At least a portion of the inner surface 221a_in of the first upper arm body 221a_1 may face (or contact) an inner surface of the first lower arm 221b. An outer surface 221a_out may be formed on an opposite side of the inner surface 221a_in of the first upper arm body 221a_1. A first upper arm rail 221a_rl may be disposed on the outer surface 221a_out of the first upper arm body 221a_1. As an example, the first upper arm rail 221a_rl may be formed to protrude in the x-axis direction from the outer surface 221a_out of the first upper arm body 221a_1. The first upper arm rail 221a_rl may be formed to have a specific inclination angle with respect to the y axis. For example, the first upper arm rail 221a_rl may be fastened to at least a portion of the first link rail 223_1a of the third link member 223. It is illustrated in the drawing shown that the first upper arm rail 221a_rl has a recess (or a rail recess, or a rail groove) shape that is engraved in one direction (e.g., the -x-axis direction) on a bottom (or a surface) of the outer surface 221a_out of the first upper arm body 221a_1, but the disclosure is not limited thereto. For example, the first upper arm rail 221a_rl may be replaced with a rail boss shape. When being replaced by the rail boss shape, the protruding first upper arm rail 221a_rl may be the first upper arm rail boss, and the first upper arm rail boss may protrude in the x-axis direction from a surface of the outer surface 221a_out of the first upper arm body 221a_1. When the first upper arm rail 221a_rl is replaced with the first upper arm rail boss, the first link rail 223_1a of the third link member 223 may be replaced with a rail recess (or a rail groove) that is engraved on a surface of the link side wall correspondingly.

The first upper arm header 221a_2 may have a first upper hole 221a_h that is formed at the central portion so that the first shaft 231 may be inserted thereinto. For example, at least a portion of the first upper arm header 221a_2, at which the first upper hole 221a_h is formed, may have a ring shape. At least a portion of a surface of the first upper arm header 221a_2 in the z-axis direction may be formed to be flat. The flat surface of the first upper arm header 221a_2 may support at least a portion of the wing plate or at least a portion of the rear surface of the display 160. The inner surface (e.g., a surface that faces the first lower arm 221b) of the first upper arm header 221a_2 may have a circular (or elliptical or polygonal) band shape. The inner surface may form a twisting surface having a specific magnitude of slope from one point to another.

As an example, the first upper arm header 221a_2 may include a first upper step 221a_2p1 (or a first upper protrusion, or a first upper boss) that protrudes from the surroundings, and a second upper step 221a_2p2 (or a second upper protrusion, or a second upper boss). A side surface of a protruding portion of the first upper step 221a_2p1 may be disposed to face the -y-axis direction as illustrated in FIG. 4B, and a side surface of the protruding portion of the second upper step 221a_2p2 may be disposed to face the y-axis direction as illustrated in FIG. 4B. While the first upper step 221a_2p1 and the second upper step 221a_2p2 are disposed to face different directions, a first inclined surface 221a_2s1 that extends clockwise (or a right-handed rotation direction) from the first upper step 221a_2p1 to the second upper step 221a_2p2 with respect to a direction from the -x axis to the x axis, and a second inclined surface 221a_2s2 that extends counterclockwise direction (or a left-hand rotation direction) from the first upper step 221a_2p1 to the second upper step 221a_2p2 may be formed. A part of the first inclined surface 221a_2s1, which is close to the first upper step 221a_2p1, may be formed to protrude in the y-axis direction (formed higher than the surrounding area) by the first upper step 221a_2p1, and a part of the first inclined surface 221a_2s1, which is closer to the second upper step 221a_2p2, may be engraved in the -y-axis direction and be formed (formed lower than the surroundings), compared to the second upper step 221a_2p2. The second inclined surface 221a_2s2 may be formed opposite to the first inclined surface 221a_2s1. For example, a part of the second inclined surface 221a_2s2, which is close to the first upper step 221a_2p1, may be formed to be engraved in the y-axis direction (formed lower than the surrounding area) compared to the first upper step 221a _2p1, and a part of the second inclined surface 221a_2s2, which is closer to the second upper step 221a_2p2, may protrude in the y-axis direction and be formed (formed higher than the surroundings), by the second upper step 221a_2p2. In the above description, the protruding portion of the first inclined surface 221a_2s1 relative to the surrounding area may include one point of the first upper step 221a_2p1, and a protruding portion of the second inclined surface 221a_2s2 relative to the surrounding area may include one point of the second upper step 221a_2p2. The first inclined surface 221a_2s1 may be disposed to have a positive (or negative) inclination angle from the z-axis to the -z-axis when observed in the z-axis direction (or a direction that faces the display 160 (or a direction that is vertical)), and the second inclined surface 221a_2s2 may be disposed to have a negative (or positive) inclination angle from the z-axis to the -z-axis when observed in the z-axis direction. The first inclined surface 221a_2s1 and the second inclined surface 221a_2s2 may be disposed to have different inclinations, on a surface that defines one band. The first and second inclined surfaces 221a_2s1 and 221a_2s2 of the first upper arm header 221a_2 may be formed to protrude in the -x-axis direction, compared to an inner surface of the first upper arm connecting part 221a_3. A portion that is connected to an inner surface of the first upper arm connecting part 221a_3 of the first and second inclined surfaces 221a_2s1 and 221a_2s2 of the first upper arm header 221a_2 may be formed to have the same height as that of the inner surface of the first upper arm connecting part 221a_3.

The first upper hole 221a_h may be formed in the first upper arm header 221a_2 and may be formed to pass through the x-axis and -x-axis. A center of the first upper hole 221a_h may be positioned on an imaginary rotation axis axis_1 (or a rotation axis or an axis), about which the first upper arm 221a is rotated. The first upper hole 221a_h may have an overall cylindrical hollow shape. A step may be formed on the inner wall of the hole of the first upper arm header 221a_2, which defines the first upper hole 221a_h, so that it may be rotated as the inserted first shaft 231 is rotated. As an example, at least a portion of a z-axis cross-section of the first upper hole 221a_h may have a D-cut shape. At least a portion of the step formed in the first upper hole 221a_h may be curved (e.g., in a convexo-concave shape). The step formed in the first upper hole 221a_h may be designed to contact one side of the first shaft 231 after the first upper arm 221a is rotated counterclockwise at a pre-designed specific angle. At least one point of the first shaft 231 may have a flat shape (e.g., a shape corresponding to an inner shape of the first upper hole 221a_h, on which the step is formed) so that the first upper arm 221a may be rotated in response to the rotation of the first shaft 231 (or so that the first upper arm 221a, on which the inserted first shaft 231 is mounted, may be rotated). Additionally, an outer shape of the first upper arm header 221a_2, which defines the first upper hole 221a_h, may have a stopper (or at least one step, or a circular band shape, but only a portion of a cloud shape is formed) to prevent or block the first upper arm 221a from being rotated at a pre-designed specific angle or more.

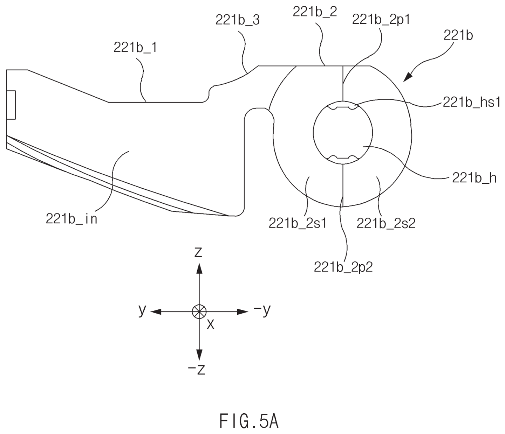

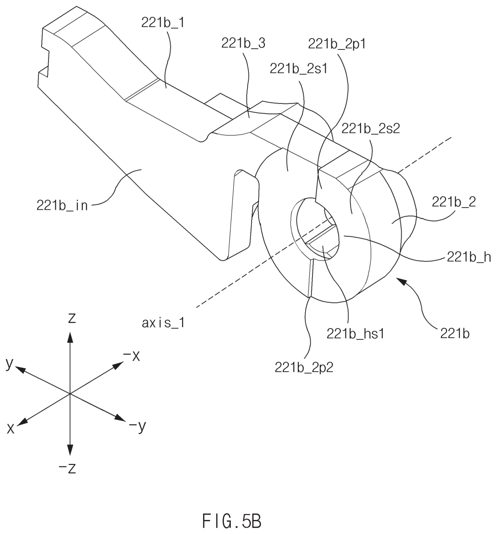

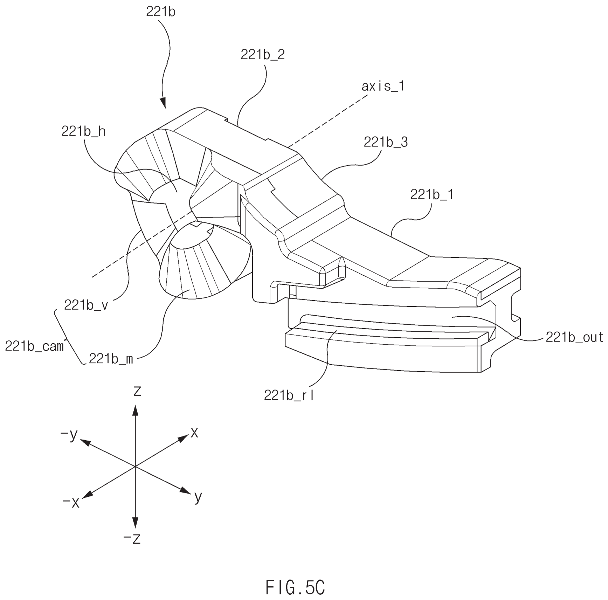

FIG. 5A is a diagram illustrating an example of a first surface of a first lower arm according to various embodiments. FIG. 5B is a perspective view, in which a first surface of a first lower arm is observed according to various embodiments. FIG. 5C is a perspective view, in which a second surface of a first lower arm is observed according to various embodiments.

As an example, the first surface of the first lower arm 221b may include a surface that faces the first upper arm 221a or a surface (e.g., an inner surface) that contacts at least a portion of the first upper arm 221a. The second surface of the first lower arm 221b may include a rear surface of the first lower arm 221b from an opposite surface of the first surface. The first lower arm 221b that will be described below may have a structure that is the same as or similar to that of the second lower arm 222b. As an example, the first lower arm 221b may be disposed at the same position as that of the second lower arm 222b with respect to the x axis. The second lower arm 222b may have at least one of the same size, the position, and the shape as those of the first upper arm 221a, except that an operation direction thereof is opposite to that of the first lower arm 221b. Accordingly, a detailed description of the second lower arm 222b may be replaced with the first lower arm 221b. At least a portion of the first lower arm 221b and the second lower arm 222b may be formed of a metallic material. In the above description, the order of defining surfaces, such as the first surface and the second surface, may vary depending on a direction, in which they are observed. As an example, in the disclosure, it is described that the first side indicates the inner surface of the sub-arm, and the second side indicates the outer surface of the sub-arm, but when defined based on a specific sub-arm, the order or directions of the above-mentioned sides may be redefined. Accordingly, the order (numbers) added to indicate the sides may be changed depending on the relationship with the surrounding structures in the process of understanding sides. Application or change of this order or numbers may apply to all embodiments of the disclosure.

Referring to FIGS. 3, 4A, 4B, 4C, 5A, 5B and 5C (which may be referred to as FIGS. 3 to 5C), the first lower arm 221b may be disposed between the first upper arm 221a and the cam member (the cam member 241 of FIG. 3) (or the first elastic body (the first elastic body 242a of FIG. 3)) with respect to the x-axis direction. The first lower arm 221b may include a first lower arm body 221b_1, a first lower arm header 221b_2, and a first lower arm connecting part 221b_3. The first lower arm connecting part 221b_3 may connect one point of the first lower arm body 221b_1 and one point of the first lower arm header 221b_2.

At least a portion of the first lower arm body 221b_1 may be inserted into the third link member 223. In this regard, similar to the first upper arm body 221a_1, at least a partial shape of the first lower arm body 221b_1 may have a shape corresponding to at least a portion of the empty space between the first and second link rails 223_1a and 223_1b of the third link member 223. As an example, a thickness of the first lower arm body 221b_1 in the z-axis direction may gradually decrease from the -y-axis in the y-axis direction. A shape of the first lower arm body 221b_1 in the -z-axis direction may form an inclined surface with a certain inclination (e.g., an inclination that is greater than 0). At least a portion of the inner surface 221b_in of the first lower arm body (221b_1) may be formed to be flat when observed from the x-axis. At least a portion of the inner surface 221b_in of the first lower arm body 221b_1 may face (or contact) an inner surface 221a_in of the first upper arm 221a. An outer surface 221b_out, on which the first lower arm rail 221b_rl is disposed, may be formed on an opposite side of the inner surface 221b_in of the first lower arm body 221b_1.

As an example, the first lower arm rail 221b_rl may have a shape of a rail groove that is engraved in the x-axis direction on the outer surface 221a_out of the first lower arm body 221b_1. The first lower arm rail 221b_rl may be formed to have a similar inclination angle to the first upper arm rail 221a_rl. At least a portion of the first lower arm rail 221b_rl, for example, may be fastened to the second link rail 223_1b of the third link member 223. It is illustrated in the drawing shown that the first lower arm rail 221b_rl has a shape that is engraved in one direction (e.g., the x-axis direction) on a bottom (or a surface) of the outer surface 221b_out of the first lower arm body 221b_1, but the disclosure is not limited thereto. For example, the first lower arm rail 221b_rl may be replaced with a rail boss shape that protrudes in the -x-axis direction from the surface of the outer surface 221b_out. When the rail boss shape is replaced, the protruding first lower arm rail 221b_rl may become the first lower arm rail boss. When the first lower arm rail 221b_r is replaced with the first lower arm rail boss, the first link rail 223_1a of the third link member 223 may be replaced with a rail groove structure that is engraved on a surface of the link side wall correspondingly.

The first lower arm header 221b_2 may have a first lower hole 221b_h at a central portion thereof so that at least a portion of the first shaft 231 may be inserted thereinto. For example, at least a portion of the first lower arm header 221b_2, at which the first lower hole 221b_h is formed, may have a ring or donut shape. At least a portion of a surface of the first lower arm header 221b_2 in the z-axis direction may be formed to be flat, similar to a surface of the first upper arm header 221a_2 in the z-axis direction. The inner surface (e.g., a surface that faces the first lower arm 221b from the x axis in the -x-direction) of the first lower arm header 221b_2 may have a circular (or elliptical or polygonal) band shape. The inner surface of the first lower arm header 221b_2 may define a twisting surface having a specific magnitude of slope from one point to another. The slope direction of the twisting surface formed in the first lower arm header 221b_2 may be opposite to the slope direction formed in the first upper arm header 221a_2. A boss 221b_hs1 (or a step, a convexo-concave portion) that contacts the first shaft 231 of FIG. 3 may be disposed in an interior of the first lower hole 221b_h. As an example, at least one boss 221b_hs1 may be disposed on a ceiling and a bottom of a peripheral area that defines the first lower hole 221b_h.

As an example, the first lower arm header 221b_2 may include a first lower step 221b_2p1 (or a first lower protrusion, or a first lower boss) that protrudes from the surrounding area, and a second lower step 221b_2p2 (or a first lower protrusion, or a first lower boss). A side surface of a protruding portion of the first lower step 221b_2p1 may be disposed to face the y-axis direction as illustrated in FIG. 5B, and a side surface of the protruding portion of the second lower step 221b_2p2 may be disposed to face the -y-axis direction as illustrated in FIG. 5B.

As the first lower step 221b_2p1 and the second lower step 221b_2p2 are disposed to face different directions, with respect to a direction from the x-axis to the -x-axis, a third inclined surface 221b_2s1 that extends clockwise from the first lower step 221b_2p1 to the second lower step 221b_2p2, and a fourth inclined surface 221b_2s2 that extends counterclockwise from the first lower step 221b_2p1 to the second lower step 221b_2p2 may be formed. The third inclined surface 221b_2s1 may be formed in an opposite direction to a slope direction formed on the first inclined surface 221a_2s1. The fourth inclined surface 221b_2s2 may be formed in an opposite direction to a slope direction formed on the second inclined surface 221a_2s2. As an example, one point of the first lower step 221b_2p1 of the third inclined surface 221b_2s1 may be formed higher than the surrounding area, and one point that is adjacent to the second lower step 221b_2p2 may be formed lower than the surrounding area. One point of the first lower step 221b_2p1 of the fourth inclined surface 221b_2s2 may be formed lower than the surrounding area, and one point of the second lower step 221b_2p2 may be formed higher than the surrounding area. The third inclined surface 221b_2s1 may be disposed to have a negative (or positive) inclination angle from the z-axis to the -z-axis when observed in the z-axis direction (or a direction that faces the display 160 (or a direction that is vertical)), and the fourth inclined surface 221b_2s2 may be disposed to have a positive (or negative) inclination angle from the z-axis to the -z-axis when observed in the z-axis direction. The third and fourth inclined surfaces 221b_2s1 and 221b, 2s2 of the first lower arm header 221b_2 may be formed to protrude in the x-axis direction compared to an inner surface of the first lower arm connecting part 221b_3 or may be formed to have the same height as that of a part that is connected to the first lower arm connecting part 221b_3. According to an embodiment, a central portion (e.g., a central portion of an inclined surface that extends from the first lower step 221b_2p1 to the bottom of the second lower step 221b_2p2) of the third inclined surface 221b_2s1 and a central portion (e.g., a central portion of an inclined surface that extends from the second lower step 221b_2p2 to the bottom of the first lower step 221b_2p1) of the fourth inclined surface 221b_2s2 may have the same height. Similarly, the shapes of the first inclined surface 221a_2s1 and the second inclined surface 221a_2s2 may be formed such that the heights of the central portions are the same. Accordingly, when the first inclined surface 221a_2s1 and the third inclined surface 221b_2s1 contact each other and the second inclined surface 221a_2s2 and the fourth inclined surface 221b_2s2 contact each other, they may be disposed to be engaged with each other without any protruding parts. As an example, a portion of the first inclined surface 221a_2s1 (or the second inclined surface 221a_2s2), which protrudes in one direction (e.g., the x-axis direction) may contact a portion of the third inclined surface 221b_2s1 (or the fourth inclined surface 221b_2s2), which is engraved in an opposite direction (e.g., the -x-axis direction), and a portion of the first inclined surface 221a_2s1 (or the second inclined surface 221a_2s2), which is engraved in one direction (e.g., the x-axis direction) may contact a portion of the third inclined surface 221b_2s1 (or the fourth inclined surface 221b_2s2), which protrudes in an opposite direction (e.g., the -x-axis direction).

The first lower hole 221b_h may be formed in the first lower arm header 221b_2 and may be formed to pass through the x-axis and -x-axis. A center of the first lower hole 221b_h may be positioned on an imaginary rotation axis axis_1 (or a rotation axis or an axis), about which the first lower arm 221b is rotated. The first lower hole 221b_h may have an overall cylindrical hollow shape. A step may be formed on the inner wall of the hole of the first lower arm header 221b_2, which defines the first lower hole 221b_h, so that it may be rotated as the inserted first shaft 231 is rotated. As an example, at least a portion of a z-axis cross-section of the first lower hole 221b_h may have a D-cut shape. At least a portion of the step formed in the first lower hole 221b_h may be curved (e.g., in a convexo-concave shape). The step formed in the first lower hole 221b_h may be designed to contact the first shaft 231 when the first shaft 231 is inserted thereinto. The first lower hole 221b_h may be associated with the first upper hole 221a_h.

Additionally, an outer shape of the first lower arm header 221b_2, which defines the first lower hole 221b_h, may be formed to correspond to the first fixing cam part 241a formed in the cam member 241. For example, as illustrated in FIG. 5C, the first lower arm header 221b_2 may include a first rotation cam 221b_cam that is formed from the x-axis in the -x-axis direction and has a repeated pattern of the mountains 221b_m of the cam structure and the valleys 221b_v of the cam structure.

It is illustrated in the above description that the steps 221a_2p1, 221a_2p2, 221b_2p1, and 221b_2p2 have shapes that are disposed parallel to the z-axis direction, but the disclosure is not limited thereto. For example, the steps 221a_2p1, 221a_2p2, 221b_2p1, and 221b_2p2 may be formed parallel to each other in the y-axis direction. As an example, the steps 221a_2p1, 221a_2p2, 221b_2p1, and 221b_2p2 may be disposed on an inner surface of the header in the y-axis direction and -y-axis direction, respectively, with respect to an imaginary axis. When the steps 221a_2p1, 221a_2p2, 221b_2p1, and 221b_2p2 are disposed parallel to the y axis, starting and ending points of the inclined surfaces 221a_2s1, 221a_2s2, 221b_2s1, and 221b_2s2 may be changed to correspond to the positions of the steps 221a_2p1, 221a_2p2, 221b_2p1, and 221b_2p2 disposed to be parallel to the y axis.

According to various embodiments, although a structure, in which the steps 221a_2p1, 221a_2p2, 221b_2p1, and 221b_2p2 are symmetrical in an upward/downward direction or a leftward/rightward direction with respect to the imaginary axis axis_1, is illustrated, at least some of the embodiments of the disclosure may employ other structures. For example, the steps 221a_2p1, 221a_2p2, 221b_2p1, and 221b_2p2 may not be disposed at intervals of 180 degrees (e.g., the first inclined surface 221a_2s1 is formed to include, among the areas of the header, which are disposed in a direction of 360 degrees, an area in a direction of 270 degrees, and the second inclined surface 221a_2s2 is formed to include an area in a direction of 90 degrees, while a starting point of the first inclined surface 221a_2s1 is adjacent to an ending point of the second inclined surface 221a_2s2, and an ending point of the first inclined surface 221a_2s1 is adjacent to a starting point of the second inclined surface 221a_2s2, but may be disposed at an interval of 270 degrees (or 90 degrees), or may be disposed at an interval of 300 degrees (or 60 degrees) (e.g., the first inclined surface 221a_2s1 is formed to include, among areas of the header disposed in a direction of 360 degrees, an area in a direction of 300 degrees, and the second inclined surface 221a_2s2 is formed to include an area in a direction of 60 degrees).

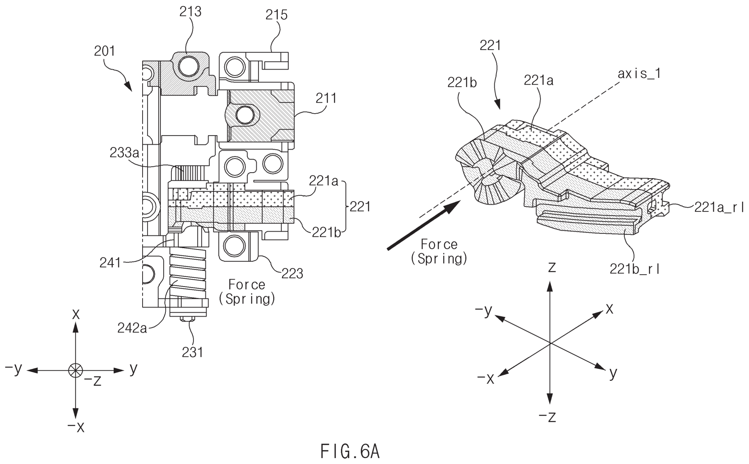

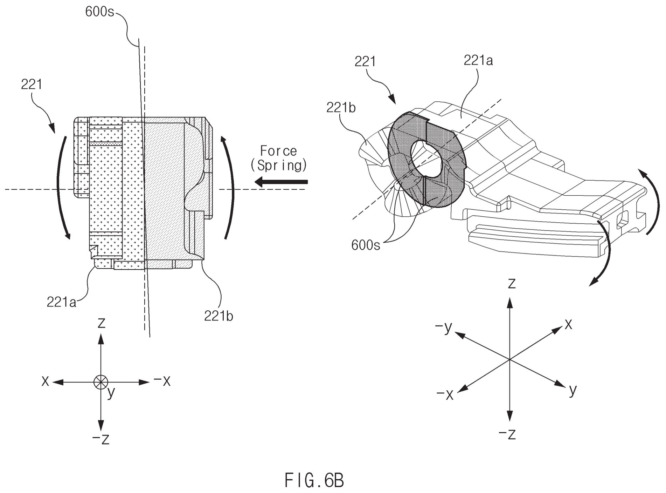

FIG. 6A is a diagram and perspective view illustrating an example of a pressing structure related to a first arm member in a hinge structure according to various embodiments. FIG. 6B is a diagram and perspective view illustrating an example of twisting of a first arm member due to a pressing structure according to various embodiments.

Referring to FIGS. 1, 2, 3, 4A, 4B, 4C, 5A, 5B, 5C 6A and 6B (which may be referred to as FIGS. 1 to 6B), the hinge structure 201 according to an embodiment may include the fixing bracket 213, the first link member 215, the first rotation member 211, the third link member 223, the first arm member 221, the cam member 241, the first shaft 231, the first main gear 233a and the first elastic body 242a. The hinge structure 201 may further include at least some of the components as illustrated above in FIG. 3.

The first elastic body 242a inserted into the first shaft 231 may press the cam member 241 (e.g., the first fixing cam part 241a of FIG. 3) from the -x axis in the x-axis direction. The cam member 241 may press the first arm member 221 in the x-axis direction by the elastic force provided by the first elastic body 242a. The first arm member 221 may be disposed between the cam member 241 and the first main gear 233a. The first main gear 233a may be disposed not to be moved in the x-axis direction. Accordingly, the elastic force provided by the first elastic body 242a may be transmitted to the first lower arm 221b and the first upper arm 221a. As described above in FIGS. 4A, 4B, 4C, 5A, 5B and 5C, the first lower arm 221b and the first upper arm 221a may contact each other in a twisted state as the surfaces that contact each other have a specific inclination angle. According to an embodiment, as illustrated shown in FIG. 6B, the first lower arm 221b and the second upper arm 222a may define a contact surface corresponding to the twisting surface 600s (or a twisting axis) with respect to the z-axis direction (or the -z-axis direction). As described above, as illustrated in FIG. 6A, as the first lower arm 221b and the first upper arm 221a come into contact with specific inclined surfaces, the first lower arm 221b may be rotated clockwise along the twisting surface 600s based on the transmitted elastic force, and the second lower arm 222b may be rotated counterclockwise along the twisting surface 600s when the elastic force is applied from the -x-axis in the x-axis direction.

When the first lower arm 221b is rotated clockwise, the first lower arm rail 221b_rl may also be rotated clockwise and may be in contact with at least a portion of one side (e.g., one side of the second link rail 223_1b of FIG. 3) of the third link member 223. When the first upper arm 221a is rotated counterclockwise, the first upper arm rail 221a_rl may also be rotated counterclockwise and may be in contact with at least a portion of an opposite side (e.g., one side of the first link rail 223_1a) of the third link member 223.

The rotation due to the elastic force applied to the above-described first upper arm 221a and the first lower arm 221b may be equally applied to the second upper arm 222a and second lower arm 222b. For example, when the second upper arm 222a and the second lower arm 222b contact each other while defining the twisting surface 600s described in FIG. 6b, the second lower arm 222b may be rotated counterclockwise and the second upper arm 222a may be rotated clockwise when the second elastic body 242b of FIG. 3 provides an elastic force to the cam member 241 (e.g., the second fixing cam part 241b of FIG. 3). In response to this, a second lower arm rail (e.g., a rail that is disposed in the second lower arm 222b and corresponds to the first lower arm rail 221b_r) formed in the second lower arm 222b may contact one side (e.g., one side of the fourth link rail 224_1b of FIG. 3) of the fourth link member 224, and a second upper arm rail (e.g., a rail that is disposed on the second upper arm 222a and corresponds to the first upper arm rail 221a_rl) formed in the second upper arm 222a may contact an opposite side (e.g., one side of the third link rail 224_1a of FIG. 3) of the fourth link member 224.

As described above, the hinge structure 201 according to an embodiment may include sub-arms (e.g., the first upper arm 221a, the first lower arm 221b, the second upper arm 222a, and the second lower arm 222b) which the first arm member 221 and the second arm member 222 contact while being separated from each other to define twisting surfaces, and may be disposed to be rotated in different directions by the elastic force applied by the elastic body (e.g., the first and second elastic bodies 242a and 242b of FIG. 3). In this hinge structure 201, the first arm member 221 may be maintained in a contact state with the third link member 223 more firmly and stably, and the second arm member 222 may be maintained in a contact state with the fourth link member 224 more firmly and stably whereby movements between the arm members 221 and 222 and the third and fourth link members 224_1a and 224_1b can be reduced (or improved) while the portable electronic device is changed to the folded or unfolded state.

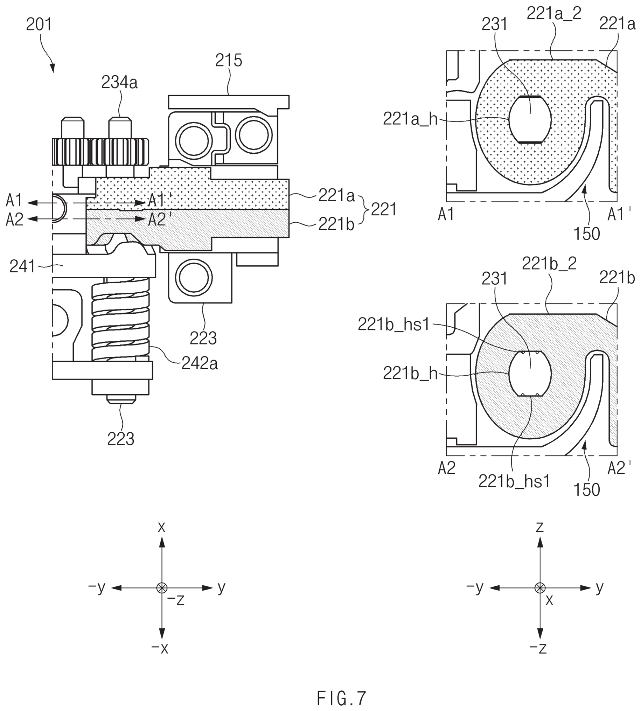

FIG. 7 is a diagram illustrating an example of a coupling form of a first upper arm, a second upper arm, and a first shaft in a hinge structure according to various embodiments.

Referring to FIGS. 1, 2, 3, 4A, 4B, 4C, 5A, 5B, 5C, 6A, 6B and 7 (which may be referred to as FIGS. 1 to 7), the hinge structure 201 according to an embodiment may include at least the first link member 215, the third link member 223, the first arm member 221, the first main gear 233a, the first shaft 231, the first elastic body 242a, and the cam member 241. Additionally, the hinge structure 201 may further include at least some of the components of the hinge structure described above in FIG. 3. At least a portion of the hinge structure 201 may be disposed in a partial space of the hinge housing 150.

In a cross-section along cutting line A1-A1', the first upper arm header 221a_2 of the first upper arm 221a may include a first upper hole 221a_h, and at least a portion of the first shaft 231 may be seated in the first upper hole 221a_h. At least a partial cross-section of the first shaft 231 in the z-axis and - z-axis directions may be formed to be flat. Accordingly, at least a portion of a z-axis cross section of the first shaft 231 may have a D-cut shape. In response to this, the z-axis cross-section of the first upper hole 221a_h may have a D-cut shape similar to the cross-section of the first shaft 231. According to an embodiment, the first upper hole 221a_h may be formed to be greater than the cross-section of the first shaft 231. The gap formed between the first upper hole 221a_h and the first shaft 231 may provide a support such that the first upper arm 221a may be rotated counterclockwise by a specific angle while the first lower arm 221b is rotated clockwise by a specific angle.

In a cross-section along cutting line A2-A2', the first lower arm header 221b_2 of the first lower arm 221a may include a first lower hole 221b_h, and at least a portion of the first shaft 231 may be seated in the first lower hole 221b_h. At least a portion of the z-axis cross section of the first shaft 231 inserted into the first lower arm 221b may be formed to be flat similar to the portion inserted into the first upper arm 221a, and at least another portion thereof may be formed as a curved surface. The z-axis cross-section of the first lower hole 221b_h may have a D-cut shape similar to the cross-section of the first shaft 231. According to an embodiment, a boss 221b_hs1 (or a step, a convexo-concave portion) that contacts the first shaft 231 may be disposed in an interior of the first lower hole 221b_h. As an example, the boss 221b_hs1 may be formed on at least one of an inner wall of the first lower hole 221b_h in the z-axis direction and an inner wall of the first lower hole 221b_h in the -z-axis direction. The boss 221b_hs1 may be disposed at at least one (or two) site on the inner wall that defines the first lower hole 221b_h that may contact the flat area of the first shaft 231.

Through the above-mentioned boss 221b_hs1, the first lower arm header 221b_2 that defines the first lower hole 221b_h and the first shaft 231 may have a compressed state (or, a state of a plurality of points, at which there is no gap between the first lower arm header 221b_2 and the first shaft 231) with a pressure of a pre-designed reference value or more. In response to this, while the first lower arm 221b is rotated through the pressing of the first elastic body 242a and the twisting surface 600s with the first upper arm 221a, it may be maintained in a firm contact with the first shaft 231.

According to an embodiment, in the hinge structure 201, the sizes of the first upper hole 221a_h and the first lower hole 221b_h are different, and thus, the above-described contact state (e.g., a state, in which the first lower arm header 221b_2 and the first shaft 231 contact each other with a strong press-fitting structure, and at least portion of the press-fitting of the first upper arm header 221a_2 and the first shaft 231 is removed due to an assembly tolerance (or a gap is formed)) may be maintained. The hinge structure 201 may have different sizes for positions (e.g., a position, in which the first upper arm header 221a_2 and the first shaft 231 overlap each other, and a position, in which the first lower arm header 221b_2 and the second shaft 232 overlap each other, when viewed in the z-axis direction) of the first shaft 231 to form the above-described contact state. According to various embodiments, the boss 221b_hs1 may be excluded from the first lower arm 221b, and may be formed in the first upper arm 221a.

In the above description, an example, in which at least a portion of the upper and lower portions of the first shaft 231, on which the first arm member 221 is mounted, has a flat shape, has been suggested, but a cross-section of the first shaft 231 in the z-axis direction may be circular (or elliptical, or polygonal) in another position (e.g., another position, in which the first arm member 221 is not mounted, for example, a position, in which the first elastic body 242a is mounted) of the first shaft 231. The first shaft 231 may have an overall shape, of which upper and lower portions are flat.

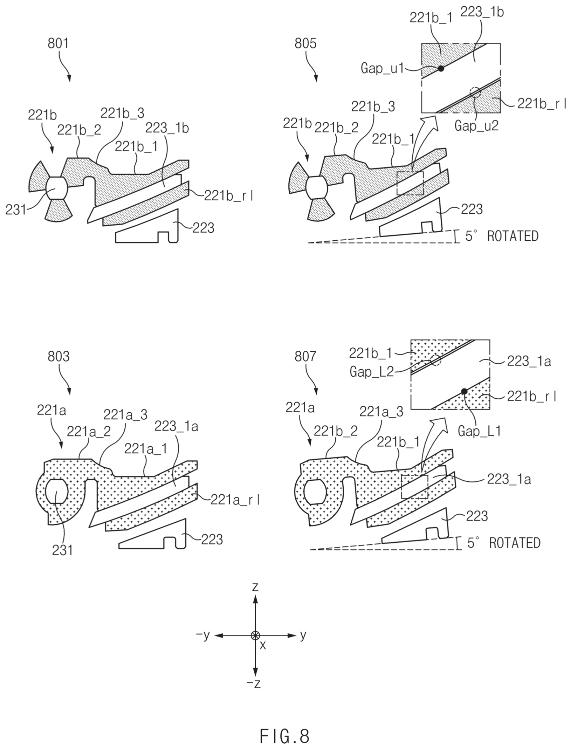

FIG. 8 is a diagram illustrating an example of a disposition state of a first upper arm, a first lower arm, and a third link member according to various embodiments. For example, the cross-section illustrated in FIG. 8 may be regarded as at least a portion of the cross-section when cutting lines A1-A1' and A2-A2' described above in FIG. 7 extend to the ends of the arm members.

Referring to at least a portion of FIGS. 1 to 7 and FIG. 8, the hinge structure 201 may include at least a first lower arm 221b, a first upper arm 221a, and a third link member 223. In state 801, the first lower arm 221b may include a first lower arm header 221b_2, a first lower arm body 221b_1, and a first lower arm connecting part 221b_3, and at least a portion of the first shaft 231 may be disposed to pass through the central portion of the first lower arm header 221b_2. State 801 may include a state, in which the portable electronic device is unfolded. As described above, the first lower arm body 221b_1 may include a first lower arm rail 221b_rl, and the first lower arm rail 221b_rl may be coupled to the second link rail 223_1b of the third link member 223. As described above in FIGS. 6A and 6B, the first elastic body 242a may provide an elastic force to the first lower arm 221b so that at least a portion or the entirety of one side (e.g., among the side walls that define the rail groove, an upper side wall that is disposed in the z-axis direction) of the first lower arm rail 221b_rl, which has a rail groove shape, may contact the second link rail 223_1b when the first lower arm 221b is rotated clockwise. According to an embodiment, at least a portion of an opposite side (e.g., among the side walls that define the rail groove, a lower side wall that is disposed in the -z-axis direction) of the first lower arm rail 221b_rl, which has a rail groove shape, may not contact the second link rail 223_1b. A size of a contact surface of the upper side wall of the first lower arm rail 221b_rl which contacts an upper portion (e.g., one surface in the z-axis direction) of the second link rail 223_1b may be greater than a size of a contact surface of the lower side wall of the first lower arm rail 221b_rl, which contacts a lower portion (e.g., one surface in the -z-axis direction) of the second link rail 223_1b.

In state 803 (e.g., a cross-section in the unfolded state of the portable electronic device), the first upper arm 221a may include a first upper arm header 221a_2, a first upper arm body 221a_1, and a first upper arm connecting part 221a_3, and at least another portion of the first shaft 231 may be disposed to pass through the central portion of the first upper arm header 221a_2. The first upper arm body 221a_1 may include a first upper arm rail 221a_rl, and the first upper arm rail 221a_rl may be fastened to the first link rail 223_1a of the third link member 223. When the first elastic body (e.g., the first elastic body 242a of FIG. 6A) provides an elastic force to the first upper arm 221a through the first lower arm 221b, the first upper arm 221a may be rotated counterclockwise in response to the clockwise rotation of the first lower arm 221b. In response to the counterclockwise rotation of the first upper arm 221a, at least a portion or entirety of one side (e.g., among the side walls forming the rail groove, an upper side wall that is disposed in the z-axis direction) of the first upper arm rail 221a_rl, which has a rail groove shape, may contact the first link rail 223_1a. According to an embodiment, at least a portion of an opposite side (e.g., among the side walls that define the rail groove, a lower side wall that is disposed in the -z-axis direction) of the first upper arm rail 221a_rl, which has a rail groove shape, may not contact the first link rail 223_1a. A size of a surface, on which the first link rail 223_1a and a side wall of and the first upper arm rail 221a_rl, which is formed in the -z-axis direction, contact each other, may be greater than a size of a contact surface, on which the first link rail 223_1a and a side wall of the first upper arm rail 221a_rl, which is formed in the z-axis direction, contact each other. The first distance between a lower portion (e.g., one surface in the - z-axis direction) of the first link rail 223_1a and a lower side wall of the first upper arm rail 221a_rl may be smaller than a second distance between an upper portion (e.g., one surface in the z-axis direction) of the first link rail 223_1a and an upper side wall of the first upper arm rail 221a_rl. A first distance between an upper portion (e.g., one surface in the z-axis direction) of the second link rail 223_1b and an upper side wall of the first lower arm rail 221b_rl may be smaller than a second distance between a lower portion (e.g., one surface in the -z-axis direction) of the second link rail 223_1b and a lower side wall of the first lower arm rail 221b_rl.

In state 805 (e.g., a state, in which the portable electronic device is rotated by a specific angle (e.g., 5 degrees) from the unfolded state), even though the portable electronic device is rotated by a specific angle, the first elastic body (e.g., the first elastic body 242a described in FIG. 6A) may provide an elastic force to the first lower arm 221b so that the first lower arm 221b remains rotated clockwise. Accordingly, one side (e.g., among the side walls that define the rail groove when the hinge structure is unfolded, an upper side wall that is disposed in the z-axis direction) of the first lower arm rail 221b_rl provided in a rail groove shape may contact an upper side (e.g., a portion that faces the z-axis direction when the hinge structure is unfolded) of the second link rail 223_1b to have a state, in which there is no gap Gap_ul between an upper side wall of the first lower arm rail 221b_rl and an upper side of the second link rail 223_1b. According to an embodiment, an opposite side (e.g., among the side walls that form the rail groove, a lower side wall that is disposed in the -z-axis direction when the hinge structure is unfolded) of the first lower arm rail 221b_rl, which is provided in a rail groove shape, may have a gap Gap_u2 that is formed with a specific tolerance with a lower side (e.g., a portion that faces the -z-axis direction when the hinge structure is unfolded) of the second link rail 223_1b.

In state 807 (e.g., a state, in which the portable electronic device is rotated by a specific angle (e.g., 5 degrees) from the unfolded state), even though the portable electronic device is rotated by a specific angle, the first elastic body (e.g., the first elastic body 242a described in FIG. 6A) may provide an elastic force to the first upper arm 221a so that the first upper arm 221a remains rotated counterclockwise. According to an embodiment, one side (e.g., among the side walls that form the rail groove, a lower side wall that is disposed in the -z-axis direction when the hinge structure is unfolded) of the first upper arm rail 221a_rl, which is provided in a rail groove shape, may have no gap Gap_L1 while contacting a lower side (e.g., a portion that faces the -z-axis direction when the hinge structure is unfolded) of the first link rail 223_1a. According to an embodiment, an opposite side (e.g., among the side walls that form the rail groove, an upper side wall that is disposed in the z-axis direction when the hinge structure is unfolded) of the first upper arm rail 221a_rl, which is provided in a rail groove shape, may have a gap Gap_L2 while not contacting an upper side (e.g., a portion that faces the z-axis direction when the hinge structure is unfolded) of the first link rail 223_1a.

The disposition form described above in FIG. 8 may be applied equally or similarly to the second upper arm 222a, the second lower arm 222b, and the fourth link member 224 (e.g., applied in an opposite direction to the rotation direction of the first upper arm 221a and the first lower arm 221b).

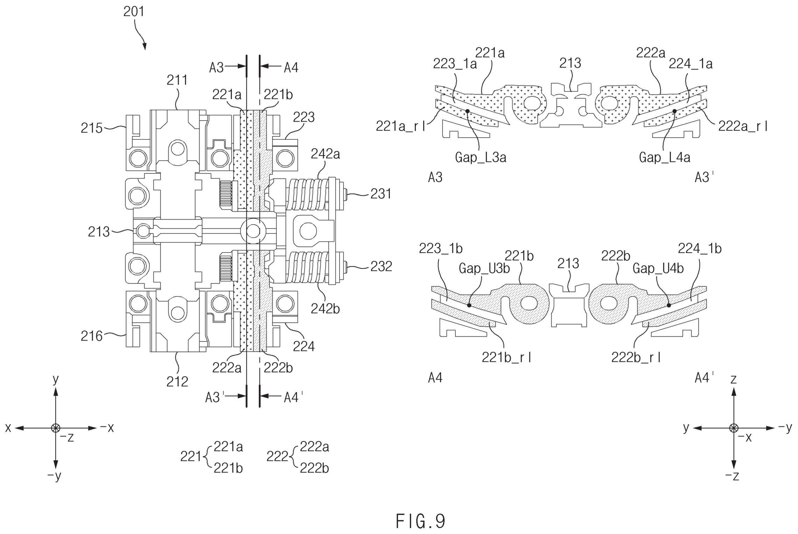

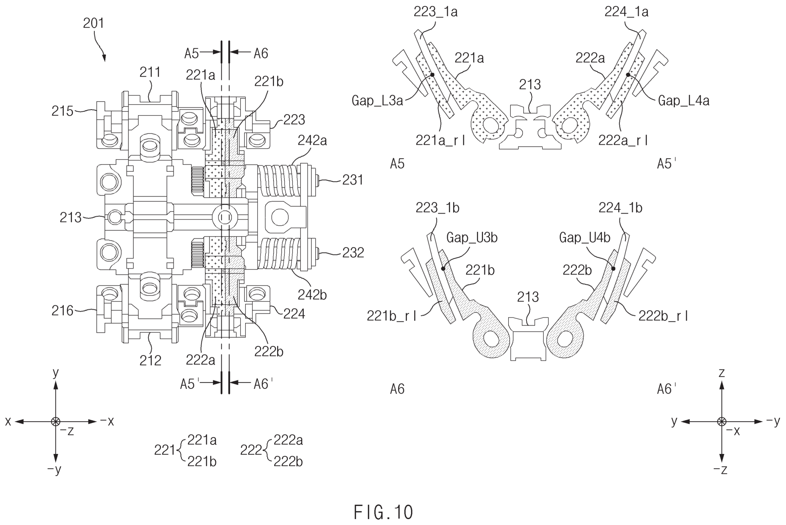

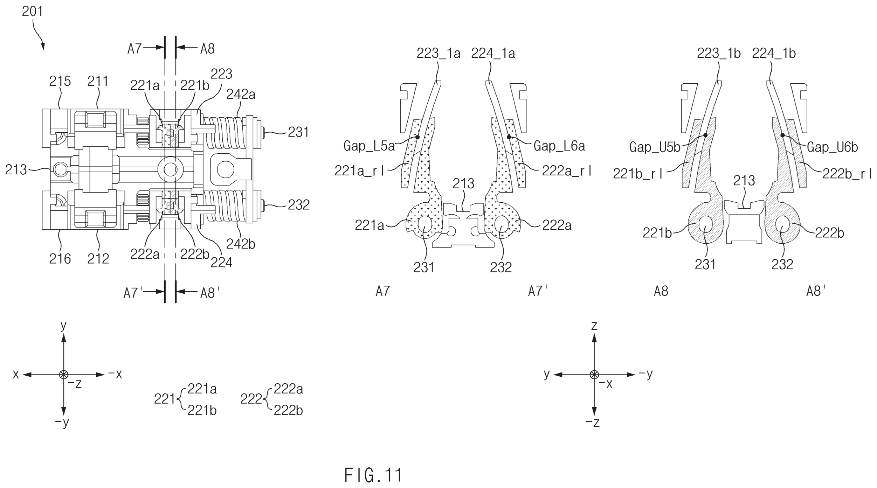

FIG. 9 is a diagram illustrating an example of a disposition state of arm members and link members in a hinge structure in an unfolded state according to various embodiments. FIG. 10 is a diagram illustrating an example of a disposition state of arm members and link members in a hinge structure defined at a specific angle according to various embodiments. FIG. 11 is a diagram illustrating an example of a disposition state of arm members and link members in a hinge structure in a folded state according to various embodiments.

Referring to at least a portion of FIGS. 1 to 8 and FIGS. 9, 10 and 11 (which may be referred to as FIGS. 9 to 11), the hinge structure 201 may include a fixing bracket 213, a first rotation member 211 and a second rotation member 212 that are coupled to the fixing bracket 213, a first link member 215, to which the first rotation member 211 is coupled, a second link member 216, to which the second rotation member 212 is coupled, a third link member 223 that is connected to (or integrally formed with) the first link member 215, a fourth link member 224 that is connected to (or integrally formed with) the second link member 216, a first arm member 221 that is coupled to the third link member 223, a second arm member 222 that is coupled to the fourth link member 224, a first shaft 231 that is fastened to the first arm member 221, a second shaft 232 that is fastened to the second arm member 222, a cam member 241 that is mounted on the first shaft 231 and the second shaft 232, a first elastic body 242a that is disposed between the first shaft 231 and the cam member 241, and a second elastic body 242b that is disposed between the second shaft 232 and the cam member 241, and the first arm member 221 may include a first upper arm 221a and a first lower arm 221b, and the second arm member 222 may include a second upper arm 222a and a second lower arm 222b. The first arm member 221 and the second arm member 222 may be rotated in different directions within a pre-designed specific angle while contacting the twisting surface described above in FIGS. 3 to 8. Additionally, the hinge structure 201 may further include the gear interlocking structure (e.g., the first main gear 233a, the second main gear 233b, the first interlocking gear 234a, and the second interlocking gear 233b of FIG. 3) described in FIG. 3.

According to an embodiment, as the first elastic body 242a and the second elastic body 242b press the cam member 241, the first upper arm 221a may be rotated by a specific angle from the y axis in the z-axis direction (or rotated counterclockwise with respect to a direction that faces the fixing bracket 213 from one point of the first shaft 231 or the second shaft 232), and the second upper arm 222a may be rotated by a specific angle from the -y axis in the z-axis direction (or rotated clockwise with respect to a direction that faces at the fixing bracket 213 from one point of the first shaft 231 or the second shaft 232).

Referring to a cut surface along cutting line A3-A3' of FIG. 9, when the hinge structure 201 is unfolded, the first link rail 223_1a of the third link member 223 may be held in (or fastened to, disposed in, or coupled to) the first upper arm rail 221a_rl (e.g., a rail groove shape) that is formed in the first upper arm 221a. As the first upper arm 221a is rotated (or rotated from the left side to the right side) clockwise with respect to a direction that faces the x axis from the -x axis, one side (e.g., among the side walls that form the rail groove, a lower side wall that is disposed in the -z-axis direction with respect to the unfolded state of the hinge structure 201) of the first upper arm rail 221a_rl may be in a contact state Gap_L1a with a lower side (e.g., one surface that faces the -z-axis direction when the hinge structure 201 is unfolded) of the first link rail 223_1a.

According to an embodiment, the third link rail 224_1a of the fourth link member 224 is held in (or fastened to, disposed in, or coupled to) to the second upper arm rail 222a_rl (e.g., a rail groove shape) formed on the second upper arm 222a. As the first upper arm 221a is rotated counterclockwise with respect to a direction that faces the x axis from the -x axis in the unfolded state of the hinge structure 201, one side (e.g., among the side walls that form the rail groove, a lower side wall that is disposed in the -z-axis direction with respect to the unfolded state of the hinge structure 201) of the second upper arm rail 222a_rl may be in a contact state Gap_L2a with a lower side (e.g., one surface that faces the -z-axis direction when the hinge structure 201 is unfolded) of the third link rail 224_1a.

Referring to a cut surface along cutting line A4-A4' of FIG. 9, when the hinge structure 201 is unfolded, the second link rail 223_1b of the third link member 223 may be held in (or fastened to, disposed in, or coupled to) the first lower arm rail 221b_rl (e.g., a rail groove shape) that is formed in the first lower arm 221b. As the first lower arm 221b is rotated counterclockwise with respect to a direction that faces the x axis from the -x axis, one side (e.g., among the side walls that form the rail groove, an upper side wall (or the first side wall) that is disposed in the z-axis direction with respect to the unfolded state of the hinge structure 201) of the first lower arm rail 221b_rl may be in a contact state Gap_U1b with an upper side (e.g., one upper surface that faces the z-axis direction when the hinge structure 201 is unfolded) of the first link rail 223_1a. According to various embodiments, an opposite side (e.g., among the side walls that form the rail groove, a lower side wall (or the second side wall) that is disposed in the -z-axis direction with respect to the unfolded state of the hinge structure 201) of the first lower arm rail 221b_rl may be in a non-contact state with one lower side (e.g., one surface that faces the -z-axis direction in the unfolded state of the hinge structure 201) of the first link rail 223_1a.

According to an embodiment, the fourth link rail 224_1b of the fourth link member 224 is held in (or fastened to, disposed in, or coupled to) to the second lower arm rail 222b_rl (e.g., a rail groove shape) formed on the second lower arm 222b. As the second lower arm 222b is rotated clockwise with respect to a direction that faces the -x axis from the x axis in the unfolded state of the hinge structure 201, one side (e.g., among the side walls that form the rail groove, an upper side wall that is disposed in the z-axis direction with respect to the unfolded state of the hinge structure 201) of the second lower arm rail 222b_rl may be in a contact state Gap_L2a with an upper side (e.g., one surface that faces the z-axis direction when the hinge structure 201 is unfolded) of the fourth link rail 224_1b. According to various embodiments, an opposite side (e.g., among the side walls that form the rail groove, a lower side wall that is disposed in the -z-axis direction with respect to the unfolded state of the hinge structure 201) of the second lower arm rail 222b_rl may be in a non-contact state with one lower side (e.g., one surface that faces the -z-axis direction in the unfolded state of the hinge structure 201) of the fourth link rail 224_1b.

According to an embodiment, the hinge structure 201 may define a specific angle (e.g., an angle that is smaller than 180 degrees (e.g., a horizontal state) and greater than 0 degrees) as the hinge operation is performed in the unfolded state. Referring to FIGS. 1 to 3, at least a portion of the display 160 of FIG. 2 may be disposed in an inner space, in which the hinge structure 201 is folded. Accordingly, at least a portion of the folded (bent) portion of the display 160 of FIG. 2 may be disposed in a concave space that is defined by the arm members 221 and 222 with respect to FIG. 10.

According to an embodiment, referring to a cutting surface along cutting line A5-A5' of FIG. 10, as the first upper arm 221a remains rotated clockwise with respect to a direction that faces the -x axis from the x axis even though the hinge structure 201 defines specific holding angle (e.g., a widened angle is between 180 degrees and 0 degrees, such as 45 degrees, 110 degrees, or 130 degrees), one side (e.g., among the upper side walls and the lower side walls that define a rail groove, the lower side wall that is located relatively distant from the display (e.g., the display 160 of FIG. 2) of the first upper arm rail 221a_rl may be in a contact state Gap_L3a with a lower side (e.g., for example, among an upper surface (or the first surface) and a lower surface (or the second surface) of the first link rail 223_1a, a lower surface that is disposed relatively distant from the display (e.g., the display 160 of FIG. 2) of the first link rail 223_1a. Similarly, as the second upper arm 222a remains rotated counterclockwise with respect to a direction that faces the x axis from the -x axis, one side (e.g., among the upper and lower side walls that define the rail groove, a lower side wall that is disposed relatively distant from the display (e.g., the display 160 of FIG. 2)) of the second upper arm rail 222a_rl may be in a contact state Gap_L4a with a lower side (e.g., among the upper surface and lower surface of the fourth link rail 224_1b, a lower surface that is distant from the display (e.g., the display 160 of FIG. 2)) of the fourth link rain 224_1b.

According to various embodiments, even though the hinge structure 201 defines a specific holding angle (e.g., a specific angle between 180 degrees and 0 degrees), one side (e.g., among the side walls that define a rail groove, an upper side wall that is disposed relatively close to the display (e.g., the display 160 of FIG. 2)) of the first upper arm rail 221a_rl may be in a non-contact state with one upper side (e.g., for example, among the upper surface and the lower surface of the first link rail 223_1a, an upper surface that is disposed relatively close to the display (e.g., the display 160 of FIG. 2)) of the first link rail 223_1a. Similarly, as the second upper arm 222a remains rotated counterclockwise with respect to a direction that faces the -x axis from the x axis, one side (e.g., among the upper and lower side walls that define the rail groove, an upper side wall that is disposed relatively close to the display (e.g., the display 160 of FIG. 2)) of the second upper arm rail 222a_rl may be in a non-contact state with an upper side (e.g., among the upper surface and lower surface of the fourth link rail 224_1b, an upper surface that is close to the display (e.g., the display 160 of FIG. 2)) of the fourth link rain 224_1b.

Referring to a cutting surface along cutting line A6-A6' of FIG. 10, as the first upper arm 221a remains rotated counterclockwise with respect to a direction that faces the -x axis from the x axis even though the hinge structure 201 defines specific holding angle (e.g., a widened angle is between 180 degrees and 0 degrees), one side (e.g., among the upper side walls and the lower side walls that define a rail groove, the upper side wall that is disposed relatively close to the display (e.g., the display 160 of FIG. 2)) of the first upper arm rail 221a_rl may be in a contact state Gap _U3b with an upper side (e.g., for example, among an upper surface and a lower surface of the first link rail 223_1a, an upper surface that is disposed relatively close to the display (e.g., the display 160 of FIG. 2)) of the first link rail 223_1a. Similarly, as the second upper arm 222a remains rotated clockwise with respect to a direction that faces the -x axis from the x axis, one side (e.g., among the upper and lower side walls that define a rail groove, an upper side wall that is disposed relatively close to the display (e.g., the display 160 of FIG. 2)) of the second upper arm rail 222a_rl may be in a contact state Gap_U4b with an upper side (e.g., among the upper surface and lower surface of the fourth link rail 224_1b, an upper surface that is close to the display (e.g., the display 160 of FIG. 2)) of the fourth link rain 224_1b.

According to various embodiments, even though the hinge structure 201 defines a specific holding angle (e.g., a widened angle is a specific angle between 180 degrees and 0 degrees), one side (e.g., among the side walls that define a rail groove, a lower side wall that is disposed relatively distant from the display (e.g., the display 160 of FIG. 2)) of the first upper arm rail 221a_rl may be in a non-contact state with one side (e.g., for example, among the upper surface and the lower surface of the second link rail 223_1b, a lower surface that is disposed relatively distant from the display (e.g., the display 160 of FIG. 2)) of the second link rail 223_1b. Similarly, as the second upper arm 222a remains rotated clockwise with respect to a direction that faces the -x axis from the x axis, one side (e.g., among the upper and lower side walls that define the rail groove, a lower side wall that is disposed relatively distant from the display (e.g., the display 160 of FIG. 2)) of the second upper arm rail 222a_rl may be in a non-contact state with one side (e.g., among the upper surface and lower surface of the fourth link rail 224_1b, a lower surface that is distant from the display (e.g., the display 160 of FIG. 2)) of the fourth link rain 224_1b.

According to an embodiment, the hinge structure 201 may be in a folded state due to an external pressure. In response to this, at least a portion of the display (e.g., the display 160 of FIG. 2) may be disposed in a folded state between the first arm member 221 and the second arm member 222. In this state, referring to a cut surface along cutting line A7-A7' of FIG. 11, the first upper arm 221a may be pressed to be rotated clockwise and the first lower arm 221b may be pressed to be rotated counterclockwise with respect to a direction that faces the -x axis from the x axis, based on the elastic force of the first elastic body (e.g., the first elastic body 242a of FIG. 3) and the twisting contact state of the first upper arm 221a and the first lower arm 221b. In response to this, one side (e.g., among the side walls that defines a rail groove, a lower side wall (or the second side wall) that is disposed relatively distant from the display (e.g., the display 160 of FIG. 2)) of the first upper arm rail 221a_rl may be in a contact state Gap_L5a with one side (e.g., for example, one supper surface of the first link rail 223_1a. and one lower surface of that is disposed relatively distant from the display (e.g., the display 160 in FIG. 2)) of the first link rail 223_1a. Similarly, as the second upper arm 222a is pressed to be rotated counterclockwise with respect to a direction that faces the -x axis from the x axis, one side (e.g., among the upper side wall (or the first side wall) or the lower side wall (or the second side wall that is located opposite to the first side wall) that form the rail groove, a lower side wall (or the second side wall) that is disposed relatively distant from the display (e.g., the display 160 of FIG. 2)) of the second upper arm rail 222a_rl may be in a contact state Gap_L6a with a lower side (e.g., among the upper one side (or the first side) and the lower side (or the second side that is opposite to the first side) of the fourth link rail 224_1b, one lower surface disposed distant from the display (e.g., the display 160 in FIG. 2)) of the fourth link rail 224_1b.

Referring to a cutting surface along cutting line A8-A8' of FIG. 11, the first lower arm 221b may be pressed to be rotated clockwise with respect to a direction that faces the -x axis from the x axis, based on the elastic force of the first elastic body (e.g., the first elastic body 242a of FIG. 3) and the twisting contact state of the first upper arm 221a and the first lower arm 221b. Accordingly, one side (e.g., among the side walls (e.g., an upper side wall (or the first side wall) and a lower side wall (or the second side wall) that is spaced apart from the upper side wall at a specific distance) that define a rail groove, the upper side wall that is disposed relatively close to the display (e.g., the display 160 of FIG. 2)) of the first lower arm rail 221b_rl may be in a contact state Gap_U5b with one side (e.g., for example, one upper surface of the second link rail 223_1b and an upper surface that is disposed relatively close to the display (e.g., the display 160 of FIG. 2) than a lower surface of the second link rail 223_1b) of the second link rail 223_1b. Similarly, even though the hinge structure 201 is in the folded state, the second upper arm 222a may be pressed to be rotated clockwise and the second lower arm 222b may be pressed to be rotated counterclockwise, based on the elastic force of the second elastic body (e.g., the second elastic body 242b of FIG. 3) and the twisting contact state of the second upper arm 222a and the second lower arm 222b.

Similarly, as the second lower arm 222b is pressed to be rotated counterclockwise with respect to a direction that faces the -x axis from the x axis, one side (e.g., among the upper and lower side walls that define a rail groove, an upper side wall that is disposed relatively close to the display (e.g., the display 160 of FIG. 2)) of the second lower arm rail 222b_rl may be in a contact state Gap_U6b with one side (e.g., among the upper surface and lower surface of the fourth link rail 224_1b, an upper surface that is close to the display (e.g., the display 160 of FIG. 2)) of the fourth link rain 224_1b. Even though the hinge structure 201 is in the folded state, as the first lower arm 221b and the second lower arm 222b are pressed to be rotated clockwise and counterclockwise, respectively (e.g., pressed by an external elastic force and a twisting surface contact) with respect to a direction that faces the -x axis from the x axis, the lower side walls that define the rail groove disposed distant from the display 160 of FIG. 2 and the lower surfaces of the link rails 223_1b and 224_1b may be in a non-contact state.

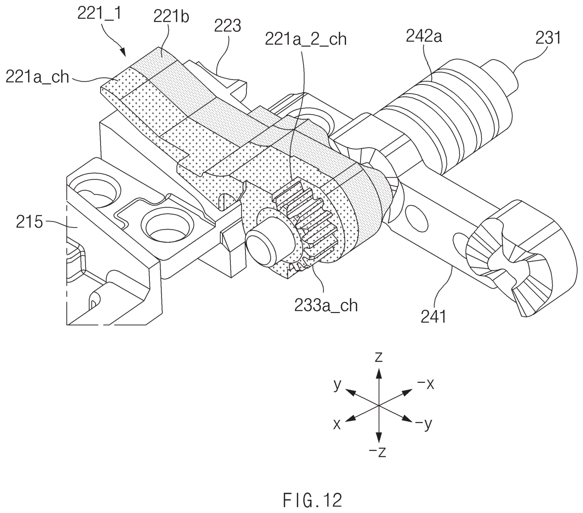

FIG. 12 is a perspective view illustrating an example of an arm member according to various embodiments.

Referring to FIGS. 1 to 12, the hinge structure 201_1 according to an embodiment may include at least a first link member 215, a third link member 223, and a first modified arm member 221_1 (e.g., a first modified upper arm 221a_ch and a first lower arm 221b), a cam member 241, a first elastic member 242a, and a first shaft 231. The hinge structure 201_1 may further include at least some components of the hinge structure 201 described above in FIG. 3.

According to an embodiment, the first link member 215, the third link member 223, the first modified upper arm 221a_ch, the first lower arm 221b, the cam member 241, and the first elastic member 242a, and the first shaft 231 may have at least one of the same shape, size, and position as those of the corresponding components described above in FIG. 3. Accordingly, the configurations of the first link member 215, the third link member 223, the first modified upper arm 221a_ch, the first lower arm 221b, the cam member 241, and the first elastic member 242a, and the first shaft 231 may be replaced with the description of at least some configurations of the hinge structure 201 described in FIG. 3.

The first modified upper arm 221a_ch, for example, may include a modified upper arm header 221a_2_ch. The inner surface e.g., a surface that faces the first lower arm 221b) of the modified upper arm header 221a_2_ch may have a structure including the inclined surfaces (e.g., 221a_2s1 and 221a_2s2) and the steps (e.g., 221a_2p1 and 221a_2p2) described above in FIGS. 4A, 4B and 4C. A main gear pattern 233a_ch may be disposed on an outer surface of the first modified upper arm 221a_ch, differently from the above description in FIG. 4C. The main gear pattern 233a_ch may be partially formed at a portion of an outer surface of the first modified upper arm 221a_ch. The main gear pattern 233a_ch may be equally applied to the second upper arm 222a of the second arm member 222 of FIG. 3. For example, the outer surface of the second upper arm 222a may include a structure, in which at least a portion of the main gear pattern is formed. The main gear pattern 233a_ch may be gear-coupled to the first interlocking gear 234a of the hinge structure 201 described in FIG. 3, and the main gear pattern 233a_ch formed in the second upper arm 222a can be gear-coupled to the second interlocking gear 234b.

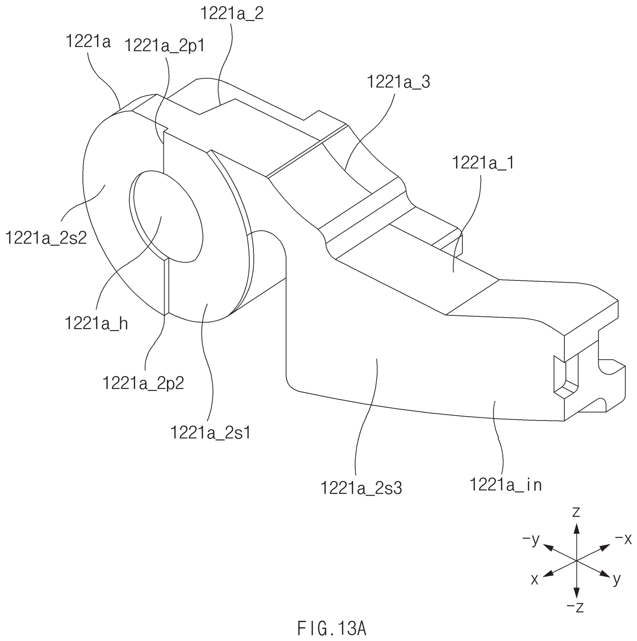

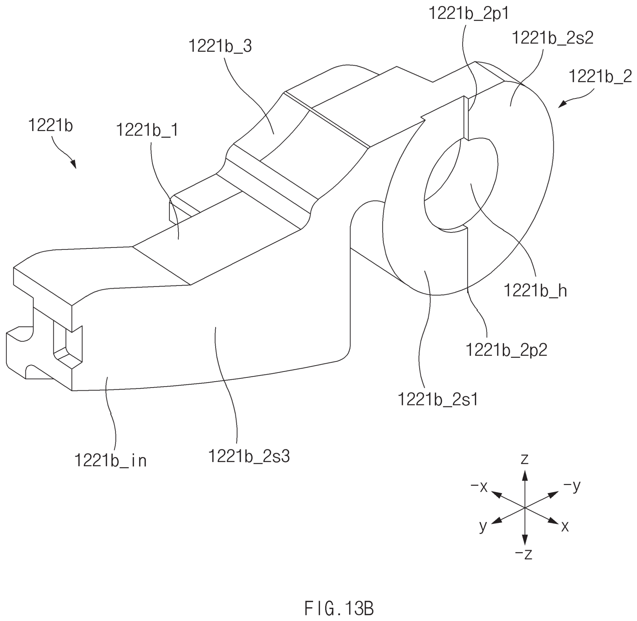

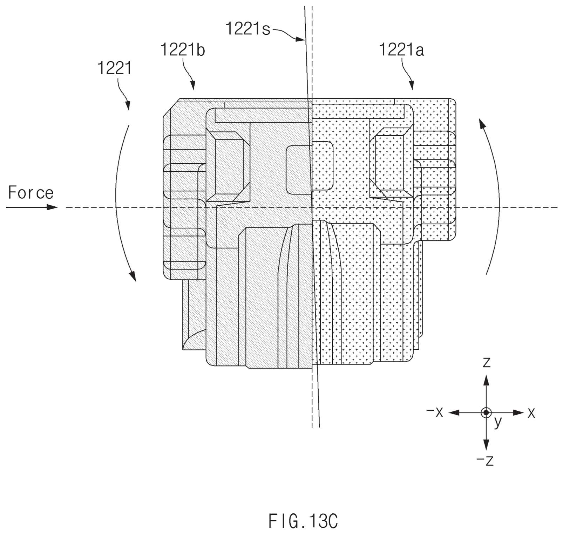

FIG. 13A is a perspective view illustrating an example of an upper arm according to various embodiments. FIG. 13B is a perspective view illustrating an example of a lower arm according to various embodiments. FIG. 13C is a diagram illustrating an example of a coupling form of an upper arm and a lower arm according to various embodiments.

Referring to FIGS. 1 to 13C, the hinge structure 201 may include an arm member 1221 having an upper arm 1221a and a lower arm 1221b. The upper arm 1221a and the lower arm 1221b may be applied to at least one of the upper arms or the lower arms of the arm members described above in FIGS. 1 to 12.

The upper arm 1221a may include an upper arm body 1221a_1, an upper arm header 1221a_2, and an upper arm connecting part 1221a_3. The inner surface (e.g., a surface that is disposed to face the lower arm 1221b) of the upper arm header 1221a_2 may include a first inclined surface 1221a_2s1, a second inclined surface 1221a_2s2, a first step 1221a_2p1, a second step 1221a_2p2, and an upper hole 1221a_h. The first inclined surface 1221a_2s1, the second inclined surface 1221a_2s2, the first step 1221a_2p1, the second step 1221a_2p2, and the upper hole 1221a_h may have a form corresponding to the first inclined surface 221a_2s1, the second inclined surface 221a_2s2, the first upper step 221a_2p1, the second upper step 221a_2p2, and the first upper hole 221a_h described above in FIGS. 4A to 4C.

The inner surface 1221a_in of the upper arm body 1221a_1 may include an inclined surface 1221a_2s3 that is formed flat and has a constant inclination from the -z axis in the z-axis direction. An x-axis thickness of the inclined surface 1221a_2s3 of the upper arm body 1221a_1 may be formed differently depending on a position thereof. For example, an x-axis thickness of an upper end portion of the inclined surface 1221a_2s3 of the upper arm body 1221a_1, which faces a z-axis direction, may be formed to be greater than an x-axis thickness of a lower end portion that faces the -z-axis direction. In response to the shape of the lower arm body 1221b_1, thicknesses of the inclined surface 1221a_2s3 of the upper arm body 1221a_1 for positions thereof may be formed differently.

The upper arm connecting part 1221a_3 may be disposed to connect the upper arm header 1221a_2 and the upper arm body 1221a_1. At least a portion of the inner surface (e.g., a surface that is disposed to face the lower arm 1221b) of the upper arm connecting part 1221a_3 may be formed to be flat. According to various embodiments, the upper arm connecting part 1221a_3 may be formed to have a specific magnitude of slope from the z axis in the -z-axis direction. For example, the upper arm connecting part 1221a_3 may be formed to have the same magnitude of slope as that of the inclined surface of the upper arm body 1221a_1. In response to this, a thickness of an upper end of the upper arm connecting part 1221a_3 may be formed differently from a thickness of a lower end thereof. According to an embodiment, the inclined surface 1221a_2s3 of the upper arm body 1221a_1 may have a specific magnitude of slope from the upper end toward the lower end, the upper end (a portion that is close to the display 160 of FIG. 2 or a portion of the upper arm body 1221a_1, of which the shortest distance from the display 160 is smaller than the other portions or a minimum distance) may protrude in the -x-axis direction (considering the hinge structure 201 in FIG. 3, toward the elastic body 242a or 242b), and the lower end (a portion that is distant from the display 160 of FIG. 2 or a portion of the upper arm body 1221a_1, of which the shortest distance from the display 160 is greater than the other portions or a maximum distance) may have a shape that is recessed in the x-axis direction (considering the hinge structure 201 of FIG. 3, toward the main gear 233a or 233b).

The lower arm 1221b may include a lower arm body 1221b_1, a lower arm header 1221b_2, and a lower arm connecting part 1221b_3. The inner surface (e.g., a surface disposed to face the upper arm 1221a) of the lower arm header 1221b_2 may include a third inclined surface 1221b_2s1, a fourth inclined surface 1221b_2s2, a third step 1221b_2p1, and a fourth steps 1221b_2p2, and a lower hole 1221b_h. The third inclined surface 1221b_2s1, the fourth inclined surface 1221b_2s2, the third step 1221b_2pl, the fourth step 1221b_2p2, and the lower hole 1221b_h may have a form corresponding to the third inclined surface 221b_2s1, the fourth inclined surface 221b_2s2, the first lower step 221b_2p1, the second lower step 221b_2p2, and the first lower hole 221b_h described in FIGS. 5A to 5C. An outer surface (e.g., one surface that is opposite to an inner surface) of the lower arm header 1221b_2 may include a shape having the cam structure described in FIGS. 5A to 5C.

The inner surface 1221b_in of the lower arm body 1221b_1 may be formed flat, and may include an inclined surface 1221b_2s3 having a constant inclination from the -z axis in the z-axis direction. An x-axis thickness of the inclined surface 1221b_2s3 of the lower arm body 1221b_1 may be formed differently depending on a position thereof. For example, an x-axis thickness of an upper end portion of the inclined surface 1221b_2s3 of the lower arm body 1221b_1, which faces a z-axis direction, may be formed to be smaller than an x-axis thickness of a lower end portion that faces the -z-axis direction. In response to the shape of the lower arm body 1221b_1, thicknesses of the lower arm body 1221b_1 for positions thereof may be formed differently. According to an embodiment, the inclined surface 1221b_2s3 of the lower arm body 1221b_1 may have a specific magnitude of slope from the upper end toward the lower end, and may have a magnitude of slope (or a slope direction) that is opposite to the magnitude of slope (or the slope direction) of the inclined surface 1221a_2s3 of the upper arm body 1221a_1. According to an embodiment, the upper end (a portion that is close to the display 160 of FIG. 2 or a portion of the upper arm body 1221a_1, of which the shortest distance from the display 160 is smaller than the other portions or a minimum distance) of the inclined surface 1221b_2s3 of the lower arm body 1221b_1 may be recessed in the -x-axis direction (considering the hinge structure 201 in FIG. 3, toward the elastic body 242a or 242b), and the lower end (a portion that is distant from the display 160 of FIG. 2 or a portion of the upper arm body 1221a_1, of which the shortest distance from the display 160 is greater than the other portions or a maximum distance) may have a shape that protrudes in the x-axis direction (considering the hinge structure 201 of FIG. 3, toward the main gear 233a or 233b).

The lower arm connecting part 1221b_3 may be disposed to connect the lower arm header 1221b_2 and the lower arm body 1221b_1. At least a portion of the inner surface (e.g., a surface that is disposed to face the upper arm 1221b) of the lower arm connecting part 1221b_3 may be formed to be flat. According to various embodiments, the upper arm connecting part 1221b_3 may be formed to have a specific magnitude of slope from the z axis in the -z-axis direction. For example, the lower arm connecting part 1221b_3 may have an inclined surface in an opposite direction to the slope direction of the upper arm connecting part 1221a_3. The inclined surface of the lower arm connecting part 1221b_3 may be formed to have the same magnitude of slope as that of the inclined surface 1221b_2s3 of the lower arm body 1221b_1. As an example, a thickness of the upper end of the lower arm connecting part 1221b_3 may be formed differently from a thickness of the lower end thereof.

As described above, the upper arm 1221a has an inner surface having a first magnitude of slope, and the lower arm 1221b has an inner surface having a second magnitude of slope in the opposite direction to the first magnitude of slope (or a slope direction of the first magnitude of slope), and thus, the arm member 1221 may include a twisting surface 1221s (or a twisting contact surface, or a twisting axis) as illustrated in FIG. 13C when the upper arm 1221a and lower arm 1221b come into contact. The twisting surface 1221s represents a portion of the inner surface of the upper arm 1221a and the inner surface of the lower arm 1221b that contact each other, and may correspond to a portion of the twisting surface. When the elastic body (e.g., 242a or 242b) of the hinge structure 201 described in FIG. 3 provides an elastic force to the lower arm 1221b and the upper arm 1221a, the lower arm 1221b may be rotated clockwise and the upper arm 1221a may be rotated counterclockwise with respect to a direction that faces the x axis from the -x axis. When the upper arm 1221a and the lower arm 1221b are applied to opposite arm members (e.g., the second arm member 222 of the hinge structure 201 in FIG. 3), the rotation direction may be reversed.

The arm member 1221 described in FIGS. 13A to 13C may define an inclined surface not only in the upper arm header 1221a_2 and the lower arm header 1221b_2, but also in the upper arm body 1221a_1 and the lower arm body 1221b_1, and thus, may reinforce (or strengthen) the twisting rotation force of the upper arm 1221a and the lower arm 1221b and guide the alternate rotation of the upper arm 1221a and lower arm 1221b more stably.

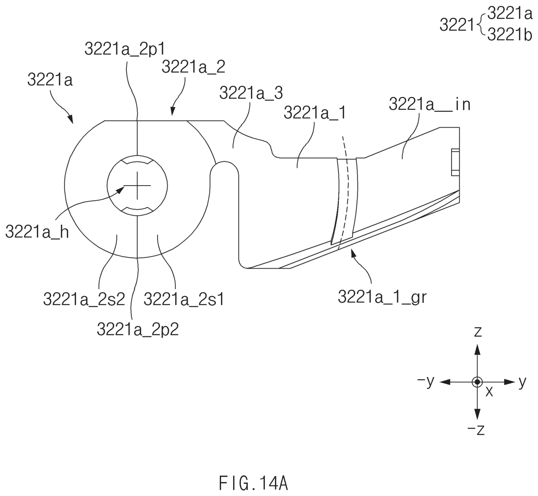

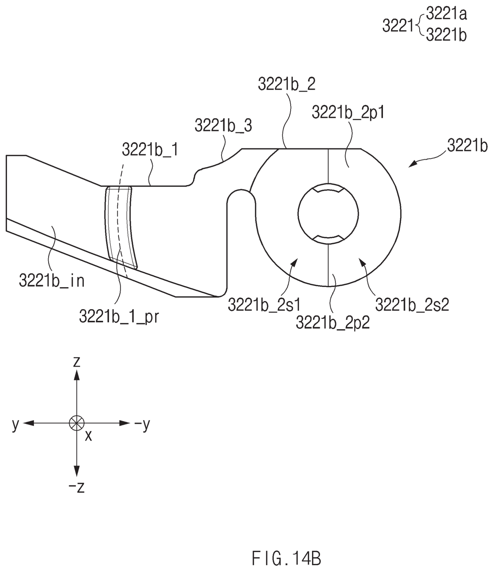

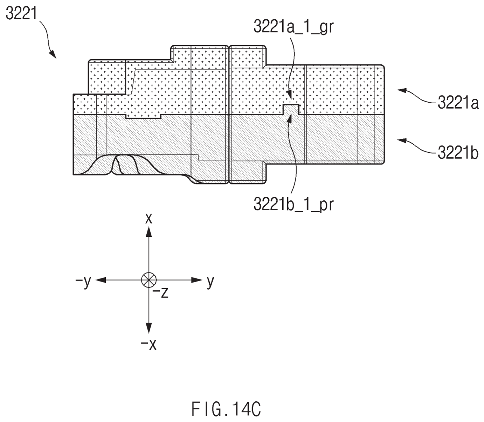

FIG. 14A is a diagram illustrating an example of a modified upper arm according to various embodiments. FIG. 14B is a diagram illustrating an example of a modified lower arm according to various embodiments. FIG. 14C is a diagram illustrating an example of a coupling form of a modified upper arm and a lower arm according to various embodiments.

Referring to FIGS. 1 to 14C, the hinge structure (e.g., the hinge structure 201 of FIG. 3) may include at least one arm member 3221, and the arm member 3221 may include a modified upper arm 3221a and a modified lower arm 3221b. For example, the arm member 3221 may be applied to at least one of the first arm member 221 and the second arm member 222 of the hinge structure 201 of FIG. 3.

The modified upper arm 3221a may include a modified upper arm body 3221a_1, an upper arm header 3221a_2, and an upper arm connecting part 3221a_3. The inner surface (e.g., a surface that is disposed to face the modified lower arm 3221b) of the upper arm header 3221a_2 may include a first inclined surface 3221a_2s1, a second inclined surface 3221a_2s2, a first step 3221a_2p1, and a second step 3221a_2p2. The first inclined surface 3221a_2s1, the second inclined surface 3221a_2s2, the first step 3221a_2p1, and the second step 3221a_2p2 may have a form corresponding to the first inclined surface 221a_2s1, the second inclined surface 221a_2s2, the first upper step 221a_2p1, and the second upper step 221a_2p2 described above in FIGS. 4A to 4C. The upper arm header 3221a_2 may include an upper hole 3221a_h, and the upper hole 3221a_h may correspond to the first upper hole 221a_h of the first upper arm header 221a_2 described above in FIGS. 4A to 4C.

The inner surface 3221a_in of the modified upper arm body 3221a_1 may be formed to be flat. A guide groove 3221a_1_gr may be formed on one side of the modified upper arm body 3221a_1. The guide groove 3221a_1_gr may have a certain width in the y-axis direction, may be formed to connect the z-axis and -z-axis, and may be formed to be engraved on the inner surface 3221a_in. At least a portion of the guide groove 3221a_1_gr may be provided in an arc shape. A y-axis width of the guide groove 3221a_1_gr may be formed to be constant. At least one of the size, shape, and position of the guide groove 3221a_1_gr may be changed in response to at least one of the size, shape, and position of the guide boss formed in the modified lower arm 3221b. The guide groove 3221a_1_gr may be used to guide at least one of the modified upper arm 3221a or the modified lower arm 3221b so that it is rotated upward and downward (in the z-axis direction) along a specific imaginary line while not being moved leftward and rightward, while the modified upper arm 3221a and the modified lower arm 3221b are twisted and rotated with respect to each other at a specific angle. The remaining parts of the modified upper arm body 3221a_1, except for a portion, at which the guide groove 3221a_1_gr of the modified upper arm body 3221a_1 is formed, may be the same as or similar to at least one of the shape and size of the first upper arm body 221a_1 of the first upper arm 221a described above in FIGS. 4A to 4C within a specific error range.

The upper arm connecting part 3221a_3 may be disposed to connect the upper arm header 3221a_2 and the modified upper arm body 1221b_1. The upper arm connecting part 3221a_3 may be formed equally or similar to at least one of the shape and size of the first upper arm header 3221a_2 of the first upper arm 221a described above in FIGS. 4A to 4C within a specific error range.

The modified lower arm 3221b may include a modified lower arm body 3221b_1, a lower arm header 3221b_2, and a lower arm connecting part 3221b_3. The inner surface (e.g., a surface disposed to face the modified upper arm 3221a) of the lower arm header 3221b_2 may include a third inclined surface 3221b_2s1, a fourth inclined surface 3221b_2s2, a third step 3221b_2p1, and a fourth step 3221b_2p2. The third inclined surface 3221b_2s1, the fourth inclined surface 3221b_2s2, the third step 3221b_2p1, and the fourth step 3221b_2p2 may have a form corresponding to the third inclined surface 221b_2s1, the fourth inclined surface 221b_2s2, the first lower step 221b_2p1, and the second lower step 221b_2p2 described in FIGS. 5A to 5C. An outer surface (e.g., one surface that is opposite to an inner surface) of the lower arm header 3221b_2 may include a shape having the cam structure described in FIGS. 5A to 5C.

The inner surface 3221b_in of the modified lower arm body 3221b_1 may be formed to be flat. A guide boss 3221b_1_pr may be formed on one side of the inner surface 3221b_in of the modified lower arm body 3221b_1. At least a portion of the guide boss 3221b_1_pr may protrude to have a band shape, and at least a portion thereof may include a curved surface. A y-axis width of the guide boss 3221b_1_pr may be formed to be constant. At least one of the size, shape, and position of the guide boss 3221b_1_pr may be changed in response to at least one of the size, shape, and position of the guide groove 3221a_1_gr formed in the modified upper arm 3221a. The guide boss 3221a_1_gr may be used to guide at least one of the modified upper arm 3221a or the modified lower arm 3221b so that it is rotated upward and downward (in the z-axis direction) along a specific imaginary line while not being moved leftward and rightward, while the modified upper arm 3221a and the modified lower arm 3221b are twisted and rotated with respect to each other at a specific angle. The remaining portions of the modified lower arm body 3221b_1, except for the guide boss 3221b_1_pr of the above modified lower arm body 3221b_1 may be the same as or similar to at least one of the shapes and sizes of the first lower arm body 221b_1 of the first lower arm 221b described above in FIGS. 5A to 5C within a specific error range.

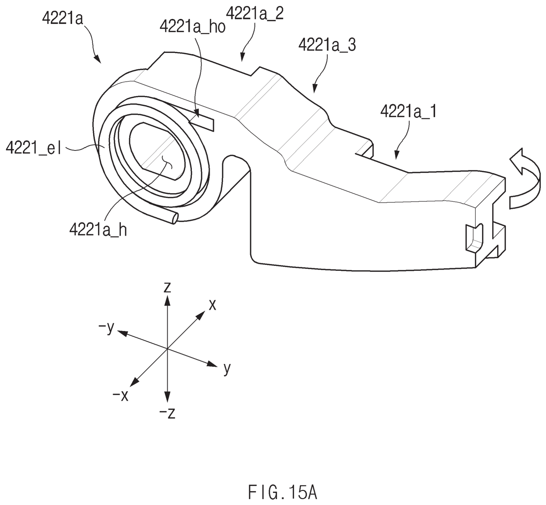

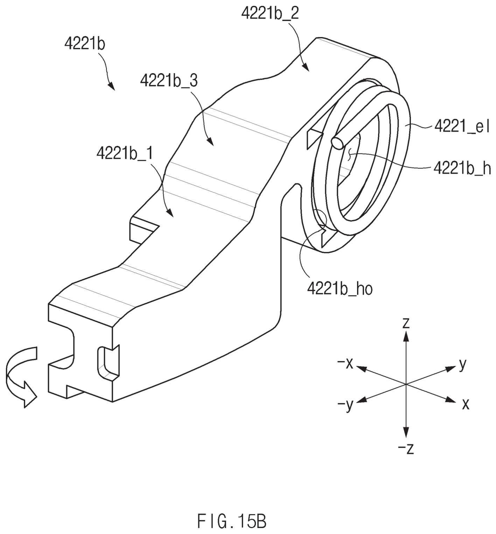

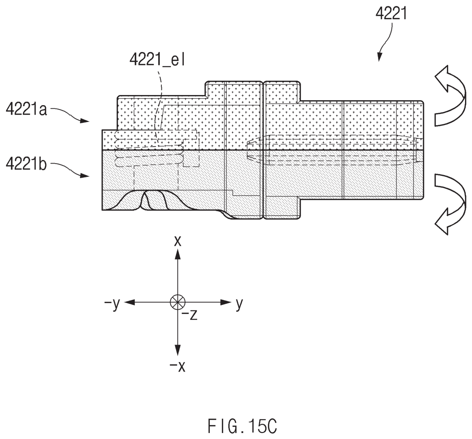

FIG. 15A is a perspective view illustrating an example of an upper arm according to various embodiments. FIG. 15B is a perspective view illustrating an example of a lower arm according to various embodiments. FIG. 15C is a diagram illustrating an example of a coupling form of an upper arm and a lower arm according to various embodiments.

Referring to FIGS. 15A, 15B and 15C, the hinge structure (the hinge structure 201 of FIG. 3) may include at least one arm member 4221, and at least one arm member 4221 may include an upper arm 4221a (or a first sub-arm) and a lower arm 4221b (a second sub-arm). One surface of the upper arm 4221a may be disposed to face one surface of the lower arm 4221b, and at least a portion of one surface (e.g., an inner surface) of the upper arm 4221a may be disposed to contact one surface (e.g., an inner surface) of the lower arm 4221b in a process of assembling the hinge structure (e.g., the hinge structure 201 of FIG. 3). The arm member 4221 may be additionally applied to at least one of the arm members included in the hinge structure described above in FIGS. 1 to 14.

According to an embodiment, the upper arm 4221a may include an upper arm body 4221a_1, a modified upper arm header 4221a_2, and an upper arm connecting part 4221a_3. The upper arm body 4221a_1 may have a shape corresponding to that of the first upper arm body 221a_1 described above in FIGS. 4A to 4C. The upper arm connecting part 4221a_3 may correspond to the first upper arm connecting part 221a_3 described above in FIGS. 4A to 4C. Accordingly, the description of the configuration of the upper arm body 4221a_1 and the upper arm connecting part 4221a_3 may be replaced with the contents described above. The shapes of the upper arm body 4221a_1 and the upper arm connecting part 4221a_3 may employ not only the structure described in FIGS. 4A to 4C but also at least one of the forms of the upper arm body and the upper arm connecting part described in FIGS. 7 to 14C.

The modified upper arm header 4221a_2 may have an upper hole 4221a_h on an inner surface, into which a shaft (e.g., the shaft 231 or 232 in FIG. 3) may be inserted, and an upper insertion groove 4221a_ho, in which an elastic member 422 1_el may be disposed, may be formed in a peripheral portion that defines the upper hole 4221a_h. A z-axis cross section of the upper insertion groove 4221a_ho may include a band-shaped empty space. A size of the upper insertion groove 4221a_ho may include a size, by which the elastic member 4221_el may be inserted. A depth of the upper insertion groove 4221a_ho may be similar to a length of a portion of a width of the elastic member 4221_el. The upper insertion groove 4221a_ho may have a shape and size corresponding to those of the elastic member 4221_el. The elastic member 4221_el may include a twisting spring (or a torsion spring). The elastic member 4221_el may include a body part that is wound several times or more to provide a rotational force through twisting thereof, and opposite end parts of the body, which have a specific angle to be widened. Among the opposite end parts of the elastic member 4221_el, a first part may exert a rotational force clockwise, and the second part may exert a rotational force counterclockwise.

According to an embodiment, it may further include an extension space, into which an upper end portion (or the first part that defines one end of the spring-type elastic member 4221_el and is located at an upper end of the elastic member 4221_el in the z-axis direction when being inserted into the upper insertion groove 4221a _ho) of the one end (e.g., the elastic member 4221_el in the shape of a skein of thread) of the elastic member 4221_el may be inserted, with respect to a direction from the -x axis toward the x axis so that the modified upper arm 4221a may be rotated clockwise. The upper end first part of the elastic member 4221_el may exert an elastic force so that, after the elastic member 4221_el is inserted into the modified lower arm header 4221b_2, the modified upper arm header 4221a_2 is rotated counterclockwise with respect to the direction from the -x axis to the x axis.

According to an embodiment, the lower arm 4221b may include a lower arm body 4221b_1, a modified lower arm header 4221b_2, and a lower arm connecting part 4221b_3. The lower arm body 4221b_1 may have a shape corresponding to that of the first lower arm body 221b_1 described above in FIGS. 5A to 5C. The lower arm connecting part 4221b_3 may correspond to the first lower arm connecting part 221b_3 described above in FIGS. 5A to 5C. Accordingly, the description of the configurations of the lower arm body 4221b_1 and the lower arm connecting part 4221b_3 may be replaced with the contents described above. The shapes of the lower arm body 4221b_1 and the lower arm connecting part 4221b_3 may employ not only the structure described in FIGS. 5A to 5C but also at least one of the forms of the lower arm body and the lower arm connecting part described in FIGS. 7 to 14C.

The modified lower arm header 4221b_2 may have a lower hole 4221b_h, into which the shaft (e.g., the shaft 231 or 232 of FIG. 3, or the same shaft as the shaft that is inserted into the modified upper arm header 4221a_2) may be inserted, on the inner surface thereof, and a lower insertion groove 4221b_ho, in which the elastic member 4221_el may be disposed, may be formed at a peripheral portion that defines the lower hole 4221b_h. The lower hole 4221b_h may be aligned with the upper hole 4221a_h when the lower arm 4221b and the upper arm 4221a are coupled to each other so that the inner space of the lower hole 4221b_hb may be connected to the inner space of the upper hole 4221a_h.

The lower insertion groove 4221b_ho may be the same as or similar to (e.g., similar within a specific error range) in at least one of the shape, size, and position of the upper insertion groove 4221a_ho. For example, a z-axis cross-section of the lower insertion groove 4221b_ho may include a band-shaped empty space, and a size of the lower insertion groove 4221b_ho may include a size and a shape, into which a portion of the elastic member 4221_el may be inserted. A depth of the lower insertion groove 4221b_ho may be similar to a length of a portion of a width of the elastic member 4221_el. As an example, the elastic member 4221_el may be formed of a twisting spring (or a torsion spring), and the lower arm 4221b may be rotated clockwise with respect to a direction from the x axis to the -x axis in response to the elastic member 4221_el being inserted into and disposed in the lower insertion groove 4221b_ho and the upper insertion groove 4221a_ho. As an example, the second part (e.g., the second part at the lower end of the elastic member 4221_el, which is disposed in a position that is symmetrical to the first part of the elastic member 4221_el with respect to a specific imaginary line) corresponding to an opposite end of the torsion spring type elastic member 4221_el may be disposed in an extension space separately provided in the lower insertion recess 4221b_ho. The second part of the lower end of the elastic member 4221_el may exert an elastic force so that, after the elastic member 4221_el is inserted into the modified lower arm header 4221b_2, the modified lower arm header 4221b_2 is rotated clockwise with respect to the direction from the -x axis to the x axis.

The hinge structure including the arm member 4221 having the above-described structure may press the upper arm 4221a such that the upper arm 4221a is rotated counterclockwise using the elastic member 4221_el of a torsion spring type and press the lower arm 4221b such that the lower arm 4221b is rotated clockwise, while a separate inclined surface or step is not formed on the inner surfaces of the upper arm 4221a and lower arm 4221b. In response to this, the upper arm 4221a and the lower arm 4221b may be rotated in different directions to maintain a contact state with the third link member (e.g., the link member 223 of FIG. 3), into which the arm member 4221 is inserted whereby a movement between the arm member 4221 and the link member 223 may be improved.

According to various embodiments, at least some of the different types of arm members illustrated in FIGS. 12 to 15C may be partially or entirely applied to the hinge structures of FIGS. 2 and 3 described above. As an example, the deformed form of the inner wall of the hole described in FIG. 7, the sub-arm structure with gears illustrated in FIG. 12, the arm member with an expanded inclined surface illustrated in FIGS. 13A to 13C, the arm member with a guide structure disposed on the inner surface illustrated in FIGS. 14A to 14C, and the arm member including the elastic member illustrated in FIGS. 15A to 15C may be selectively applied to the hinge structure (e.g., the hinge structure 201 of FIG. 3) respectively or at least partially. Accordingly, in various embodiments, a hinge structure, in which all the structures described in FIGS. 7 and 12 to 15C are applied to the hinge structure illustrated in FIGS. 3 to 6B, may be considered. In various embodiments, a hinge structure, in which at least some of the modified or expanded structures illustrated in FIGS. 7 and 12 to 15C are added to the hinge structure illustrated in FIGS. 3 to 6B, may be considered. In various embodiments, the arm member 4221 illustrated in FIGS. 15A to 15C may be applied to the hinge structure by replacing the arm members (e.g., 221, 1221, and 3221) illustrated in FIGS. 3 to 14. In various embodiments, the elastic member 4221_el corresponding to the torsion spring described above in FIGS. 15A to 15B may be additionally applied to the arm member described above in FIGS. 3 to 14.

The above-described structure of the arm member including two separate sub-arms may not be applied to all the arm members included in the hinge structure, but may be partially applied. For example, the structure of the arm member divided into sub-arms may be applied to only one of the first arm member 221 and the second arm member 222 included in the hinge structure 201 of FIG. 3. The arm member structure including the sub-arms may be applied to all arm members included in the hinge structure.

The portable electronic device according to an example embodiment, may include: a flexible display, a first housing and a second housing configured to accommodate the flexible display, and a hinge structure including a hinge coupled to the housings, the hinge structure may include a first rotation member comprising a bracket and a second rotation member comprising a bracket that are fastened to the first housing and the second housing, a first arm and a second arm that are fastened to the first housing and the second housing, and a first elastic body and a second elastic body configured to press the first arm and the second arm, respectively, and the first arm may include a first upper arm disposed between the first rotation member and the first elastic body and has an inclined surface on one side, and a first lower arm disposed between the first upper arm and the first rotation member, is disposed to face the first upper arm, and has an inclined surface formed thereon.

According to an example embodiment, the portable electronic device may further include a first link disposed in the first housing and coupled to the first rotation member, a second link disposed in the second housing and coupled to the second rotation member, a third link disposed in the first housing and coupled to the first arm, and a fourth link disposed in the second housing and coupled to the second arm.

According to an example embodiment, in response to the pressing by the first elastic body, the first upper arm may be rotated in a first direction by a specific angle, and the first lower arm may be rotated in a second direction different from the first direction by a specific angle.

According to an example embodiment, the first upper arm may be configured to be rotated counterclockwise by a specific angle, and the first lower arm may be configured to be rotated clockwise by a specific angle with respect to a third direction that faces the first rotation member from the first elastic body, in response to the pressing by the first elastic body.

According to an example embodiment, in response to the rotation of the first upper arm, one side of the lower end of the first upper arm rail disposed in the first upper arm, may maintain a contact state with one side of the lower end of the first link rail disposed on the third link.

According to an example embodiment, in response to the rotation of the first upper arm, one side of the upper end of the first upper arm rail may be maintained in a non-contact state with one side of the upper end of the first link rail.

According to an example embodiment, in response to the rotation of the first lower arm, one side of the upper end of the first lower arm rail disposed in the first lower arm, may maintain a contact state with one side of the upper end of the second link rail disposed on the third link.

According to an example embodiment, in response to the rotation of the first lower arm, one side of the lower end of the first lower arm rail may be maintained in a non-contact state with one side of the upper end of the first link rail.

According to an example embodiment, the second arm may include a second upper arm disposed between the second rotation member and the second elastic body and has an inclined surface on one side, and a second lower arm disposed between the second upper arm and the second rotation member, faces the second upper arm, and has an inclined surface.

According to an example embodiment, in response to the pressing by the second elastic body, the second upper arm may be rotated in a second direction by a specific angle, and the second lower arm may be rotated in a first direction by a specific angle.

According to an example embodiment, the second upper arm may be rotated clockwise by a specific angle, and the second lower arm may be rotated counterclockwise by a specific angle with respect to the third direction that faces the second rotation member from the second elastic body, in response to the pressing by the second elastic body.

According to an example embodiment, in response to the rotation of the second upper arm, one side of the lower end of the second upper arm rail disposed in the second upper arm, may maintain a contact state with one side of the lower end of the third link rail disposed on the fourth link.

According to an example embodiment, in response to the rotation of the second upper arm, one side of the upper end of the second upper arm rail may be maintained in a non-contact state with one side of the upper end of the third link rail.

According to an example embodiment, in response to the rotation of the second lower arm, one side of the upper end of the second lower arm rail disposed in the second lower arm may be maintained in a contact state with one side of the upper end of the fourth link rail disposed on the fourth link, and in response to the rotation of the second lower arm, one side of the lower end of the second lower arm rail may be maintained in a non-contact state with one side of the lower end of the fourth link rail.

According to an example embodiment, the first upper arm may include a first upper arm body having a first upper arm rail fastened to the first link rail formed in the third link, a first upper arm header having a hole formed at a central portion thereof, and a first upper arm connecting part configured to connect the first upper arm body and the first upper arm header, and the first upper arm header may include a first upper step protruding from the inner surface facing the first lower arm, a second upper step formed on the inner surface and disposed in a position spaced apart from the first upper step, a first inclined surface formed from the first upper step toward the second upper step, and a second inclined surface formed from the second upper step toward the first upper step direction.

According to an example embodiment, the first lower arm may include a first lower arm body having a first lower arm rail fastened to a second link rail formed in the third link, a first lower arm header having a hole formed at the central portion, and a first lower arm connecting part configured to connect the first lower arm body and the first lower arm header, and the first lower arm header may include a third upper step protruding from the inner surface facing the first upper arm, a fourth upper step formed on the inner surface and disposed in a position spaced apart from the third upper step, a third inclined surface formed from the third upper step toward the fourth upper step, and a fourth inclined surface formed from the fourth upper step toward the third upper step.

According to an example embodiment, the first inclined surface and the third inclined surface may be disposed to face each other, the slope direction of the first inclined surface and the slope direction of the third inclined surface may be opposite to each other, the second inclined surface and the fourth inclined surface may be disposed to face each other, and the slope direction of the second inclined surface and the slope direction of the fourth inclined surface may be formed to be opposite to each other.

According to an example embodiment, the first upper arm body may have an inclined surface inclined by a specific angle with respect to a direction facing the display from an outside, the first lower arm body may have an inclined surface, and the slope direction of the inclined surface of the first upper arm body may be opposite to the slope direction of the inclined surface of the first lower arm body.

According to an example embodiment, the portable electronic device may further include a guide groove formed in the first upper arm body, and a guide boss formed in the first lower arm body and inserted into the guide groove.

According to an example embodiment, the portable electronic device may include an upper insertion groove formed on one side of the first upper arm header, a lower insertion groove formed on one side of the first lower arm header, and an elastic member comprising an elastic body inserted into the upper insertion groove and the lower insertion groove and configured to rotate the first upper arm in a first direction and the second upper arm in a second direction.

According to an example embodiment, the first link and the third link may be integrally formed, and the second link and the fourth link may be integrally formed.

According an example embodiment of the disclosure, the hinge structure may include: a first rotation member comprising a bracket and a second rotation member comprising a bracket coupled to the housings of the portable electronic device, and a first arm and a second arm, and may include a first elastic body and a second elastic body configured to press the first arm and the second arm, respectively, the first arm may include a first upper arm disposed between the first rotation member and the first elastic body and having an inclined surface on one side, and a first lower arm disposed between the first upper arm and the first rotation member, faces the first upper arm, and having an inclined surface formed thereon, the first upper arm may be rotated clockwise by the pressing by the first elastic body and the second inclined surface in contact with the first inclined surface so that at least a portion of the first upper arm is disposed in a contact state with a rail formed on one side of the third link, and the first lower arm may be rotated counterclockwise by the pressing by the first elastic body and the first inclined surface in contact with the second inclined surface so that at least a portion of the second upper arm may be disposed in a contact state with a rail formed on one side of the fourth link.

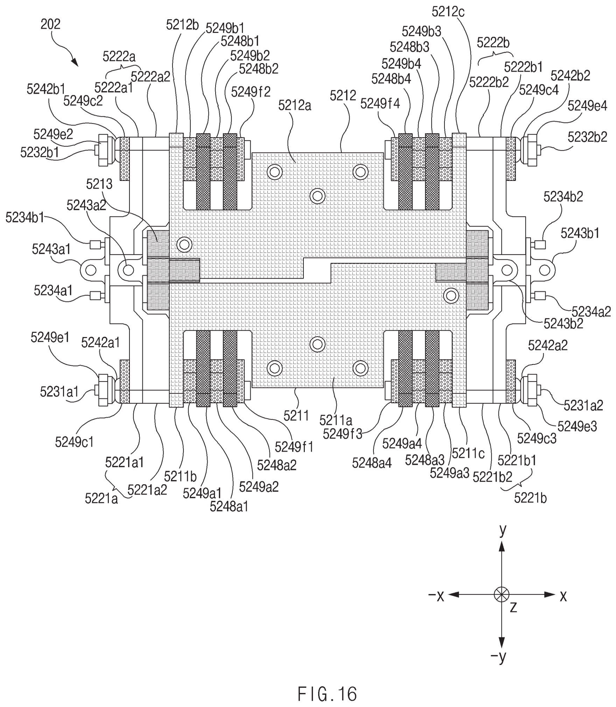

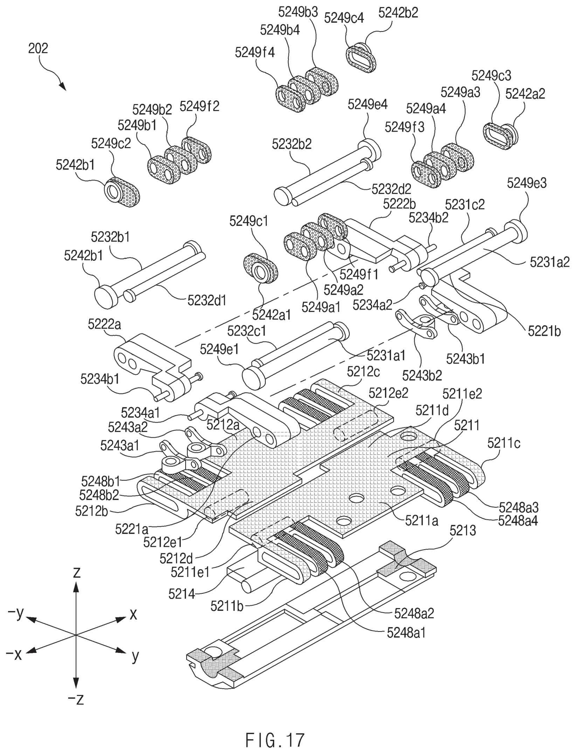

FIG. 16 is a diagram illustrating an example of a hinge structure according to various embodiments. FIG. 17 is an exploded perspective view of a hinge structure according to various embodiments.

Referring to FIGS. 16 and 17, a hinge structure 202 (or a gear assembly) may include a fixing bracket 5213, a slide structure 5214, a first rotation member 5211 (or a first rotation bracket), a second rotation member 5212 (or a second rotation bracket), a first arm member 5221a, a second arm member 5222a, a third arm member 5221b, a fourth arm member 5222b, a first support member 5248a1 and a second support member 5248a2, a third support member 5248a3 and a fourth support member 5248a4, a fifth support member 5284b1 and a sixth support member 5284b2, and a seventh support member 5284a1 and an eighth support member 5284b4, a first shaft 5231a1 and a first auxiliary shaft 5231c1, a second shaft 5231b1 and a second auxiliary shaft 5231d1, a third shaft 5231a2 and a third auxiliary shaft 5231c2, and a fourth shaft 5231b2 and a fourth auxiliary shaft 5231d2, a first arm shaft 5234a1, a second arm shaft 5234b1, a third arm shaft 5234a2, a fourth arm shaft 5234b2, and a first arm shaft fixing part 5243a1, a second arm shaft fixing part 5243a2, a third arm shaft fixing part 5243b1, and a fourth arm shaft fixing part 5243b2.

The fixing bracket 5213 may include an upper surface (e.g., a surface that faces the z-axis direction), on which the slide structure 5214 may be seated, and a lower surface (e.g., a surface that faces the -z-axis direction) that faces the hinge housing (e.g., the hinge housing 150 in FIG. 2). A first rotation rail 5211d of the first rotation member 5211 and a second rotation rail 5212d of the second rotation member 5212 may be disposed on an upper surface of the fixing bracket 5213.

The slide structure 5214 may include a lower surface (e.g., a surface that faces the -z-axis direction) that faces an upper surface of the fixing bracket 5213 that is slid in the -x-axis or x-axis direction, and an upper surface (or a side part) that is fastened to the first rotation rail 5211d of the first rotation member 5211 and the second rotation rail 5212d of the second rotation member 5212. For example, the slide structure 5214 may be linearly moved in the first direction while the first rotation member 5211 and the second rotation member 5212 are folded, and may be linearly moved in the second direction while the first rotation member 5211 and the second rotation member 5212 are unfolded. In this regard, an upper surface or a side part of the slide structure 5214 may include diagonal rail grooves (e.g., a first rail groove coupled to the first rotating rail 5211d and a second rail groove coupled to the second rotating rail 5212d) that are coupled to the first rotation rail 5211d and the second rotation rail 5212d formed in a diagonal direction.

The first rotation member 5211 may be disposed to be positioned on one side of the fixing bracket 5213 while at least a portion thereof is coupled to one side of the slide structure 5214. An upper surface of the first rotation member 5211 may be formed to be flat. This first rotation member 5211 may include a first rotation body 5211a, a first rotation side portion 5211b and a first arm shaft coupling portion 5211e1 that are disposed in the -x-axis direction of the first rotation body 5211a, a second rotation side portion 5211c and a second arm shaft coupling portion 5211e2 that are disposed in the x-axis direction of the first rotation body 5211a, and a first rotation rail 5211d that is formed in a rearward direction of the first rotation member 5211. At least one through-hole that passes in the upward/downward direction (e.g., from the -z axis to the z axis) may be formed on one side of the first rotation body 5211a, and at least one through-hole that is formed in the first rotation body 5211a may be used to fasten the first rotation member 5211 to the housing (e.g., the first housing 110 of FIG. 2). A first rotation side portion 5211b may be disposed to define a specific empty space with the first rotation bodies 5211a. The first rotation side portion 5211b may have a through-hole, of which a y-axis direction is greater than a length in the x-axis direction. An upper surface of the first rotation side portion 5211b may be formed to be flat with the first rotation body 5211a, and may be disposed to protrude in the -z-axis direction. A first arm shaft coupling portion 5211e1 formed in the -x-axis or x-axis direction may be disposed on one side of the first rotation side portion 5211b. The first arm shaft coupling portion 5211e1 may be disposed on a lower surface of the first rotation body 5211a. A portion of the first arm shaft 5234a1 may be inserted into the first arm shaft coupling portion 5211e1. A second rotation side portion 5211c may be disposed in a position that is symmetrical to the first rotation side portion 5211b with respect to a center of the first rotation body 5211a. The second rotation side portion 5211c may be formed to be spaced apart from the first rotation body 5211a at a specific distance. The shape and arrangement of the second rotation side portion 5211c may be similar to those of the first rotation side portion 5211b. A second arm shaft coupling portion 5211e1 formed in the -x-axis or x-axis direction may be disposed on one side of the second rotation side portion 5211c. The second arm shaft coupling portion 5211e2 may be disposed on a lower surface of the first rotation body 5211a. A portion of the third arm shaft 5234a2 may be inserted into the second arm shaft coupling portion 5211e2. The first rotation rail 5211d may be disposed on one periphery (e.g., a position of a y-axis periphery, which is biased toward an x-axis periphery) of the first rotation body 5211a, and may be formed diagonally on a lower surface of the first rotation body 5211a, and at least a portion thereof may have a curved rail structure.

According to an embodiment, a first support member 5248a1 and a second support member 5248a2 may be disposed between the first rotation side portion 5211b and the first rotation body 5211a. The first support member 5248a1 and the second support member 5248a2 may have the same shape and size as some of the shapes and sizes of the first rotation side portion 5211b. For example, the first support member 5248a1 and the second support member 5248a2 may have a length in the y-axis direction that is greater than the lengths in the x-axis and z-axis directions, and may have a hole that passes from the -x axis in the x-axis direction, and the through-hole may have a shape that is long in the y-axis direction. The first support member 5248a1 may be disposed to be spaced apart from the first rotation side portion 5211b in the -x-axis direction at a specific interval, and may be disposed to be spaced apart from the second support member 5248a2 in the x-axis direction. The second support member 5248a2 may be disposed to be spaced apart from the first support member 5248a1 in the -x-axis direction by a specific interval, and may be disposed to be spaced apart from the first rotation body 5211a in the x-axis direction. A first friction member 5249a1 may be disposed between the first rotation side portion 5211b and the first support member 5248a1, a second friction member 5249a2 may be disposed between the first support member 5248a1 and the second support member 5248a2. A first fixing ring 5249f1, of which a cross-section in the z-axis direction has the same or similar shape as that of the first friction member 5249a1 or the second friction member 5249a2, and which fixes the first shaft 5231a1 and the first auxiliary shaft 5231c1 may be disposed between the second support member 5248a2 and the first rotation body 5211a.

According to an embodiment, a third support member 5248a3 and a fourth support member 5248a4 may be disposed between the second rotation side portion 5211c and the first rotation body 5211a. The third support member 5248a3 may be disposed to be spaced apart from the second rotation side portion 5211c in the x-axis direction at a specific interval, and may be disposed to be spaced apart from the fourth support member 5248a4 in the -x-axis direction. The fourth support member 5248a4 may be disposed to be spaced apart from the third support member 5248a3 in the x-axis direction by a specific interval, and may be disposed to be spaced apart from the first rotation body 5211a in the -x-axis direction. The third support member 5248a3 and the fourth support member 5248a4 may have the same shape and size as some of the shapes and sizes of the second rotation side portion 5211c. The third support member 5248a3 and the fourth support member 5248a4 may be formed similarly or identically to the first support member 5248a1 and the fourth support member 5248a4 described above. A third friction member 5249a3 may be disposed between the second rotation side portion 5211c and the third support member 5248a3, and a fourth friction member 5249a4 may be disposed between the third support member 5248a3 and the fourth support member 5248a4. A second shaft fixing ring 5249f3, of which a cross-section in the z-axis direction has the same or similar shape as that of the third friction member 5249a3 or the fourth friction member 5249a4, and which fixes the third shaft 5231a3 and the third auxiliary shaft 5231c2 may be disposed between the third support member 5248a3 and the first rotation body 5211a.

The second rotation member 5212 may be disposed to be positioned on an opposite side of the fixing bracket 5213 while at least a portion thereof is coupled to an opposite side of the slide structure 5214. This second rotation member 5212 may have the same or similar structure, shape, and size as those of the first rotation member 5211 described above. As an example, with respect to a horizontal center line (e.g., a center line that crosses the -x axis and the x axis) of the fixing bracket 5213, the second rotation member 5212 may be disposed in a position that is symmetrical to that of the first rotation member 5211. As an example, the second rotation member 5212 may include a second rotation body 5212a, a third rotation side portion 5212b and a third arm shaft coupling portion 5212e1 that are disposed in the -x-axis direction of the second rotation body 5212a, and a fourth rotation side portion 5212c and a fourth arm shaft coupling portion 5212e2 that are disposed in the x-axis direction of the second rotation body 5212a, and a second rotation rail 5212d that is formed on in a rearward direction of the second rotation member 5212. A shape of the second rotation body 5212a may be similar to or the same as the shape of the first rotation body 5211a. The third rotation side portion 5212b may be disposed in a position that is symmetrical to that of the first rotation side portion 5211b with respect to a transverse center line of the fixing bracket 5213, and may have a structure of a size and a shape that are similar to those the first rotation side portion 5211b within a specific error range. A third arm shaft coupling portion 5212e1 formed in the -x-axis or x-axis direction may be disposed on one side of the third rotation side portion 5212b. The third arm shaft coupling portion 5212e1 may be disposed on a lower surface of the second rotation body 5212a. A portion of the second arm shaft 5234b1 may be inserted into the third arm shaft coupling portion 5212e1. The fourth rotation side portion 5212c may be disposed in a position that is symmetrical to that of the second rotation side portion 5211c with respect to a transverse center line of the fixing bracket 5213, and may have a structure of a size and a shape that are similar to those the second rotation side portion 5211c within a specific error range. A fourth arm shaft coupling portion 5212e2 formed in the -x-axis or x-axis direction may be disposed on one side of the fourth rotation side portion 5212c. The fourth arm shaft coupling portion 5212e2 may be disposed on a lower surface of the second rotation body 5212a. A portion of the fourth arm shaft 5234b2 may be inserted into the fourth arm shaft coupling portion 5212e2. The second rotation rail 5211d may be disposed on one periphery (e.g., a position of a y-axis periphery, which is biased toward an -x-axis periphery) of the second rotation body 5212a, and may be formed diagonally on a lower surface of the second rotation body 5212a, and at least a portion thereof may have a curved rail structure. The second rotation member 5212 may be rotated clockwise while the first rotation member 5211 is rotated counterclockwise, and may be rotated counterclockwise while the first rotation member 5211 is rotated clockwise.

According to an embodiment, a fifth support member 5284b1 and a sixth support member 5284b2 may be disposed between the third rotation side portion 5212b and the second rotation body 5212a. The fifth support member 5284b1 and the sixth support member 5284b2 may have the same shape and size as some of the shapes and sizes of the third rotation side portion 5212b. The fifth support member 5284b1 and the sixth support member 5284b2 may have a shape that is the same as or similar to that of the first support member 5248a1, the second support member 5248a2, the third support member 5248a3, or the fourth support member5248a4 described above. The fifth support member 5284b1 may be disposed to be spaced apart from the third rotation side portion 5212b in the -x-axis direction at a specific interval, and may be disposed to be spaced apart from the sixth support member 5284b2 in the x-axis direction. A fifth friction member 5249b1 may be disposed between the third rotation side portion 5212b and the fifth support member 5284b1, and a sixth friction member 5249b2 may be disposed between the fifth support member 5284b1 and the sixth support member 5284b2. A third shaft fixing ring 5249f2, of which a cross-section in the z-axis direction has the same or similar shape as that of the fifth friction member 5249b1 or the sixth friction member 5249b2, and which fixes the second shaft 5231b1 and the second auxiliary shaft 5231d1 may be disposed between the sixth support member 5284b2 and the second rotation body 5212a.

According to an embodiment, a seventh support member 5284b3 and an eighth support member 5284b4 may be disposed between the fourth rotation side portion 5212c and the second rotation body 5212a. The seventh support member 5284b3 may be disposed to be spaced apart from the fourth rotation side portion 5212c in the x-axis direction at a specific interval, and may be disposed to be spaced apart from the eighth support member 5284b4 in the -x-axis direction at specific interval. The eighth support member 5284b4 may be disposed to be spaced apart from the seventh support member 5284b3 in the x-axis direction by a specific interval, and may be disposed to be spaced apart from the second rotation body 5212a in the -x-axis direction at a specific interval. The seventh support member 5284b3 and the eighth support member 5284b4 may have the same shape and size as some of the shapes and sizes of the fourth rotation side portion 5212c. The seventh support member 5284b3 and the eighth support member 5284b4 may be formed similarly or identically to the first to sixth support members described above. A seventh friction member 5249b3 may be disposed between the fourth rotation side portion 5212c and the seventh support member 5284b3, and an eighth friction member 5249b3 may be disposed between the seventh support member 5284b3 and the eighth support member 5284b4. A fourth shaft fixing ring 5249f4, of which a cross-section in the z-axis direction has the same or similar shape as the cross-section of the seventh friction member 5249b3 or the eighth friction member 5249b4 in the z-axis direction, is located between the eighth support member 5284b4 and the second rotation body 5212a, and fixes the fourth shaft 5231b2 and the fourth auxiliary shaft 5231d2 may be disposed.

The first arm member 5221a may be disposed adjacent to the first rotation side portion 5211b of the first rotation member 5211 when the hinge structure 202 is unfolded. The first arm member 5221a may include a first sub-arm member 5221a1 and a second sub-arm member 5221a2. A portion of the second sub-arm member 5221a2 may be disposed between the first sub-arm member 5221a1 and the first rotation side portion 5211b. The first sub-arm member 5221a1 may be disposed between the second sub-arm member 5221a2 and the first support ring 5249c1. Through-holes, into which the first shaft 5231a1 and the first auxiliary shaft 5231c1 may be inserted, and a through-hole, into which the first arm shaft 5234a1 may be inserted, may be disposed in the first arm member 5221a. A first fixing member 5249e1 that fixes the first shaft 5231a1 may be disposed at one end (e.g., a -x-axis periphery) of the first shaft 5231a1, and a first shaft elastic member 5241a1 (or a first elastic member) may be disposed between the first fixing member 5249e1 and the first support ring 5249c1. A portion (e.g., a portion, at which the through-hole, into which the first arm shaft 5234a1 is inserted, is formed) of the first arm member 5221a may be disposed between the first arm shaft fixing part 5243a1 and the second arm shaft fixing part 5243a2.

The second arm member 5222a may be disposed adjacent to the third rotation side portion 5212b of the second rotation member 5212 when the hinge structure 202 is unfolded. The second arm member 5222a may include a third sub-arm member 5222a1 and a fourth sub-arm member 5222a2. A portion of the fourth sub-arm member 5222a2 may be disposed between the third sub-arm member 5222a1 and the second rotation side portion 5211c. The third sub-arm member 5222a1 may be disposed between the fourth sub-arm member 5222a2 and the second support ring 5249c2. Through-holes, into which the second shaft 5231b1 and the second auxiliary shaft 5231d1 may be inserted, and a through-hole, into which the second arm shaft 5234b1 may be inserted, may be disposed in the second arm member 5222a. A second fixing member 5249e2 that fixes the second shaft 5231b1 may be disposed at one end (e.g., a -x-axis periphery) of the second shaft 5231b1, and a second shaft elastic member 5242b1 (or a second elastic member) may be disposed between the second fixing member 5249e2 and the second support ring 5249c2. A portion (e.g., a portion, at which the through-hole, into which the second arm shaft 5234b1 is inserted, is formed) of the second arm member 5222a may be disposed between the first arm shaft fixing part 5243a1 and the second arm shaft fixing part 5243a2. In response to this, a portion of the second arm member 5222a may be disposed adjacent to a portion of the first arm member 5221a.

The third arm member 5221b may be disposed adjacent to the second rotation side portion 5211c of the first rotation member 5211 when the hinge structure 202 is unfolded. The third arm member 5221b may include a fifth sub-arm member 5221b1 and a sixth sub-arm member 5221b2. A portion of the sixth sub-arm member 5221b2 may be disposed between the fifth sub-arm member 5221b1 and the second rotation side portion 5211c. The fifth sub-arm member 5221b1 may be disposed between the sixth sub-arm member 5221b2 and the third support ring 5249c3. Through-holes, into which the third shaft 5231a2 and the third auxiliary shaft 5231c2 may be inserted, and a through-hole, into which the third arm shaft 5234a2 may be inserted, may be disposed in the third arm member 5221b. A third fixing member 5249e3 that fixes the third shaft 5231a2 may be disposed at one end (e.g., an x-axis periphery) of the third shaft 5231a2, and a third shaft elastic member 5242a2 (or a third elastic member) may be disposed between the third fixing member 5249e3 and the third support ring 5249c3. A portion (e.g., a portion, at which the through-hole, into which the third arm shaft 5234a2 is inserted, is formed) of the third arm member 5221b may be disposed between the third arm shaft fixing part 5243b1 and the fourth arm shaft fixing part 5243b2.

The fourth arm member 5222b may be disposed adjacent to the fourth rotation side portion 5212c of the second rotation member 5212 when the hinge structure 202 is unfolded. The fourth arm member 5222b may include a seventh sub-arm member 5222b1 and an eighth sub-arm member 5222b2. A portion of the eighth sub-arm member 5222b2 may be disposed between the seventh sub-arm member 5222b1 and the fourth rotation side portion 5212c. The seventh sub-arm member 5222b1 may be disposed between the eighth sub-arm member 5222b2 and the fourth support ring 5249c4. Through-holes, into which the fourth shaft 5231b2 and the fourth auxiliary shaft 5231d2 may be inserted, and a through-hole, into which the fourth arm shaft 5234b2 may be inserted, may be disposed in the fourth arm member 5222b. A fourth fixing member 5249e4 that fixes the fourth shaft 5231b2 may be disposed at one end (e.g., an x-axis periphery) of the fourth shaft 5231a2, and a fourth shaft elastic member 5242b2 (or a fourth elastic member) may be disposed between the fourth fixing member 5249e4 and the fourth support ring 5249c4. A portion (e.g., a portion, at which the through-hole, into which the fourth arm shaft 5234b2 is inserted, is formed) of the fourth arm member 5222b may be disposed between the third arm shaft fixing part 5243b1 and the fourth arm shaft fixing part 5243b2. In response to this, a portion of the fourth arm member 5222b may be disposed adjacent to a portion of the third arm member 5221b. A fixing bracket 5213 may be disposed between the second arm shaft fixing part 5243a2 and the fourth arm shaft fixing part 5243b2.

The hinge structure 202 described above is intended to describe a structure including an arm member in contact with a twisting surface according to an embodiment of the disclosure, and at least some of the components of the hinge structure 202 described above may be omitted or added. For example, at least some of the support members and the friction members of the hinge structure 202 may be omitted or added. Furthermore, the number of the four shaft fixing parts of the hinge structure 202 may be decreased to two. As described above, the hinge structure 202 of the disclosure may have a structure that is directly coupled to the housings without a separate link member.

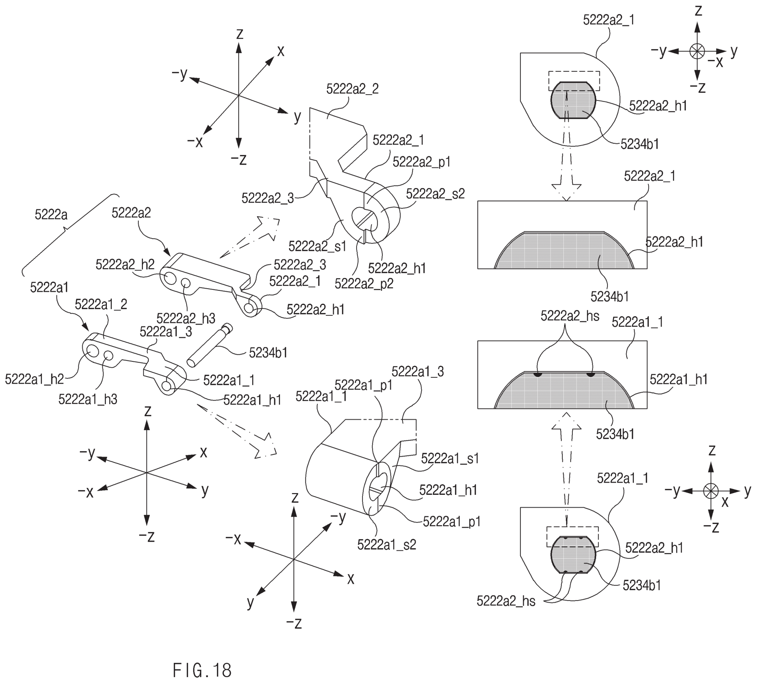

FIG. 18 is an exploded perspective view and diagram illustrating an arm member of a hinge structure according to various embodiments.

Referring to FIGS. 16, 17 and 18, the arm member including the twisting surface of the hinge structure 202 according to an embodiment will be explained with reference to the reference numerals of the second arm member 5222a, among the arm members 5221a, 5221b, 5222a, and 5222b described above in FIGS. 16 and 17. However, the disclosure is not limited thereto, and the shape of the second arm member 5222a described in FIG. 18 may be applied to at least one of the arm members 5221a, 5221b, 5222a, and 5222b described above in FIGS. 16 and 17.

As mentioned above, the second arm member 5222a may include a third sub-arm member 5222a1 and a fourth sub-arm member 5222a2 that are coupled to each other while facing each other in the x-axis direction, and a second arm shaft 5234b1.

The third sub-arm member 5222a1 (or an upper arm) may include a first arm connecting part 5222a1_3 (or an upper arm connecting part), a first arm header 5222a1_1 (or an upper arm header), and a first arm body 5222a1_2 (or an upper arm body).

The first arm connection portion 5222a1_3 may be disposed to connect the first arm header 5222a1_1 and the first arm body 5222a1_2. The first arm connection portion 5222a1_3 may be disposed to face or contact one side of the second arm header 5222a2_3 formed in the fourth sub arm member 5222a2 when the hinge structure 202 is unfolded.

The first arm header 5222a1_1 may be formed to extend in the y-axis direction with respect to the first arm connection portion 5222a1_3, and a first arm shaft hole 5222a1_h1 may be formed at a central portion thereof from the - x axis in the x-axis direction so that the second arm shaft 5234b1 may be inserted thereinto. Accordingly, at least a portion of a z-axis cross section of the first arm header 5222a1_1may have a ring shape. At least one hole boss 5222a2_hs that may increase an adhesion performance to the second arm shaft 5234b1 may be disposed at a periphery (or an inner wall of the first arm header 5222a1_1, on which the first arm shaft hole 5222a1_h1 is formed) of the first arm shaft hole 5222a1_h1. When the second arm shaft 5234b1 is inserted into the first arm shaft hole 5222a1_h1, the hole boss 5222a2_hs may contact an outer surface of the second arm shaft 5234b1 to prevent or restrict movement of the second arm shaft 5234b1, and may allow the second arm shaft 5234b1 to be adhered more firmly to an interior of the first arm shaft hole 5222a1_h1.

At least a portion of an upper surface of the first arm header 5222a1_1 in the z-axis direction may be formed to be flat. An inner surface (e.g., a surface that faces the fourth sub-arm member 5222a2) of the first arm header 5222a1_1, on which the first arm shaft hole 5222a1_h1 is formed, may have a circular (or elliptical or polygonal) band shape. The inner surface may include a twisting surface having a specific magnitude of slope from one point to another. As an example, an inner surface of the first arm header 5222a1_1 may include a first upper step 5221a1_p1 (or a first upper protrusion, or a first upper boss) that protrudes from the surrounding area, and a second upper step 5221a1_p2 (or a second upper protrusion, or a second upper boss). A side surface of the protruding portion of the first upper step 5221a1_p1 may be disposed to face the y-axis direction, and a side surface of the protruding portion of the second upper step 5221a1_p2 may be disposed to face the -y-axis direction. While the first upper step 5221a1_p1 and the second upper step 5221a1_p2 are disposed to face different directions, a first inclined surface 5221a1_p2 that extends clockwise (or a right-handed rotation direction) from the first upper step 5221a1_p1 to the second upper step 5221a_p2 with respect to a direction from the -x axis to the x axis, and a second inclined surface 5221a_s2 that extends counterclockwise direction (or a left-hand rotation direction) from the first upper step 5221a1_p1 to the second upper step 5221a_p2 may be formed. A part of the first inclined surface 5221a_s1, which is close to the first upper step 5221a1_p1, may be formed to protrude in the y-axis direction (formed higher than the surrounding area) by the first upper step 5221a1_p1, and a part of the first inclined surface 5221a_s1, which is closer to the second upper step 5221a1_p2, may be engraved in the -y-axis direction and be formed (formed lower than the surroundings), compared to the second upper step 5221a1_p2. A slope direction of the second inclined surface 5221a_s2 may be formed opposite to a slope direction of the first inclined surface 5221a1_s1. For example, a part of the second inclined surface 5221a_s2, which is close to the first upper step 5221a_p1, may be formed to be engraved in the -y-axis direction (formed lower than the surrounding area) compared to the first upper step 5221a_p1, and a part of the second inclined surface 5221a_s2, which is closer to the second upper step 5221a_p2, may protrude in the y-axis direction and be formed (formed higher than the surroundings), by the second upper step 5221a1_p2. A description of the inclined surface described above may be the same or similar to the description of the shape of the inclined surface described in the above-described drawing, for example, FIG. 4B.

The first arm body 5222a1_2 may include a structure that extends in the -y-axis direction from the first arm connection portion 5222a1_3. An upper surface of the first arm body 5222a1_2 in the z-axis direction may be formed to be flat. Furthermore, a surface that faces the -x-axis direction and a surface that faces the x-axis direction of the first arm body 5222a1_2 may be formed to be flat. The first arm body 5222a1_2 may have a structure, an area of which increases gradually or in a specific position as it goes from the y-axis direction in the -y-axis direction. The first arm body 5222a1_2 may include a first shaft insertion hole 5222a1_h2 and a first auxiliary shaft insertion hole 5222a1_h3 that is formed such that the second shaft 5231b1 and the second auxiliary shaft 5231d1 may be inserted thereinto from the -x axis in the x-axis direction.

The fourth sub-arm member 5222a2 (or a lower arm) may include a second arm connection part 5222a2_3 (or a lower arm connecting part), a second arm header 5222a2_3 (or a lower arm header), a second arm body 5222a2_2 (or a lower arm body).

The second arm connection part 5222a2_3 may be disposed to connect the second arm header 5222a2_3 and the second arm body 5222a2_2. The second arm connection portion 5222a2_3 may be disposed to face or contact one side of the first arm header 5222a2_2 formed in the third sub-arm member 5222a1 when the hinge structure 202 is unfolded. It is illustrated in the drawing that a width of the second arm connection part 5222a2_3 in the xy plane is narrower than a width of the first arm connection part 5222a1_3 in the xy plane, but the disclosure is not limited thereto, and a thickness or width thereof may be changed.

The second arm header 5222a2_3 may be formed to extend in the y-axis direction with respect to the second arm connection portion 5222a2_3 and be disposed parallel to the first arm header 5222a1_1. A second arm shaft hole 5222a2_h1 may be formed at a central portion of the second arm header 5222a2_3 from the -x axis in the x-axis direction so that the second arm shaft 5234b1 may be inserted thereinto. Accordingly, at least a portion of a z-axis cross section of the second arm header 5222a2_3 may have a ring shape. When the third sub-arm member 5222a1 and the fourth sub-arm member 5222a2 are coupled to the second arm shaft 5234b1, are pressed by an elastic member (e.g., the shaft elastic member), and are disposed adjacent to each other or disposed to at least partially contact each other, the second arm shaft hole 5222a2_h1 and the first arm shaft hole 5222a1_h1 may be aligned in the x-axis direction. For example, when the hinge structure 202 is in an unfolded or folded state, a center of the first arm shaft hole 5222a1_h1 and a center of the second arm shaft hole 5222a2_h1 may be located on the same axis.

At least a portion of an upper surface of the second arm header 5222a2_3 in the z-axis direction may be formed to be flat. An inner surface (e.g., a surface that faces the third sub-arm member 5222a1) of the second arm header 5222a2_3, on which the second arm shaft hole 5222a2_h1 is formed, may have a circular (or elliptical or polygonal) band shape. The inner surface of the second arm header 5222a_3 may include a twisting surface having a specific magnitude of slope from one point to another. As an example, an inner surface of the second arm header 5222a2_3 may include a first lower step 5221a2_p1 (or a first lower protrusion, or a first lower boss) that protrudes from the surrounding area, and a second lower step 5221a2_p2 (or a second lower protrusion, or a second lower boss). A side surface of the protruding portion of the first lower step 5221a2_p1 may be disposed to face the y-axis direction, and a side surface of the protruding portion of the second lower step 5221a2_p2 may be disposed to face the -y-axis direction. As the first lower step 5221a2_p1 and the second lower step 5221a2_p2 are disposed to face different directions, with respect to a direction from the -x-axis to the x-axis, a third inclined surface 221b_2s1 that extends counterclockwise (or a left-hand rotation direction) from the first lower step 5221a2_p1 to the second lower step 5221a2_p2, and a fourth inclined surface 5221a2_s2 that extends clockwise (or a right-hand rotation direction) from the first lower step 5221a2_p1 to the second lower step 5221a2_p2 may be formed. The protruding directions of the first lower step 5221a2_p1 and the second lower step 5221a2_p2 may be opposite to those of the first upper step 5222a1_p1 and the second upper step 5222a1_p2. In response to this, a slope direction of the third inclined surface 5222a2_s1 and a slope direction of the fourth inclined surface 5222a2_s2 may be formed to be opposite to each other, slope directions of the first inclined surface 5222a1_s1 and the facing third inclined surface 5222a2_s1 may be formed to be opposite to each other, and slope directions of the second inclined surface 5222a1_s2 and the facing fourth inclined surface 5222a2_s2 may be formed to be opposite to each other. A description of the inclined surface of the fourth sub-arm member 5222a2 may be the same or similar to the description of the shape of the inclined surface described in the above-described drawing, for example, FIG. 5B.

The second arm body 5222a2_2 may include a structure that extends in the -y-axis direction from the second arm connection portion 5222a2_3. This second arm body 5222a2_2 may be disposed parallel to the first arm body 5222a1_2 in the y-axis direction. An upper surface of the second arm body 5222a2_2 in the z-axis direction may be formed to be flat. Furthermore, surfaces of the second arm body 5222a2_2, which faces the -x-axis direction and the x-axis direction, may be formed to be flat. The second arm body 5222a2_2 may have a structure, an area of which increases gradually or in a specific position as it goes from the y-axis direction in the -y-axis direction. The second arm body 5222a2_2 may include a second shaft insertion hole 5222a2_h2 and a second auxiliary shaft insertion hole 5222a2_h3 that are formed such that the second shaft 5231b1 and the second auxiliary shaft 5231d1 may be inserted thereinto from the -x axis in the x-axis direction. When the hinge structure 202 is in an unfolded or folded state, a center of the second shaft insertion hole 5222a2_h2 may be located on the same axis as a center of the first shaft insertion hole 5222a1_h2, and a center of the second auxiliary shaft insertion hole 5222a2_h3 may be located on the same axis as a center of the first auxiliary shaft insertion hole 5222a1_h3. It is illustrated in the drawing that an x-axis thickness of the second arm body 5222a2_2 is greater than an x-axis thickness of the first arm body 5222a1_2, but this may be changed.

In the hinge structure 202 described above, because at least one of the arm members 5221a, 5221b, 5222a, and 5222b includes the sub-arm members as described in FIG. 18, and the sub-arm members include twisting surfaces with different slope directions on the surfaces that contact each other, the third sub-arm member 5222a1 may be pressed to be rotated clockwise (or counterclockwise), and the fourth sub-arm member 5222a2 may be pressed to be rotate counterclockwise (or clockwise) with respect to the sub-arm members illustrated in FIG. 18 when the elastic member presses the arm member. The third sub-arm member 5222a1 and the fourth sub-arm member 5222a2 may be pressed to be rotated in different rotation directions. In response to this, because at least some of the shaft insertion hole, the auxiliary shaft insertion hole, the arm shaft hole, and the shafts inserted into the holes are maintained at least in contact with each other, no collision may occur between the shafts and the inner walls of the holes when the hinge structure 202 is rotated (or when the foldable electronic device is folded or unfolded) whereby the joints may be improved and the detent operation during the folding or unfolding may be performed more smoothly with no interruption.

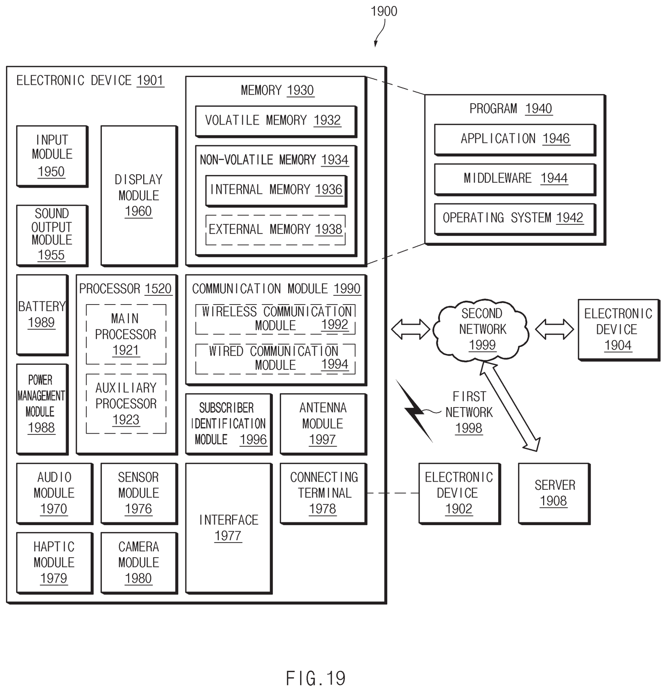

FIG. 19 is a block diagram illustrating an example electronic device 1901 in a network environment 1900 according to various embodiments. Referring to FIG. 19, the electronic device 1901 in the network environment 1900 may communicate with an electronic device 1902 via a first network 1998 (e.g., a short-range wireless communication network), or at least one of an electronic device 1904 or a server 1908 via a second network 1999 (e.g., a long-range wireless communication network). According to an embodiment, the electronic device 1901 may communicate with the electronic device 1904 via the server 1908. According to an embodiment, the electronic device 1901 may include a processor 1920, memory 1930, an input module 1950, a sound output module 1955, a display module 1960, an audio module 1970, a sensor module 1976, an interface 1977, a connecting terminal 1978, a haptic module 1979, a camera module 1980, a power management module 1988, a battery 1989, a communication module 1990, a subscriber identification module (SIM) 1996, or an antenna module 1997. In various embodiments, at least one of the components (e.g., the connecting terminal 1978) may be omitted from the electronic device 1901, or one or more other components may be added in the electronic device 1901. In various embodiments, some of the components (e.g., the sensor module 1976, the camera module 1980, or the antenna module 1997) may be implemented as a single component (e.g., the display module 1960).

The processor 1920 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. The processor 1920 may execute, for example, software (e.g., a program 1940) to control at least one other component (e.g., a hardware or software component) of the electronic device 1901 coupled with the processor 1920, and may perform various data processing or computation. According to an embodiment, as at least part of the data processing or computation, the processor 1920 may store a command or data received from another component (e.g., the sensor module 1976 or the communication module 1990) in volatile memory 1932, process the command or the data stored in the volatile memory 1932, and store resulting data in non-volatile memory 1934. According to an embodiment, the processor 1920 may include a main processor 1921 (e.g., a central processing unit (CPU) or an application processor (AP)), or an auxiliary processor 1923 (e.g., a graphics processing unit (GPU), a neural processing unit (NPU), an image signal processor (ISP), a sensor hub processor, or a communication processor (CP)) that is operable independently from, or in conjunction with, the main processor 1921. For example, when the electronic device 1901 includes the main processor 1921 and the auxiliary processor 1923, the auxiliary processor 1923 may be adapted to consume less power than the main processor 1921, or to be specific to a specified function. The auxiliary processor 1923 may be implemented as separate from, or as part of the main processor 1921.

The auxiliary processor 1923 may control at least some of functions or states related to at least one component (e.g., the display module 1960, the sensor module 1976, or the communication module 1990) among the components of the electronic device 1901, instead of the main processor 1921 while the main processor 1921 is in an inactive (e.g., sleep) state, or together with the main processor 1921 while the main processor 1921 is in an active state (e.g., executing an application). According to an embodiment, the auxiliary processor 1923 (e.g., an image signal processor or a communication processor) may be implemented as part of another component (e.g., the camera module 1980 or the communication module 1990) functionally related to the auxiliary processor 1923. According to an embodiment, the auxiliary processor 1923 (e.g., the neural processing unit) may include a hardware structure specified for artificial intelligence model processing. An artificial intelligence model may be generated by machine learning. Such learning may be performed, e.g., by the electronic device 1901 where the artificial intelligence is performed or via a separate server (e.g., the server 1908). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1930 may store various data used by at least one component (e.g., the processor 1920 or the sensor module 1976) of the electronic device 1901. The various data may include, for example, software (e.g., the program 1940) and input data or output data for a command related thereto. The memory 1930 may include the volatile memory 1932 or the non-volatile memory 1934.

The program 1940 may be stored in the memory 1930 as software, and may include, for example, an operating system (OS) 1942, middleware 1944, or an application 1946.

The input module 1950 may receive a command or data to be used by another component (e.g., the processor 1920) of the electronic device 1901, from the outside (e.g., a user) of the electronic device 1901. The input module 1950 may include, for example, a microphone, a mouse, a keyboard, a key (e.g., a button), or a digital pen (e.g., a stylus pen).

The sound output module 1955 may output sound signals to the outside of the electronic device 1901. The sound output module 1955 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1960 may visually provide information to the outside (e.g., a user) of the electronic device 1901. The display module 1960 may include, for example, a display, a hologram device, or a projector and control circuitry to control a corresponding one of the display, hologram device, and projector. According to an embodiment, the display module 1960 may include a touch sensor adapted to detect a touch, or a pressure sensor adapted to measure the intensity of force incurred by the touch.

The audio module 1970 may convert a sound into an electrical signal and vice versa. According to an embodiment, the audio module 1970 may obtain the sound via the input module 1950, or output the sound via the sound output module 1955 or a headphone of an external electronic device (e.g., an electronic device 1902) directly (e.g., wiredly) or wirelessly coupled with the electronic device 1901.

The sensor module 1976 may detect an operational state (e.g., power or temperature) of the electronic device 1901 or an environmental state (e.g., a state of a user) external to the electronic device 1901, and then generate an electrical signal or data value corresponding to the detected state. According to an embodiment, the sensor module 1976 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1977 may support one or more specified protocols to be used for the electronic device 1901 to be coupled with the external electronic device (e.g., the electronic device 1902) directly (e.g., wiredly) or wirelessly. According to an embodiment, the interface 1977 may include, for example, a high definition multimedia interface (HDMI), a universal serial bus (USB) interface, a secure digital (SD) card interface, or an audio interface.

A connecting terminal 1978 may include a connector via which the electronic device 1901 may be physically connected with the external electronic device (e.g., the electronic device 1902). According to an embodiment, the connecting terminal 1978 may include, for example, a HDMI connector, a USB connector, a SD card connector, or an audio connector (e.g., a headphone connector).

The haptic module 1979 may convert an electrical signal into a mechanical stimulus (e.g., a vibration or a movement) or electrical stimulus which may be recognized by a user via his tactile sensation or kinesthetic sensation. According to an embodiment, the haptic module 1979 may include, for example, a motor, a piezoelectric element, or an electric stimulator.

The camera module 1980 may capture a still image or moving images. According to an embodiment, the camera module 1980 may include one or more lenses, image sensors, image signal processors, or flashes.

The power management module 1988 may manage power supplied to the electronic device 1901. According to an embodiment, the power management module 1988 may be implemented as at least part of, for example, a power management integrated circuit (PMIC).

The battery 1989 may supply power to at least one component of the electronic device 1901. According to an embodiment, the battery 1989 may include, for example, a primary cell which is not rechargeable, a secondary cell which is rechargeable, or a fuel cell.

The communication module 1990 may support establishing a direct (e.g., wired) communication channel or a wireless communication channel between the electronic device 1901 and the external electronic device (e.g., the electronic device 1902, the electronic device 1904, or the server 1908) and performing communication via the established communication channel. The communication module 1990 may include one or more communication processors that are operable independently from the processor 1920 (e.g., the application processor (AP)) and supports a direct (e.g., wired) communication or a wireless communication. According to an embodiment, the communication module 1990 may include a wireless communication module 1992 (e.g., a cellular communication module, a short-range wireless communication module, or a global navigation satellite system (GNSS) communication module) or a wired communication module 1994 (e.g., a local area network (LAN) communication module or a power line communication (PLC) module). A corresponding one of these communication modules may communicate with the external electronic device via the first network 1998 (e.g., a short-range communication network, such as Bluetooth^{™}, wireless-fidelity (Wi-Fi) direct, or infrared data association (IrDA)) or the second network 1999 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1992 may identify and authenticate the electronic device 1901 in a communication network, such as the first network 1998 or the second network 1999, using subscriber information (e.g., international mobile subscriber identity (IMSI)) stored in the subscriber identification module 1996.

The wireless communication module 1992 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1992 may support a high-frequency band (e.g., the mmWave band) to achieve, e.g., a high data transmission rate. The wireless communication module 1992 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1992 may support various requirements specified in the electronic device 1901, an external electronic device (e.g., the electronic device 1904), or a network system (e.g., the second network 1999). According to an embodiment, the wireless communication module 1992 may support a peak data rate (e.g., 20Gbps or more) for implementing eMBB, loss coverage (e.g., 1964dB or less) for implementing mMTC, or U-plane latency (e.g., 0.5ms or less for each of downlink (DL) and uplink (UL), or a round trip of 19ms or less) for implementing URLLC.

The antenna module 1997 may transmit or receive a signal or power to or from the outside (e.g., the external electronic device) of the electronic device 1901. According to an embodiment, the antenna module 1997 may include an antenna including a radiating element including a conductive material or a conductive pattern formed in or on a substrate (e.g., a printed circuit board (PCB)). According to an embodiment, the antenna module 1997 may include a plurality of antennas (e.g., array antennas). In such a case, at least one antenna appropriate for a communication scheme used in the communication network, such as the first network 1998 or the second network 1999, may be selected, for example, by the communication module 1990 (e.g., the wireless communication module 1992) from the plurality of antennas. The signal or the power may then be transmitted or received between the communication module 1990 and the external electronic device via the selected at least one antenna. According to an embodiment, another component (e.g., a radio frequency integrated circuit (RFIC)) other than the radiating element may be additionally formed as part of the antenna module 1997.

According to various embodiments, the antenna module 1997 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1901 and the external electronic device 1904 via the server 1908 coupled with the second network 1999. Each of the electronic devices 1902 or 1904 may be a device of a same type as, or a different type, from the electronic device 1901. According to an embodiment, all or some of operations to be executed at the electronic device 1901 may be executed at one or more of the external electronic devices 1902, 1904, or 1908. For example, if the electronic device 1901 should perform a function or a service automatically, or in response to a request from a user or another device, the electronic device 1901, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1901. The electronic device 1901 may provide the outcome, with or without further processing of the outcome, as at least part of a reply to the request. To that end, a cloud computing, distributed computing, mobile edge computing (MEC), or client-server computing technology may be used, for example. The electronic device 1901 may provide ultra low-latency services using, e.g., distributed computing or mobile edge computing. In an embodiment, the external electronic device 1904 may include an internet-of-things (IoT) device. The server 1908 may be an intelligent server using machine learning and/or a neural network. According to an embodiment, the external electronic device 1904 or the server 1908 may be included in the second network 1999. The electronic device 1901 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. A portable electronic device, comprising:
a flexible display;
a first housing and a second housing accommodating the flexible display; and
a hinge structure comprising a hinge coupled to the first housing and the second housing, wherein the hinge structure includes:
a first rotation member comprising a bracket coupled to the first housing and a second rotation member comprising a bracket coupled to the second housing;
a first arm coupled to the first housing and a second arm coupled to the second housing; and
a first elastic body configured to press the first arm and a second elastic body configured to press the second arm,
wherein the first arm includes:
a first upper arm disposed between the first rotating member and the first elastic body, and having an inclined surface formed thereon; and
a first lower arm disposed between the first upper arm and the first rotation member to face the first upper arm, and having an inclined surface formed thereon.

2. The portable electronic device of claim 1, further comprising:
a first link disposed in the first housing and coupled to the first rotation member;
a second link disposed in the second housing and coupled to the second rotation member;
a third link disposed in the first housing and coupled to the first arm;
a fourth link disposed in the second housing and coupled to the second arm.

3. The portable electronic device of claim 2, wherein the first upper arm is configured to rotate by a specific angle in a first direction in response to a pressure of the first elastic body,
wherein the first lower arm is configured to rotate by a specific angle in a second direction different from the first direction.

4. The portable electronic device of claim 3, wherein the first upper arm is configured to rotate counterclockwise by the specific angle in response to the pressure of the first elastic body and the first lower arm is configured to rotate clockwise by the specific angle, based on a third direction from the first elastic body toward the first rotation member.

5. The portable electronic device of claim 3, wherein
a lower portion of a first upper arm rail disposed on the first upper arm is maintained in a contact state with a lower portion of the first link rail disposed on the third link, in response to rotation of the first upper arm.

6. The portable electronic device of claim 5, wherein an upper portion of the first upper arm rail is maintained in a non-contact state with an upper portion of the first link rail, in response to rotation of the first upper arm.

7. The portable electronic device of claim 3, wherein an upper portion of a first lower arm rail disposed on the first lower arm is maintained in a contact state with an upper portion of a second link rail disposed on the third link, in response to the rotation of the first lower arm.

8. The portable electronic device of claim 7, wherein a lower portion of the first lower arm rail is maintained in a non-contact state with a lower portion of the second link rail, in response to rotation of the first lower arm.

9. The portable electronic device of claim 3, wherein the second arm includes:
a second upper arm disposed between the second rotating member and the second elastic body, and having an inclined surface formed thereon;
a second lower arm disposed between the second upper arm and the second rotation member and facing the second upper arm, and having an inclined surface formed thereon.

10. The portable electronic device of claim 9, wherein the second upper arm is configured to rotate by a specific angle in the second direction and the second lower arm is configured to rotate by a specific angle in the first direction, in response to a pressure of the second elastic body.

11. The portable electronic device of claim 10, wherein the second upper arm is configured to rotate clockwise by a specific angle and the second lower arm is configured to rotate counterclockwise by a specific angle in response to the pressure of the second elastic body, based on a third direction from the second elastic body to the second rotation member.

12. The portable electronic device of claim 10, wherein a lower portion of a second upper arm rail disposed on the second upper arm is maintained in a contact state with a lower portion of a third link rail disposed on the fourth link in response to the rotation of the second upper arm.

13. The portable electronic device of claim 12, wherein an upper portion of the second upper arm rail is maintained in a non-contact state with an upper portion of the third link rail.

14. The portable electronic device of claim 10, wherein an upper portion of a second lower arm rail disposed on the second lower arm is maintained in a contact state with an upper portion of a fourth link rail disposed on the fourth link and a lower portion of the second lower arm rail is maintained in a non-contact state with a lower portion of the fourth link rail, in response to the rotation of the second lower arm.

15. The portable electronic device of claim 2, wherein the first upper arm includes:
a first upper arm body including a first upper arm rail coupled to a first link rail formed on the third link;
a first upper arm header including a hole formed in a center;
a first upper arm connector configured to connect the first upper arm body and the first upper arm header,
wherein the first upper arm header includes:
a first upper step protruding from an inner surface facing the first lower arm,
a second upper step formed on the inner surface and disposed at a position spaced apart from the first upper step;
a first inclined surface formed in a direction from the first upper step to the second upper step; and
a second inclined surface formed in a direction from the second upper step to the first upper step,
wherein the first lower arm includes:
a first lower arm body including a first lower arm rail coupled to a second link rail formed on the third link;
a first lower arm header with a hole formed in a center;
a first lower arm connector configured to connect the first lower arm body and the first lower arm header,
wherein the first lower arm header includes:
a third upper step protruding from an inner surface facing the first upper arm,
a fourth upper step formed on the inner surface and disposed at a position spaced apart from the third upper step;
a third inclined surface formed in a direction from the third upper step to the fourth upper step;
a fourth inclined surface formed in a direction from the fourth upper step to the third upper step.
